# EUROPEAN PATENT APPLICATION

(11) **EP 2 599 537 A1**
(43) Date of publication of application: **05.06.2013**
(21) Application number: 11812094.8
(22) Date of filing: 29.07.2011
(51) Int. Cl.: B01D 53/46, C01B 33/04, H01L 21/205

(54) **EXHAUST GAS PROCESSING SYSTEM**

(30) Priority: 31.03.2011 JP 2011078522; 30.07.2010 JP 2010171980
(71) Applicant: JX Nippon Oil & Energy Corporation, Chiyoda-ku Tokyo 100-8162 (JP)
(72) Inventor: OHUCHI, Tai, Tokyo 100-8162 (JP); OKABE, Takashi, Tokyo 100-8162 (JP); ASANO, Tsuyoshi, Tokyo 100-8162 (JP)
(74) Representative: Blokland, Arie
(86) International application number: PCT/JP2011/004329
(87) International publication number: WO 2012/014497

(57) **Abstract**

A mixed gas containing monosilane is released from a semiconductor fabrication equipment (1). A pump unit (2) suctions the mixed gas discharged from the semiconductor fabrication equipment (1) and sends it out to a silane gas treatment unit (20) provided at a stage subsequent to the pump unit (2). Argon gas is used as a purge gas of the pump unit (2). The silane gas treatment unit (20) processes the mixed gas, containing at least hydrogen and monosilane, discharged from the semiconductor fabrication equipment (1) via the pump unit (2). And the silane gas treatment unit (20) separates and recover monosilane from the mixed gas so as to be recycled. Argon recovered by a noble gas treatment unit (30) is used as the purge gas of the pump unit (2).

## Description

### [TECHNICAL FIELD]

The present invention relates to an exhaust gas treatment system that separates and recovers monosilane from a mixed gas, containing monosilane, discharged from a semiconductor fabrication equipment so as to recycle monosilane.

### [BACKGROUND ART]

Unused monosilane is contained in exhaust gas discharged from a semiconductor fabrication equipment, in particular a plasma CVD apparatus. Recycling monosilane by separating and recovering it therefrom enhances the utilization efficiency of monosilane, so that the reduction in gas utilities' cost can be expected.

### [Related Art List]

### [Patent documents]

[Patent document 1] Japanese Unexamined Patent Application Publication (Translation of PCT application) No. 2010-504436.
[Patent document 2] Pamphlet of International Patent Application No. WO 2008/154293.
[Patent document 3] Japanese Unexamined Patent Application Publication No. Hei07-267625.

### [Non-patent documents]

[Non-patent document 1] Journal of Applied Physics 105, 074509 (2009).
[Non-patent document 2] Journal of Non-crystalline Solids 354 (2008), pp 2268-2271.

### [SUMMARY OF THE INVENTION]

### [PROBLEM TO BE SOLVED BY THE INVENTION]

In view of the above purpose, a method is reported where monosilane discharged from the semiconductor fabrication equipment is recycled. In this method, fine particles in exhaust gas is trapped by a filter provided at a subsequent stage and a gas containing monosilane that has passed through the filter is circulated in a chamber. Thus, the purity of monosilane is not very high and impurities are considered to be contained in a fabricated semiconductor (see patent document 1 and patent document 2).

Purge nitrogen in a dry pump provided at a stage subsequent to a plasma CVD apparatus is mixed in the exhaust gas discharged from a conventional solar cell manufacturing equipment functioning as the plasma CVD apparatus. In this case, the following had been reported. That is, when monosilane gas containing nitrogen is reused by circulating it in the solar cell manufacturing equipment, nitrogen is mixed into a solar cell manufactured and therefore the performance is degraded (see non-patent document 1 and non-patent document 2).

In view of the above, an attempt was made to separate nitrogen from monosilane and vice versa. This requires large-scale facilities such as rectifiers, which in turn is problematic in terms of offsetting the cost incurred (see patent document 3).

The present invention has been made to solve problems as described above, and a purpose thereof is to provide an exhaust gas treatment system and its technology capable of suppressing the mixture of impurities into a semiconductor fabrication equipment while monosilane contained in exhaust gas discharged from the semiconductor fabrication equipment is efficiently separated and recovered so as to be reused.

### [MEANS TO SOLVE THE PROBLEMS]

In order to resolve the above-described problems, an exhaust gas treatment system according to one embodiment of the present invention is an exhaust gas treatment system for recovering monosilane from a mixed gas containing at least hydrogen and monosilane discharged from a semiconductor fabrication equipment, and the system includes: a pump unit configured to release the mixed gas discharged from the semiconductor fabrication equipment; and a silane gas treatment unit configured to separate and recover monosilane from the mixed gas so as to be recycled in the semiconductor fabrication equipment, wherein argon is used as a purge gas introduced into the pump unit.

### [ADVANTAGES OF THE PRESENT INVENTION]

According to this embodiment, monosilane discharged from a semiconductor fabrication equipment is separated and recovered so as to be recycled in the semiconductor fabrication equipment. Thus the utilization efficiency of monosilane can be improved and the operating cost can be reduced.

Since argon is used as the purge gas of the pump unit, the concentration of impurities in monosilane recovered can be reduced. Further, argon used is separated and recovered and then circulated in the pump unit so as to be reused. Thus the utilization efficiency of purge gas can be enhanced and the operating cost can be reduced.

Furthermore, a system is constructed as a production line of solar cells such that gas discharged only when an i (intrinsic) layer is fabricated is recovered and treated. Thus, the targeted gas can be efficiently separated and recovered.

### [BRIEF DESCRIPTION OF THE DRAWINGS]

FIG. 1 is a system diagram showing an exemplary overview of an exhaust gas treatment system according to a first embodiment.
FIG. 2 schematically shows a specific structure of a silane gas treatment unit.
FIG. 3 schematically shows a specific structure of a noble gas treatment unit.
FIG. 4 is a system diagram showing a detailed structure of an exhaust gas treatment system according to a first embodiment.
FIG. 5 schematically shows a specific structure of a silane gas purification unit.
FIG. 6 schematically shows a specific structured of first and second purification units.
FIG. 7 schematically shows a structure of an exhaust gas treatment system according to an exemplary embodiment.
FIG. 8 schematically shows a specific structure of a silane gas treatment unit when adsorption separation is used as the silane gas treatment unit in an exhaust gas treatment system according to an exemplary embodiment.
FIG. 9 schematically shows a specific structure of a silane gas treatment unit when membrane separation is used as the silane gas treatment unit in an exhaust gas treatment system according to exemplary embodiments.
FIG. 10 schematically shows a specific structure of a silane gas treatment unit when cryogenic separation is used as the silane gas treatment unit in an exhaust gas treatment system according to exemplary embodiments.
FIG. 11 schematically shows a specific structure of a silane purification unit in an exhaust gas treatment system according to exemplary embodiments.
FIG. 12 is a system diagram showing an exemplary overview of an exhaust gas treatment system according to a second embodiment.
FIG. 13 schematically shows a specific structure of a silane gas treatment unit.
FIG. 14 schematically shows a specific structure of a wet scrubber.
FIG. 15 schematically shows a structure of an exhaust gas treatment system according to an embodiment.
FIG. 16 schematically shows a specific structure of a silane gas treatment unit in an exhaust gas treatment system according to an exemplary embodiment.
FIG. 17 schematically shows a specific structure of a silane gas purification unit in an exhaust gas treatment system according to exemplary embodiments.
FIG. 18 is a system diagram showing an exemplary overview of an exhaust gas treatment system according to a third embodiment.
FIG. 19 schematically shows a specific structure of a gas compression unit.
FIG. 20 schematically shows a specific structure of a silane gas treatment unit.
FIG. 21 is a system diagram showing a structure of an exhaust gas treatment system according to an exemplary embodiment.
FIG. 22 is a system diagram showing in more detail a structure of a gas compression unit in an exhaust gas treatment system according to an exemplary embodiment.
FIG. 23 is a system diagram showing in more detail a structure of a silane gas treatment unit in an exhaust gas treatment system according to an exemplary embodiment.
FIG. 24 is a system diagram showing in more detail a structure of a silane gas purification unit in an exhaust gas treatment system according to an exemplary embodiment.
FIG. 25 is a system diagram showing an exemplary overview of an exhaust gas treatment system according to a fourth embodiment.
FIG. 26 schematically shows a specific structure of a noble gas/silane separation unit.
FIG. 27 is a system diagram showing in more detail a structure of an exhaust gas treatment system according to an exemplary embodiment.
FIG. 28 schematically shows a specific structure of an exhaust gas treatment system according to an exemplary embodiment.
FIG. 29 schematically shows a specific structure of a gas compression unit in an exhaust gas treatment system according to an exemplary embodiment.
FIG. 30 schematically shows a specific structure of a silane gas treatment unit when adsorption separation is used as the silane gas treatment unit in an exhaust gas treatment system according to an exemplary embodiment.
FIG. 31 schematically shows a specific structure of a gas purification unit in an exhaust gas treatment system according to an exemplary embodiment.
FIG. 32 schematically shows a specific structure of a noble gas/silane separation unit in an exhaust gas treatment system according to an exemplary embodiment.

### [BEST MODE FOR CARRYING OUT THE INVENTION]

Hereinbelow, the embodiments of the present invention will be described with reference to the accompanying drawings. Note that the identical components are given the identical reference numerals in all accompanying Figures and the repeated description thereof will be omitted as appropriate.

### (First Embodiment)

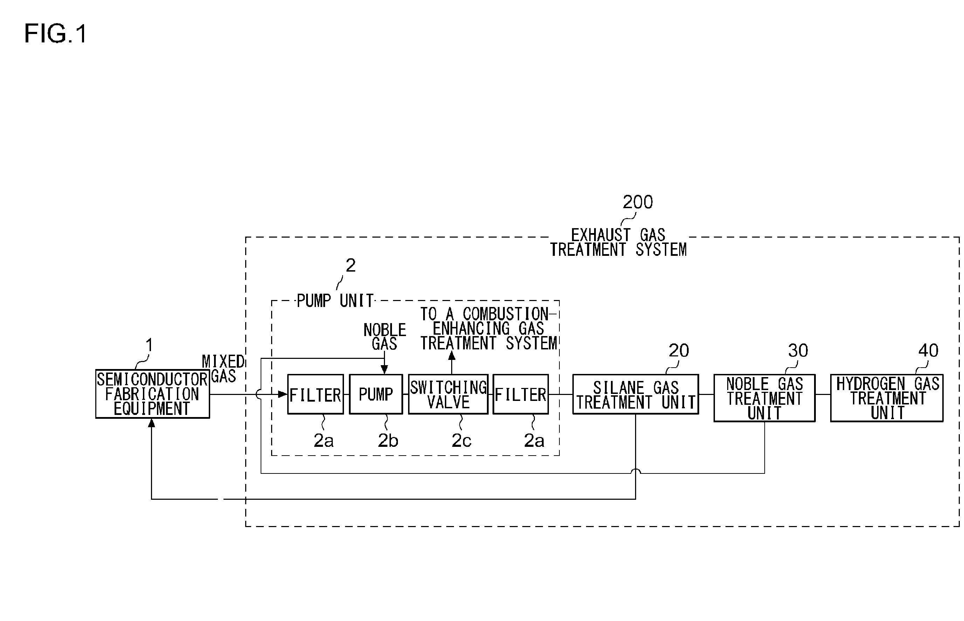

FIG. 1 is a system diagram showing an exemplary overview of an exhaust gas treatment system according to a first embodiment of the present invention. As shown in FIG. 1, an exhaust gas treatment system 200 according to the first embodiment treats a mixed gas, which contains at least monosilane, hydrogen and argon, discharged from a semiconductor fabrication equipment 1 via a pump unit 2. And the exhaust gas treatment system 200 includes a silane gas treatment unit 20, which separates and recovers monosilane so as to be reused, and a noble gas treatment unit 30, which separates and collects (recovers) argon from the mixed gas discharged from the silane gas treatment unit 20 and which reuses the thus recovered argon.

The semiconductor fabrication equipment 1 is not limited to any particular equipment. For example, a plasma CVD apparatus for forming a film by thin-film silicon used for a solar cell may be used as the semiconductor fabrication equipment 1.

The composition of the mixed gas discharged from the semiconductor fabrication equipment 1 is not limited to any particular ones but may contain monosilane, hydrogen, and a small amount of impurities, for instance. The small amount of impurities may be a high-order silane having plural silicons, such as disilane or trisilane, CH₄, PH₃, and B₂H₆ (whose content rate in the mixed gas is in a range of 0.0001 to 1 % each) and the like. It is desirable that only a semiconductor fabrication equipment 1 into which various dopant gases such as CH₄, PH₃, and B₂H₆ are not introduced be connected to the exhaust gas treatment system 200 of the present embodiment.

The pump unit 2 suctions the mixed gas discharged from the semiconductor fabrication equipment 1, and sends out the mixed gas to the silane gas treatment unit 20 provided at a stage subsequent to the pump unit 2. The type of a pump used is not limited to any particular one but a dry pump generally and oftentimes works well for the semiconductor fabrication equipment 1. The dry pump needs to introduce a purge gas for the purposes of, for instance, maintaining airtightness, preventing unnecessary deposited material, preventing the corrosion inside a pump, and improving exhaust capability. The purge gas used in the present embodiment is not limited to any particular ones as long as the following three conditions are met. The three conditions are: that the purge gas does not react with monosilane, that it does not operate as a dopant even if it is mixed with a process gas, and that it has a gas density enough to normally operate the pump. And the purge gas having such properties may be a noble gas other than helium (e.g., neon, argon, krypton, and xenon). In light of cost performance, argon is most preferable among those. Though the amount of gas introduced is not limited to any particular amount, it may generally be 10 to 50 NL/minute per pump.

Also, a filter 2a may be provided at a stage prior to and/or subsequent to a pump 2b. If, in particular, a relatively large amount of fine particles such as a high-order silane are present, it is preferable that the filter 2a be provided. The filter 2a is a fine particle capturing filter that selectively removes the fine particles, such as a high-order silane, contained in the mixed gas. Though not limited to any particular one, the filter to be used may be a filter of vortex type or the like.

Further, the semiconductor fabrication equipment 1 sometimes undergoes chemical cleaning in order to remove the deposited material, inside a chamber, resulting from the film formation. In general, the chemical cleaning is done such that, in order to remove a silicon thin film deposited in the chamber, a plasma treatment is conducted while a gas such as NF₃ and F₂ is being introduced. Since, however, such a gas has a combustion enhancing property, it is necessary to prevent the gas from contacting an inflammable gas such as hydrogen and monosilane. Thus, it is preferable that a switching valve 2c be provided at a stage subsequent to the pump 2b. With this configuration, an operation mode is switched to an combustion-enhancing gas treatment system when exhaust gas comes out as a result of the chemical cleaning, thereby preventing such exhaust gas from being mixed into a treatment line of a silane-based gas. It is to be noted here that the switching valve 2c may be provided with a built-in mechanism for realizing the aforementioned operation. Also, when the combustion-enhancing gas is to be released to atmosphere, it is desirable that the combustion-enhancing gas be diluted with an inert gas such as nitrogen.

The silane gas treatment unit 20 allows the mixed gas to pass therethrough and separates the mixed gas into monosilane, contained in the mixed gas, and primary-constituent mixed gas, excluding monosilane, such as hydrogen and argon (hereinafter also referred to as "hydrogen/noble gas-rich gas" containing a high proportion of hydrogen and purge gas). A method for separating the mixed gas is not limited to any particular methods as long as the mixed gas can be separated into monosilane and the primary-constituent mixed gas excluding monosilane. For example, such a method may be an adsorption separation method using adsorbents, a membrane separation method using a membrane separation module, or a cryogenic separation method where the mixed gas is separated through distillation or partial condensation utilizing the difference in temperature when the mixed gas is cooled to a low temperature so as to be liquefied and condensed.

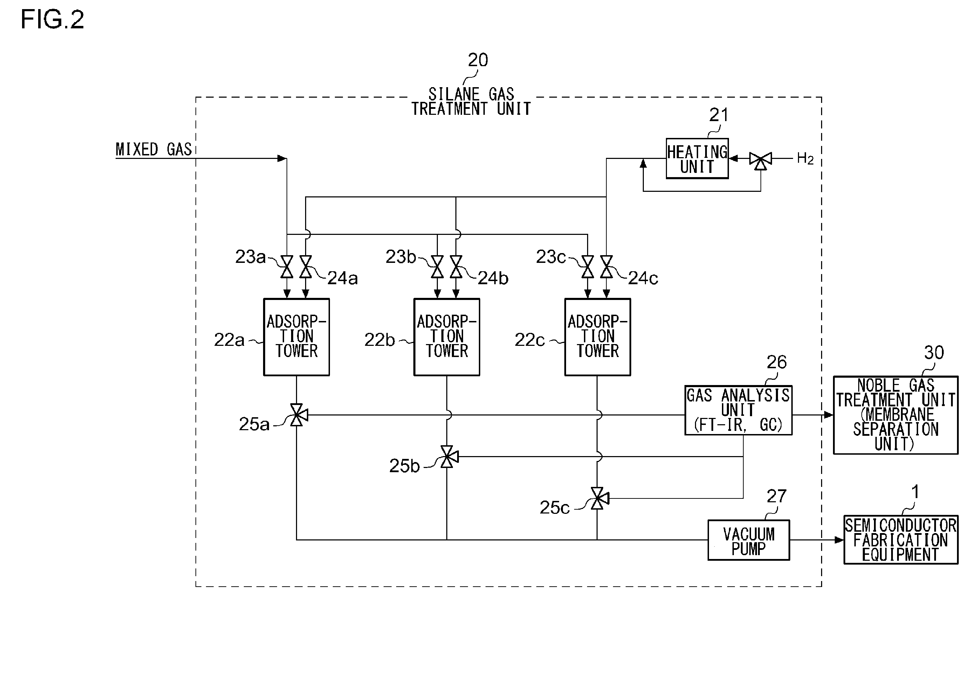

FIG. 2 schematically shows a specific structure of the silane gas treatment unit 20 when the silane gas treatment unit 20 carries out a adsorption separation process. As shown in FIG. 2, the silane gas treatment unit 20 includes a heating unit 21, adsorption towers 22a to 22c, adsorption-desorption switching valves 23a to 23c, carrier-gas-introduction switching valves 24a to 24c, adsorption-desorption switching three-way valves 25a to 25c, a gas analysis unit 26, and a vacuum pump 27.

The carrier gas supplied to the heating unit 21 may be an inert gas such as hydrogen, argon, or helium, for instance. The carrier gas is heated to 40 to 200°C and then fed to each of the adsorption towers 22a to 22c.

The adsorption towers 22a to 22c according to the present embodiment are filled with adsorbents capable of adsorbing monosilane more efficiently than hydrogen, nitrogen, and argon. The absorbent like this is not limited to any particular one insofar as it conforms to the aforementioned purpose and may be activated carbon, silica gel, alumina gel, and zeolite such as 3A, 4A, 5A and 13X, for instance. The adsorption towers 22a to 22c may each have a structure, such as an electric furnace, which allows the temperature to be kept constant on the outside thereof. The temperature can be adjusted based on a detection result of a temperature detector (not shown) that is inserted inside the adsorption towers 22a to 22c. Also, a plurality of temperature detectors inserted thereinto allow an adsorption band to be kept track of so as to observe and graspt adsorption behavior. Differential pressures of the adsorption towers 22a to 22c are monitored by measuring the internal pressures of the adsorption towers 22a to 22c by a plurality of pressure sensors (not shown), so that the respective powdering conditions of the adsorbents can be grasped as well.

A detailed description is now given of a method for separating monosilane using adsorbents. A carrier gas such as hydrogen that is heated to about 40 to 200°C by the heating unit 21 is introduced to each of the adsorption towers 22a to 22c filled with adsorbents. The carrier gas is discharged by the vacuum pump 27 until the pressure reaches -0.1 MPaG to -0.09 MPaG. The pressure is maintained in this condition for about 1 to 100 hours. Then the respective temperatures of the adsorption towers 22a to 22c are cooled down to predetermined temperatures (an adsorbent pretreatment). Then, upon the introduction of a mixed gas whose temperature is 0 to 100°C and whose pressure is -0.01 MPaG to 1.0 MPaG into the adsorption towers 22a to 22c, monosilane contained in the mixed gas is adsorbed to the absorbents filled inside the adsorption towers 22a to 22c. As a result, a gas whose monosilane concentration is 1.0% or below is discharged from the adsorption towers 22a to 22c in an early stage of the introduction of the mixed gas. In the light of energy efficiency, it is preferred that the mixed gas whose temperature is 30 to 40°C and whose pressure is -0.01 MPaG to 2.0 MPaG be introduced into the adsorption towers 22a to 22c.

In so doing, the adsorption-desorption switching three-way valves 25a to 25c are controlled such that exhaust passages of the adsorption towers 22a to 22c communicate with the noble gas treatment unit 30. The gas analysis unit 26 conducts composition analysis of the mixed gas discharged from the absorbents by the use of a Fourier transform infrared spectrometer (FT-IR) and an on-line gas chromatography (GC). And when monosilane of a predetermined concentration is detected thereby, the adsorption-desorption switching three-way valves 25a to 25c shut off the passages between the adsorption towers 22a to 22c and the noble gas treatment unit 30.

At this time, monosilane is being adsorbed onto the absorbents. Thus, the silane gas treatment unit 20 according to the present embodiment desorbs the adsorbed monosilane by a temperature swing adsorption (TSA) process, for instance. More specifically, heating the adsorption towers 22a to 22c to about 40 to 120°C by the electric furnace causes monosilane to be desorbed from the adsorbents. As a result, the gas discharged from the adsorption towers 22a to 22c substantially contains monosilane in a high concentration. Thus, the adsorption-desorption switching three-way valves 25a to 25c are controlled such that the exhaust passages of the adsorption towers 22a to 22c communicate with the semiconductor fabrication equipment 1. Also, monosilane adsorbed by a pressure swing adsorption (PSA) can be desorbed as well. More specifically, depressurizing the adsorption towers 22a to 22c down to -0.1 MPaG to - 0.05 MPaG by the vacuum pump 27 causes monosilane to be desorbed from the adsorbents. As a result, the gas discharged from the adsorption towers 22a to 22c substantially contains monosilane in a high concentration. Thus, the adsorption-desorption switching three-way valves 25a to 25c are controlled such that the exhaust passages of the adsorption towers 22a to 22c communicate with the semiconductor fabrication equipment 1.

As described above, for the TSA process the silane gas treatment unit 20 controls the timings with which the mixed gas is introduced and the adsorption towers are heated, whereas for the PSA process the silane gas treatment unit 20 controls the timings with which the mixed gas is introduced and the adsorption towers are depressurized. Thereby, the monosilane gas alone can be separated from the mixed gas and then the thus separated monosilane gas can be sent to the semiconductor fabrication equipment 1 at a high concentration so as to be circulated thereinto. Also, the adsorption towers into which the mixed gas or carrier gas is introduced are switched sequentially by using the adsorption-desorption switching valves 23a to 23c and 24a to 24c. This enables the adsorption and desorption of monsilane in the mixed gas to be continuously carried out without any interruption. In other words, when the adsorption switching valve 23a is opened while the other valves are closed and when the adsorption-desorption switching three-way valve 25a is switched to a noble gas treatment unit 30 side, the mixed gas flows into the adsorption tower 22a only and monosilane in the mixed gas is adsorbed. Thus a gas with a reduced monosilane concentration can be obtained at the noble gas treatment unit 30. The adsorption is carried out for a predetermined length of time. Then the adsorption switching valve 23b is opened while the other valves are closed, and the adsorption-desorption switching three-way valve 25b is switched to the noble gas treatment unit 30 side. This delivers the mixed gas to the adsorption tower 22b where monosilane in the mixed gas is adsorbed, so that a gas with a reduced monosilane concentration can be continuously obtained at the noble gas treatment unit 30 side. In parallel with the aforementioned processing, the adsorption-desorption switching three-way valve 25a is switched to a semiconductor fabrication equipment 1 side and then monosilane adsorbed onto the adsorption tower 22a is desorbed through the above-described PSA or TSA process. This allows a gas containing monosilane in a high concentration to be circulated on the semiconductor fabrication equipment 1 side. Repeating these operations alternately for each adsorption tower allows a predetermined gas to be uninterruptedly supplied to the noble gas treatment unit 30 side and the semiconductor fabrication equipment 1 side.

The noble gas treatment unit 30 is not limited to any particular one as long as it can have the mixed gas, composed mainly of hydrogen and argon separated from monosilane by the silane gas treatment unit 20, pass therethrough and then can separate hydrogen from argon and vice versa. For example, the noble gas treatment unit 30 as used herein may be a adsorption-separation means using adsorbents, a membrane separation means using a membrane separation module, or a cryogenic separation means where the mixed gas is separated through distillation or partial condensation utilizing the difference in temperature when the mixed gas is cooled to a low temperature so as to be liquefied and condensed.

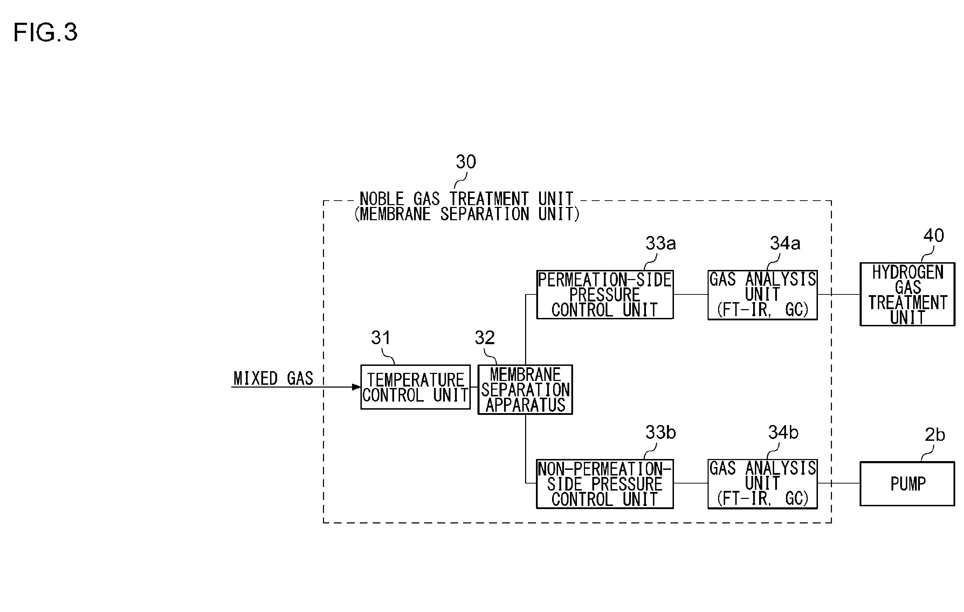

FIG. 3 schematically shows a specific structure employed when the membrane separation is used as the noble gas treatment unit 30. As shown in FIG. 3, the noble gas treatment unit 30 includes a membrane separation apparatus 32, a permeation-side pressure control unit 33a and/or non-permeation-side pressure control unit 33b. The membrane separation apparatus 32 is not limited to any particular one as long as it is a membrane through which hydrogen is selectively permeated but it may be one of various semipermeable membranes, for instance. The semipermeable membrane includes, for example, a dense layer through which hydrogen is selectively permeated and a porous base material that supports a dense layer. As the shape of the semipermeable membrane, a flat membrane, a spiral membrane, and a hollow fiber membrane may be exemplified. Among these, the hollow fiber membrane is more preferable.

The material used for the dense layer may be polyimide, polysiloxane, polysilazane, acrylonitrile, polyester, cellulose polymer, polysulfone, polyalkylene glycol, polyethylene, polybutadiene, polystyrene, polyvinylhalide, polyvinylidene halide, polycarbonate, and block copolymers having repeating units of any of the preceding components, for instance.

The material used for the base material may be an inorganic material such as glass, ceramic, and sintered metal and a porous organic material, for instance. The porous organic material as used herein may be polyether, polyacrylonitrile, polyether, poly (arylene oxide), polyether ketone, polysulfide, polyethylene, polypropylene, polybutene, polyvinyl, and the like.

The flow rate, the pressure, and the temperature of the mixed gas supplied to the membrane separation apparatus 32 are not particularly limited. Also, the concentration of argon gas in the mixed gas, the non-permeation-side pressure and the permeation-side pressure of the membrane separation apparatus 32 are not particularly limited. For example, the flow rate may be 5 NL/min to 500 NL/min relative to the capacity of 1 L of the membrane separation apparatus 32, and may preferably be 10 NL/min to 100 NL/min. The pressure may preferably be -90 kPaG to 1.0 MPaG. The temperature may preferably be about -20°C to 100°C. The concentration of argon gas in the mixed gas may preferably be 50 vol% or below. The non-permeation-side pressure of the membrane separation apparatus 32 may preferably be -90 kPaG to 1.0 MPaG. The permeation-side pressure may preferably be -100 kPaG to 0.9 MPaG.

Here, the capacity of the membrane separation apparatus 32 indicates the volume of a portion of the membrane separation apparatus 32 where the separation membrane in the separation apparatus 32 is filled in a sufficiently dense manner.

When the membrane separation unit is operated at a temperature, other than a room temperature, which serves as the temperature of the mixed gas supplied to the membrane separation apparatus 32, a temperature control unit 31 as shown in FIG. 3 needs to be installed.

The temperature control unit 31 is not particularly limited as long as it has a function of cooling or heating the mixed gas and it may be an electric heater, various heat exchangers, or the like, for instance. The mixed gas that has been cooled or heated by the temperature control unit 31 is supplied to the membrane separation apparatus 32.

Hydrogen gas separated by the membrane separation apparatus 32 is sent to a hydrogen gas treatment unit 40, whereas high-concentration argon is sent to the pump 2b. In the hydrogen gas treatment unit 40, the hydrogen recovered may simply be used for a combustion treatment or as fuel. Or the hydrogen gas treatment unit 40 may be configured such that the hydrogen recovered is diluted with nitrogen, air, or the like to an explosion limit or below and then the hydrogen diluted therewith is released to the outside. When the hydrogen recovered is to be diluted therewith, it is preferable for safety that the concentration of hydrogen be diluted to an explosion lower limit or below (e.g., 4 vol% or below). As a method for diluting hydrogen therewith, the hydrogen recovered is preferably diluted with nitrogen by a nitrogen manufacturing apparatus using a membrane separation method or PSA method. This method of diluting the hydrogen with nitrogen is economically inexpensive. The gas diluted therewith may be discharged to the outside by a blower. Also, a hydrogen gas purification unit may be provided where hydrogen can be purified and reused. The hydrogen purified may be used as raw materials for a fuel cell. How hydrogen is to be processed can be determined from a result obtained when the purity of recovered hydrogen is measured by a gas analysis unit 34a.

The high-concentration argon separated by the membrane separation apparatus 32 can be circulated by the pump 2b so as to be reused. In so doing, whether or not the high-concentration argon is to be reused may be determined based on a result obtained when the purity of recovered argon is measured by a gas analysis unit 34b provided at a non-permeation side. Depending on the purity of high-concentration argon gas circulated by the pump 2b, a mechanism by which to circulate only the purge gas in the pump may be provided. More specifically, if high-concentration argon gas whose content of hydrogen is 4.0 vol% or above is to be circulated, it will be desirable that this high-concentration argon gas be circulated as the purge gas only in the pump 2b. In this case, the sealing argon gas fed to the pump 2b is preferably fresh argon from a compressed gas cylinder. If the high-concentration argon gas is to be circulated as the purge gas only in the pump 2b, there may be provided a mechanism wherein the argon gas can be recovered further efficiently by selecting an operating condition of the membrane separation apparatus 32. Also, there may be provided a mechanism for controlling the amount of noble gas supplied from the compressed gas cylinder relative to the amount of circulated argon so that the purge gas (pump feeding gas) supplied to the pump 2b can be supplied steadily without fluctuations in the amount supplied thereto. Also, as will be discussed later, an accumulator 9a may be provided at a midway point of a circulation line led to a pump, so that the supply pressure to the pump can be kept constant.

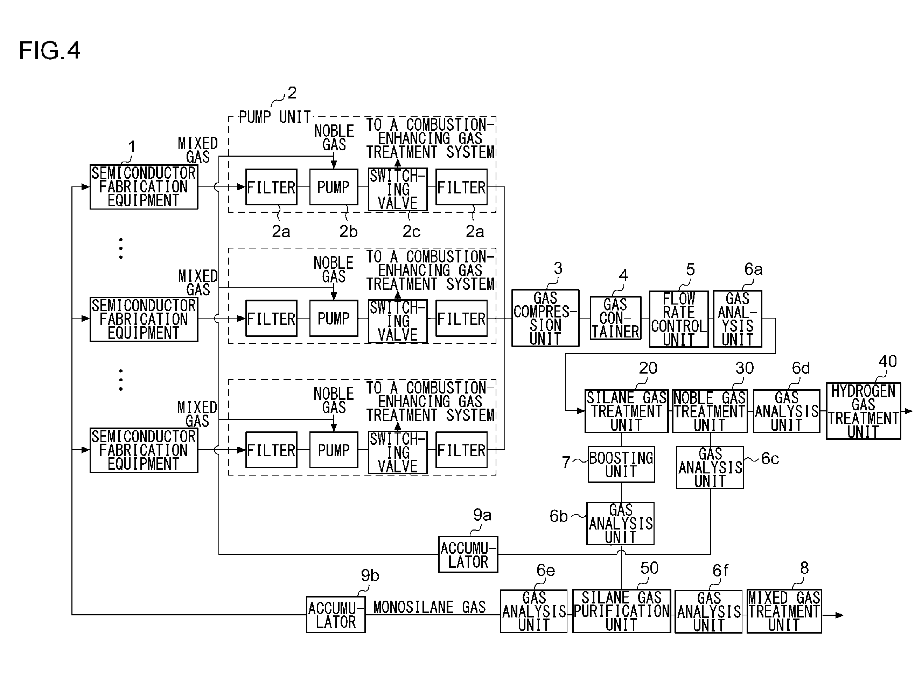

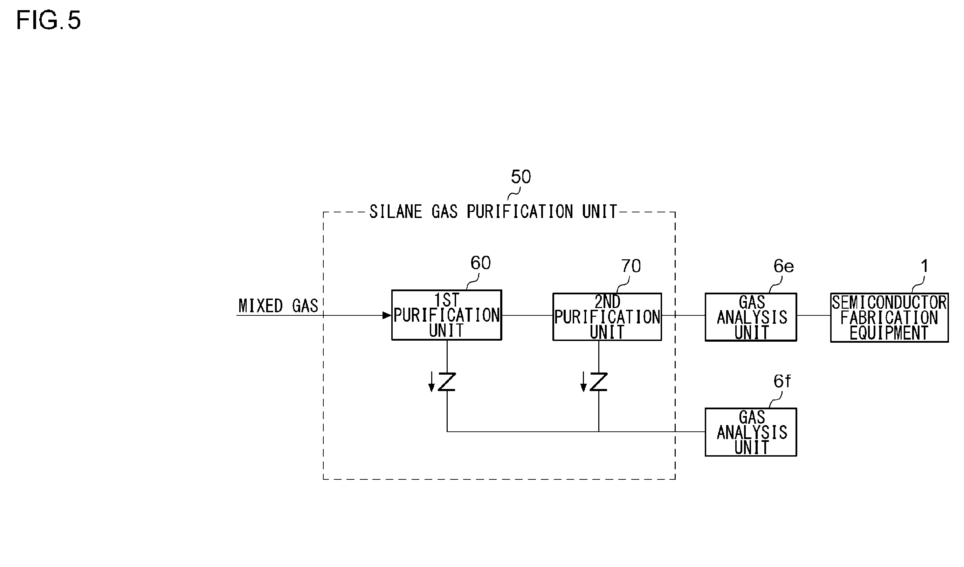

In the exhaust gas treatment system according to the present embodiment, other various supplemental facilities as shown in FIG. 4 and FIG. 5 may be additionally provided.

The exhaust gas treatment system as illustrated in FIG. 4 is a system capable of processing the exhaust gas from a plurality of semiconductor fabrication equipment.

A compression unit 3 is not particular limited and may be a diaphragm compressor, a centrifugal compressor, an axial flow compressor, a reciprocating compressor, a twin-screw compressor, a single-screw compressor, a scroll compressor, a rotary compressor or the like. Among these compressors, a diaphragm compressor is highly preferred.

The operating condition of the gas compression unit 3 is not particularly limited and the compression unit 3 is preferably operated such that the temperature of the mixed gas after compression is 200°C, which is a decomposition temperature of monosilane, or below. That is, when, for example, the mixed gas discharged from the pump unit 2 is compressed from an ordinary pressure, the compressor is preferably operated at a compression ratio of 4.4 or below. If there are thermally unstable impurities, such as B₂H₆, in the mixed gas, the temperature of the mixed gas after compression will be preferably 100°C or below for the purpose of decomposing such impurities. That is, when, for example, the mixed gas discharged from the pump unit 2 is compressed from an ordinary pressure, the compressor is preferably operated at a compression ratio of 2.0 or above.

The structure of a compressor used for the gas compression unit 3 is not particularly limited. In order to stably operate the compressor even when the flow rate of the mixed gas fed to the compressor varies, the gas compression unit 3 is preferably configured such that both a compressor and an inverter are provided or the gas compression unit 3 is preferably configured by the use of a spill-back method where the mixed gas once compressed by the compressor is returned to a suction side of compressor.

A gas container 4 collects the mixed gas discharged from a plurality of semiconductor fabrication equipment 1 through the pump units 2 in a tank or the like having a sufficient capacity. Thereby, the gas container 4 can average variations in the flow rate and the pressure of the mixed gas discharged from the respective semiconductor fabrication equipment 1 and can constantly deliver the mixed gas having a constant flow rate and a constant pressure to the silane gas treatment unit 20 provided at a stage subsequent to the gas container 4. Also, a function of removing fine particles contained in the mixed gas may be added by devising the structure of the exhaust gas treatment system.

Though not particularly limited, the size of the tank used for the gas container 4 may preferably be set to at least a value corresponding to the sum of maximal flow rates of gases supplied to the respective semiconductor fabrication equipment 1.

Though not particularly limited, the pressure inside the tank used for the gas container 4 may be accumulated at a maximum of 10 MPaG. It may preferably be accumulated up to 5.0 MPaG or more preferably be accumulated up to 1 MPaG.

At the start-up of the system, it is preferable that while an outlet valve of the gas container 4 is being closed, the purge gas in a pump or the exhaust gas be supplied to the gas container 4 from the gas compression unit 3 so as to be accumulated in the gas container 4. This can maintain a pressure enough to mitigate adverse changes in the supply flow rate of gas supplied to the respective separation apparatuses provided at stages subsequent to the gas container 4, in the event that the exhaust gas flow rate of the semiconductor fabrication equipment varies greatly. At the same time, the amount of gas that can be held in the gas container 4 can be increased and therefore the volume of the gas container can be reduced. Further, accumulation of sufficient pressure allows the separation efficiency at each of the separation apparatuses, which is operationally advantageous.

A flow rate control unit 5 controls the flow rate and the pressure of the mixed gas gathered in the gas container 4 so that the flow rate and the pressure thereof are constant. Though not particularly limited, a method for controlling the flow rate and the pressure thereof may preferably be one that is not affected by a change in the pressure of the mixed gas supplied to the flow rate control unit 5. Such a method may be one using a mass flow controller, for instance. Also, as for the pressure, a necessary pressure can be ensured by selecting an operating condition of the gas compression unit 3.

A boosting unit 7 is used to introduce a gas composed mainly of monosilane separated by the silane gas treatment unit 20 into a silane gas purification unit 50 described later and is used to boost the pressure up to a certain pressure level in order to circulate monosilane in the semiconductor fabrication equipment 1. The boosting unit 7 as used herein is not particularly limited insofar as it attains the aforementioned purpose and may preferably be one having the same features and requisites as that of the above-described gas compression unit 3.

FIG. 5 schematically shows a specific structure of the silane gas purification unit 50. The silane gas purification unit 50 removes impurities, such as phosphine, diborane and disilane, contained in monosilane separated by the silane gas treatment unit 20 and thereby recovers monosilane of higher purity.

The silane gas purification unit 50 is configured such that it has a first purification unit 60 therewithin. A second purification unit 70 may be further provided at a stage subsequent to the first purification unit 60.

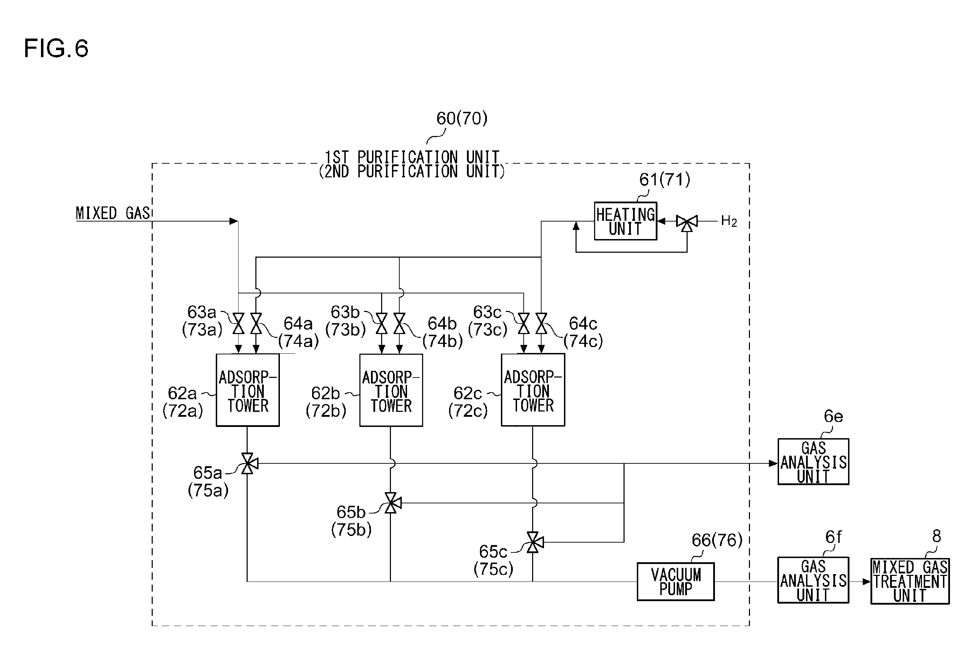

FIG. 6 schematically shows a specific structured of the first and second purification units. The first purification unit 60 and the second purification unit 70 each includes a heating unit 61 (71), adsorption towers 62a to 62c (72a to 72c), adsorption switching valves 63a to 63c (73a to 73c), carrier gas introduction switching valves 64a to 64c (74a to 74c), adsorption-desorption switching three-way valves 65a to 65c (75a to 75c), and a vacuum pump 66 (76).

The absorbent used in the adsorption towers 62a to 62c (72a to 72c) is not particularly limited as long as it can selectively adsorb the impurities, such as phosphine, diborane and disilane, contained in the mixed gas composed mainly of monosilane. Such adsorbent may be activated carbon, silica gel, alumina gel, and zeolite such as 3A, 4A, 5A and 13X, for instance. Type-A zeolite, which is ion-exchanged with magnesium and manganese, and zeolite with a mordenite-type framework are more preferable.

The adsorption towers 62a to 62c (72a to 72c) may each have a structure, such as an electric furnace, which allows the temperature to be kept constant on the outside thereof. The temperature can be adjusted based on a detection result of a temperature detector (not shown) that is inserted inside the adsorption towers 62a to 62c (72a to 72c). Also, a plurality of temperature detectors inserted thereinto allow an adsorption band to be kept track of so as to observe adsorption behavior. Differential pressures of the adsorption towers 62a to 62c (72a to 72c) are monitored by measuring the internal pressures of the adsorption towers 62a to 62c (72a to 72c) by a plurality of pressure sensors (not shown), so that the respective powdering conditions of the adsorbents can be grasped as well.

The type of carrier gas fed to the heating unit 61 (71) may be an inert gas such as nitrogen, hydrogen, and argon, for instance. The carrier gas is heated to 40 to 200°C and then fed to each of the adsorption towers 62a to 62c (72a to 72c).

An operation of the first purification unit 60 and the second purification unit 70 is as follows. A carrier gas such as hydrogen that is heated to about 40 to 200°C by the heating unit 61 (71) is first introduced to each of the adsorption towers 62a to 62c (72a to 72c). Then the carrier gas is discharged by the vacuum pump 66 (76) until the pressure reaches -0.1 MPaG to -0.09 MPaG. The pressure is maintained in this condition for about 1 to 100 hours. Then the respective temperatures of the adsorption towers 62a to 62c (72a to 72c) are cooled down to predetermined temperatures (an adsorbent pretreatment). Then, upon the introduction of a mixed gas whose temperature is 0 to 100°C and whose pressure is -0.01 MPaG to 5.0 MPaG into the adsorption towers 62a to 62c (72a to 72c), phosphine, diborane, disilane and the like contained in the mixed gas are adsorbed to the absorbents. As a result, a gas whose total concentration of phosphine, diborane, disilane and the like is 1000 ppm or below, preferably 100 ppm or below, or more preferably 10 ppm or below is discharged from the adsorption towers 62a to 62c (72a to 72c) in an early stage of the introduction of the mixed gas. In the light of energy efficiency, it is preferred that the mixed gas whose temperature is 30 to 40°C and whose pressure is -0.01 MPaG to 1.0 MPaG be introduced into the adsorption towers 62a to 62c (72a to 72c).

The adsorption-desorption switching three-way valves 65a to 65c are controlled such that exhaust passages of the adsorption towers 62a to 62c in the first purification unit 60 communicate with the second purification unit 70. Also, the adsorption-desorption switching three-way valves 75a to 75c are controlled such that exhaust passages of the adsorption towers 72a to 72c in the second purification unit 70 communicate with a gas analysis unit 6e. Then a Fourier transform infrared spectrometer (FT-IR) and an on-line gas chromatography (GC) in the gas analysis unit 6e conduct composition analysis of phosphine, diborane, disilane and the like. And when phosphine, diborane, disilane and the like of predetermined concentrations are detected by the gas analysis unit 6e, the adsorption-desorption switching three-way valves 65a to 65c (75a to 75c) shut off the passages communicating with the second purification unit 70 (the gas analysis unit 6e).

Phosphine, diborane, disilane and the like adsorbed to the first purification unit 60 and/or the second purification unit 70 can be now desorbed through the TSA process or PSA process, for instance. More specifically, heating the adsorption towers 62a to 62c (72a to 72c) to about 40 to 120°C by the electric furnace causes phosphine, diborane, disilane and the like to be desorbed from the adsorbents, when the TSA process is employed. Also, more specifically, depressurizing the adsorption towers 62a to 62c (72a to 72c) down to -0.1 MPaG to -0.05 MPaG causes phosphine, diborane, disilane and the like to be desorbed from the adsorbents, when the PSA process is employed. As a result, the gas discharged from the adsorption towers 62a to 62c (72a to 72c) substantially contains phosphine, diborane, disilane and the like in a high concentration. The gas containing phosphine, diborane, disilane and the like in a high concentration communicates with the exhaust passages and is treated appropriately and safely by a mixed gas treatment unit 8.

The mixed gas treatment unit 8 is an apparatus for detoxifying or abating monosilane, phosphine, diborane, disilane and the like, which are toxic gases. Also, the mixed gas treatment 8 is provided with a structure in which such toxic gases are diluted with noble gas to a predetermined concentration level and are then introduced into an detoxification unit or abatement unit where such gasses as monosilane, phosphine, diborane and disilane are detoxified or abated to an allowable concentration level or below and then discharged outside.

Gas analysis units 6a to 6f may be provided to measure the component of gas communicated to the silane gas treatment unit 20 from the flow rate control unit 5 as well as the component concentration of high-concentration monosilane gas and high-concentration argon separated by and discharged from the silane gas purification unit 50 and the noble gas treatment unit 30. A method for the measurement employed by the gas analysis units 6a and 6f is not particularly limited as long as at least the concentration of monosilane and the concentration of argon in the mixed gas can be measured. For example, such a method may be one using an FT-IR with a gas circulation type sample cell, an on-line type gas chromatograph, or the like.

If the concentration of argon and the concentration of monosilane measured by the gas analysis units 6c and 6e are less than predetermined concentration levels, a mechanism may be provided supplementarily where argon and monosilane are sent to the monosilane detoxification unit (not shown) and a noble gas exhaust unit (not shown), without being circulated in the semiconductor fabrication equipment 1 and the bump unit 2, respectively, so that they can be treated safely and appropriately.

The accumulators 9a and 9b have argon and monsilane, recovered by the noble gas treatment unit 30 and the silane gas purification unit 50, circulated in the pump unit 2 and the semiconductor fabrication equipment 1 at constant pressure. The accumulators 9a and 9b as used herein are not particularly limited insofar as they attain the aforementioned purpose. And the pressure to be accumulated in the accumulators 9a and 9b must be lower than the pressure of gas supplied to the accumulators 9a and 9b and higher than the pressure with which the differential pressure of a flow rate control apparatus of the semiconductor fabrication equipment 1 can be obtained. If no such a range of pressures can be obtained, a boosting apparatus (not shown) will be preferably provided at a stage prior to the accumulators in order to raise the supply pressure to the accumulators 9a and 9b. The boosting apparatus as used herein may preferably be one further having the same features and requisites as those of the above-described gas compression unit 3. The pressure to be accumulated in the accumulators 9a and 9b is not limited to a particular value insofar as it serves the aforementioned purpose and may preferably be 0.05 MPaG to 10 MPaG or more preferably 0.1 MPaG to 0.5 MPaG.

A detailed description is given hereunder of the present embodiment based on exemplary embodiments or examples but the present embodiment is not limited to these exemplary embodiments only.

### (Exemplary embodiment 1-1)

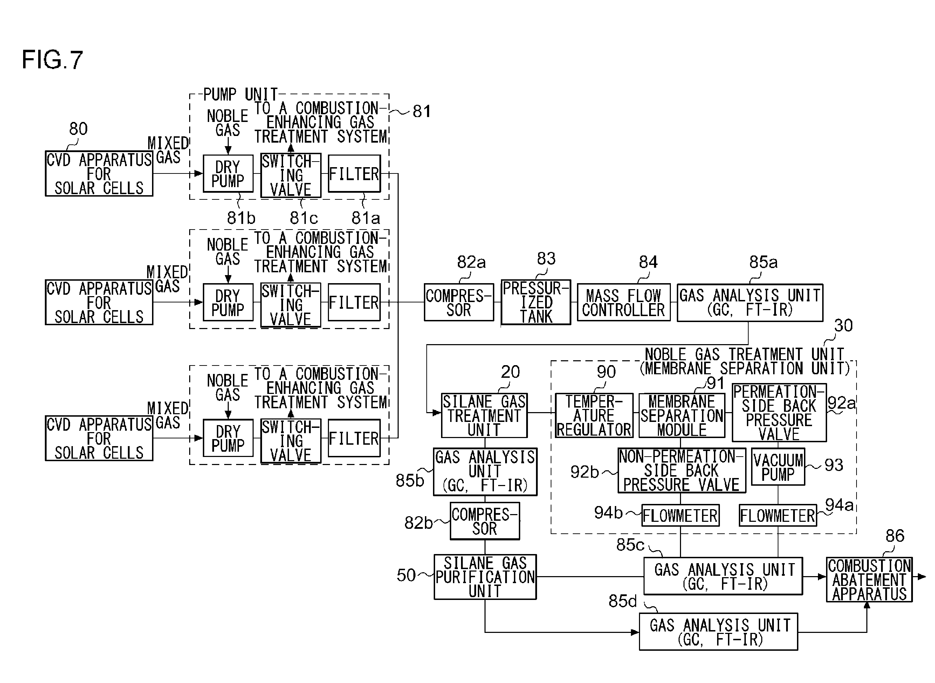

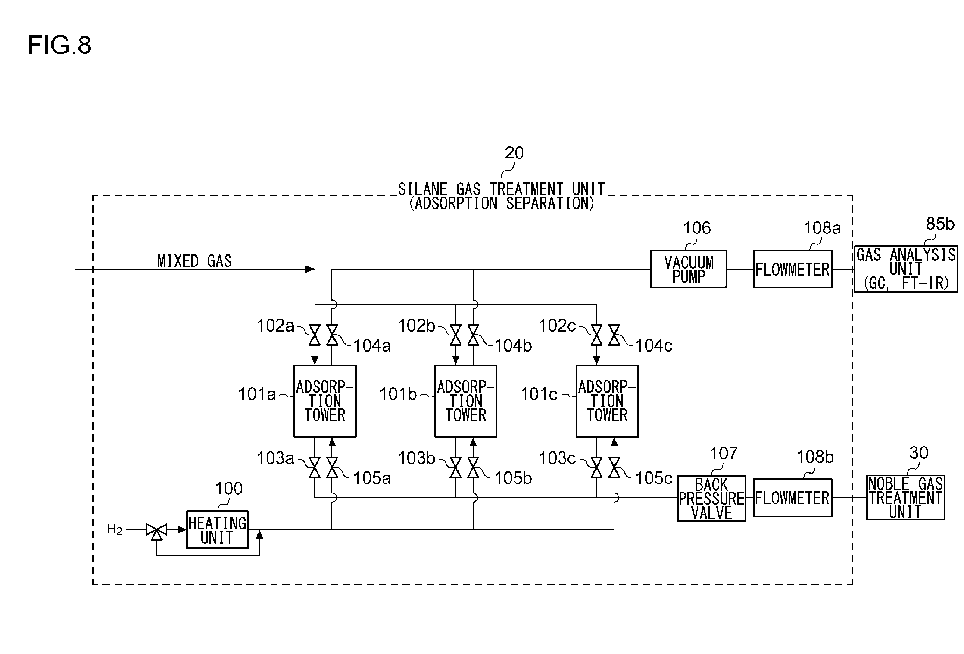

FIG. 7 and FIG. 8 are each a system diagram showing a structure of an exhaust gas treatment system according to exemplary embodiment 1-1. In the exemplary embodiment 1-1, the silane gas treatment unit 20 shown in FIG. 7 uses an adsorption separation method as depicted in FIG. 8. As shown in FIG. 7, the exhaust gas treatment system according to the above-described first embodiment is connected to three CVD apparatuses 80 for thin-film silicon solar cells. Here, the thin-film silicon solar cell CVD apparatus 80 is a semiconductor fabrication equipment 1. The exhaust gas treatment system suctions the mixed gas, discharged from a plurality of thin-film silicon solar cell CVD apparatuses 80, together with purge gases introduced into dry pumps 81 b, by the dry pumps 81 b corresponding respectively to the thin-film silicon solar cell CVD apparatuses 80. Then the exhaust gas treatment system delivers the mixed gas and the purge gases toward a compressor 82a via a filter 81 a. Note that a switching valve 81 c is provided after the dry pump 81 b. With this configuration, the operation mode is switched to the combustion-enhancing gas treatment system when exhaust gas comes out as a result of the chemical cleaning, thereby preventing such exhaust gas from being mixed into a treatment line of a silane-based gas.

A compressor capable of being operated at the compression ratio of 4 is selected as the compressor 82a. While an outlet valve (not shown) of a pressurized tank 83a (capacity: 1 m³) is closed, argon is delivered to each dry pump 81 b as purge gas at the flow rate of 10 NL/min, so that the pressure of the pressurized tank 83 is boosted up to 0.5 MPaG. Then the outlet valve of the pressurized tank 83 is opened and the supply of gas to a mass flow controller 84a starts. Also, the respective thin-film silicon solar cell CVD apparatuses 80 start their operations such that the start of operation of each of the three thin-film silicon solar cell CVD apparatuses 80 lags each other by four minutes. The gas flow rate is controlled at 20 NL/min by the mass flow controller 84a and is supplied to an adsorption tower 101 a of the silane gas treatment unit 20 (with activated carbon filled, as adsorbent, with a volume of 21.6 L). The gas, whose flow rate has been controlled at a constant value by the mass flow controller 84a, undergoes gas composition analysis, and the pressure of the adsorption tower 101a is controlled at 0.4 MPaG by a back pressure valve 107. Before the start of operation, each of adsorption towers 101a to 101c is heated to 200°C and the pretreatment is carried out for four hours while hydrogen is delivered at a rate of 10 NL/min. Then it is cooled down to a room temperature and is then controlled at a predetermined adsorption temperature (e.g., 30°C). The temperature of the gas that has passed through the adsorption tower 101 a is adjusted at 30°C by a temperature regulator 90 before the gas is introduced into a membrane separation module 91 (polyimide hollow fiber membrane with a volume of 1.2 L). A vacuum pump 93 is connected at a permeation side of the membrane separation module 91, and the permeation-side pressure of the membrane separation module 91 is adjusted to -0.1 MPaG at a permeation-side back pressure valve 92a. The flow rate and the composition of a gas on the permeation side are measured by GC (gas chromatogram) and FT-IR in a gas analysis unit 85c. The non-permeation-side pressure of the membrane separation module 91 is controlled to 0.4 MPaG at a non-permeation-side back pressure valve 92b. The flow rate and the composition of a gas on the non-permeation side are measured by a flowmeter 94b and the GC (gas chromatogram) and FT-IR in the gas analysis unit 85c. After the operation for one hour, the adsorption tower 101a closes adsorption switching valves 102a and 103a and opens adsorption switching valves 102b and 103b. Thereby, the operation is switched to an adsorption tower 101 b so as to continue the operation. At the same time, both a desorption switching valve 104a and a carrier gas introduction switching valve 105a are opened so as to deliver hydrogen at a rate of 10 NL/min. Also, the pressure is reduced to -0.09 MPaG by a vacuum pump 106 over a period of one hour. As a result, components adsorbed to the adsorption tower 101 a are removed. The flow rate and the composition of the desorbed gas are measured by a flowmeter 108a and a gas analysis unit 85b. The operating conditions and results are gathered in Table 1 and Table 2.

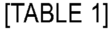

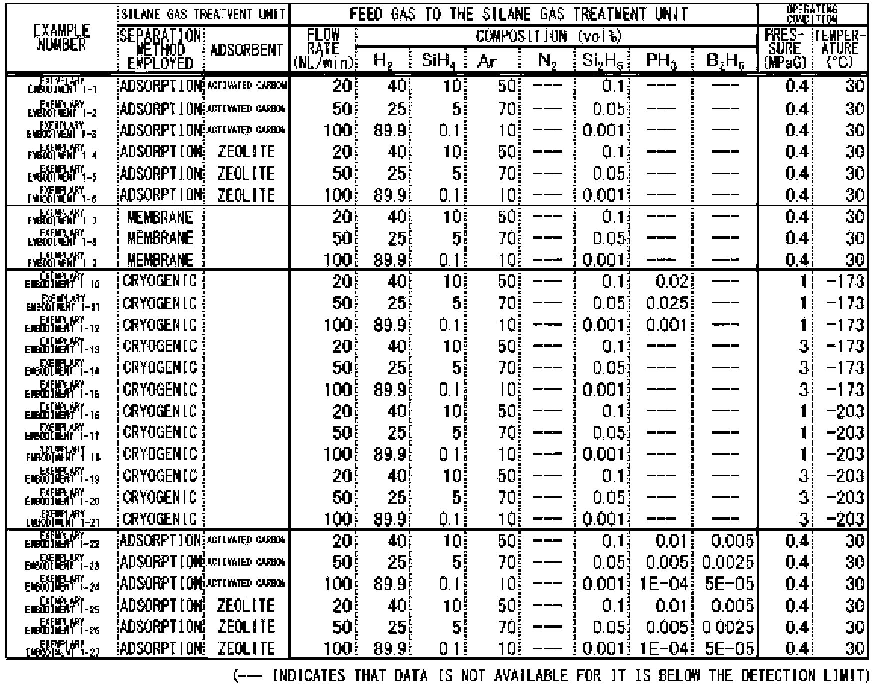

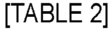

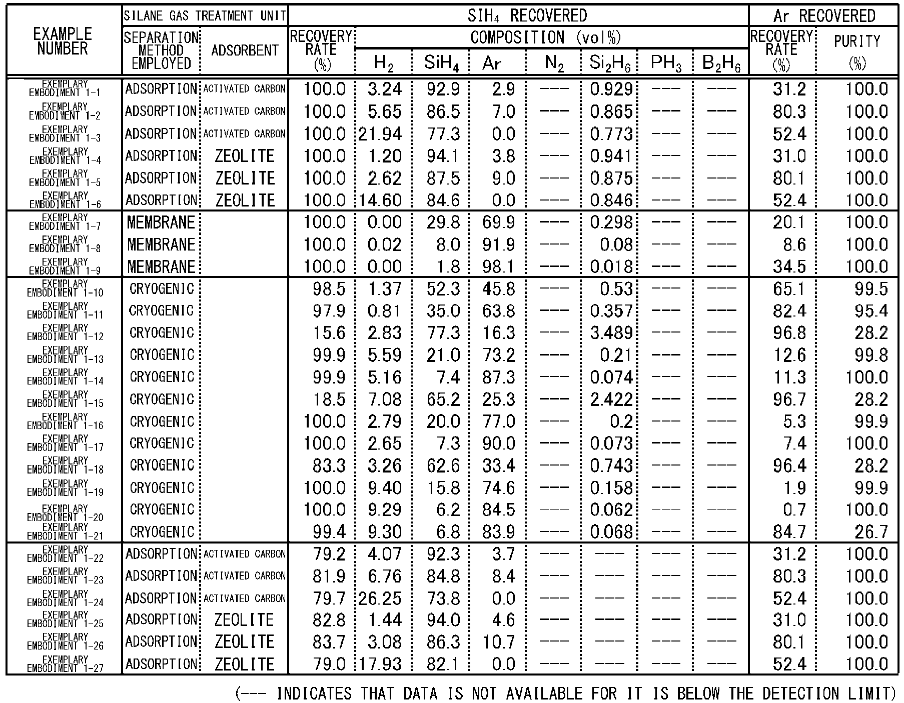

### (Exemplary embodiments 1-2 and 1-3)

The exhaust gas treatment system is operated under the same conditions as those of the exemplary embodiment 1-1 excepting the flow rate of the mass flow controller 84a and the gas composition. The operating conditions and results are gathered in Table 1 and Table 2.

### (Exemplary embodiments 1-4 to 1-6)

The exhaust gas treatment system is operated under the same conditions as those of the exemplary embodiments 1-1 to 1-3 excepting that zeolite is used as absorbent. The operating conditions and results are gathered in Table 1 and Table 2.

### (Exemplary embodiments 1-7 to 1-9)

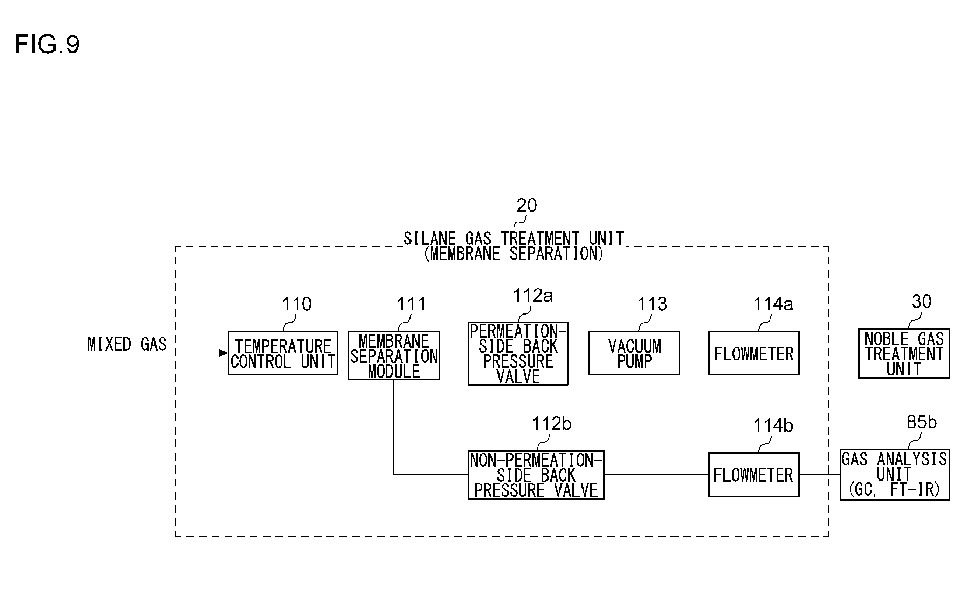

The exhaust gas treatment system is operated, similarly to the exemplary embodiments 1-1 to 1-3, using the membrane separation as shown in FIG. 9 as the silane gas treatment unit. The temperature of the mixed gas, whose flow rate is controlled by the mass flow controller 84a, is adjusted at 30°C before the mixed gas is introduced into a membrane separation module 111 (polyimide hollow fiber membrane with a volume of 1.2 L). A vacuum pump 113 is connected at a permeation side of the membrane separation module 111, and the permeation-side pressure of the membrane separation module 111 is adjusted to -0.1 MPaG at a permeation-side back pressure valve 112a. The non-permeation-side pressure of the membrane separation module 111 is controlled to 0.4 MPaG at a non-permeation-side back pressure valve 112b. The flow rate and the composition of a gas on the permeation side is measured by the use of a flowmeter 114a, whereas the flow rate and the composition of a gas on the non-permeation side are measured by the use of a flowmeter 114b and the GC (gas chromatogram) and FT-IR in the gas analysis unit 85c. The operating conditions and results are gathered in Table 1 and Table 2.

### (Exemplary embodiments 1-10 to 1-21)

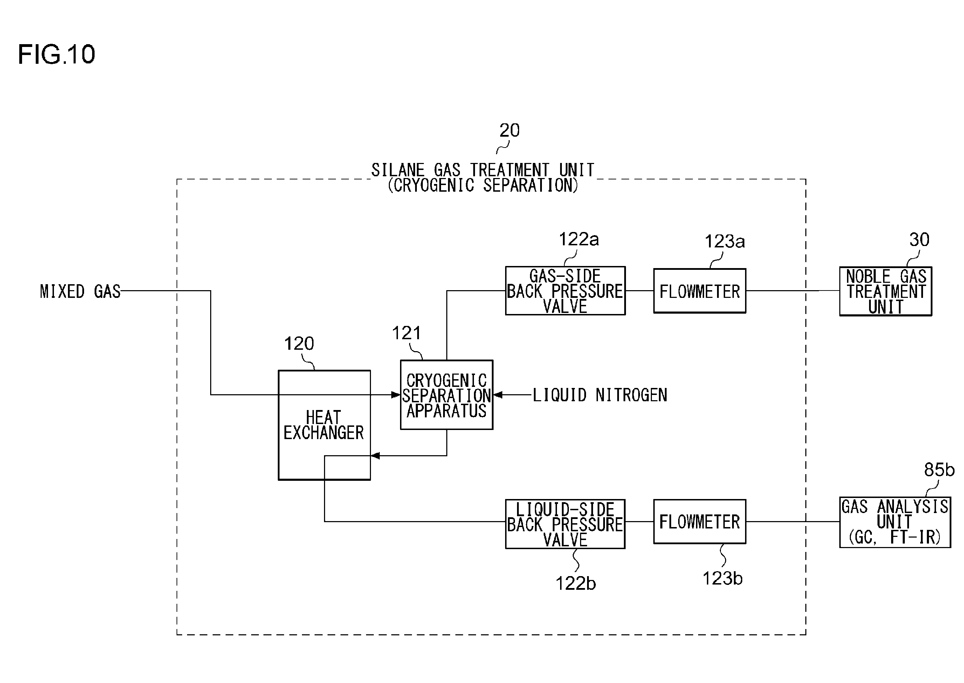

The exhaust gas treatment system is operated, similarly to the exemplary embodiments 1-1 to 1-3, using the cryogenic separation as shown in FIG. 10 as the silane gas treatment unit. The pressure of the pressurized tank 83 is boosted up to 1.1 MPaG or 3.1 MPaG. And the flow rate is controlled by the mass flow controller 84a and the mixed gas is sent to a cryogenic separation apparatus 121 via a heat exchanger 120. The cryogenic separation apparatus 121 controls the temperature of gas layer at predetermined temperatures (e.g., -173, -203°C) with liquid nitrogen and, furthermore, the pressure inside the cryogenic separation apparatus 121 is controlled to 1 MPaG or 3 MPaG. Also, a liquid-side back pressure valve 122b performs control such that the liquid level in the cryogenic separation apparatus 121 is kept at a constant level, and delivers the liquid to the gas analysis unit 85b. The flow rate of gas on a gas side is measured by a flowmeter 123a, whereas the flow rate and the composition of gas on a liquid side are measured by a flowmeter 123b and the GC (gas chromatogram) and FT-IR in the gas analysis unit 85b. The operating conditions and results are gathered in Table 1 and Table 2.

### (Exemplary embodiments 1-22 to 1-27)

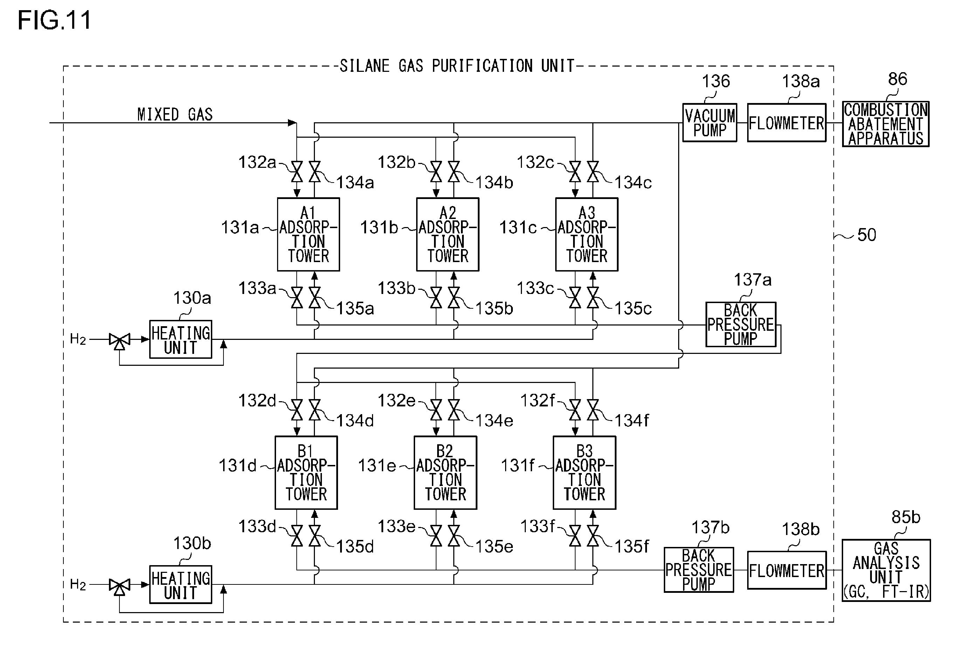

In order that n-type membranes are produced by one of the three thin-film silicon solar cell CVD apparatus 80 and p-type type membranes are produced by another one thereof, PH₃ and B₂H₆ are introduced thereinto, respectively, and the exhaust gas treatment system is operated similarly to the exemplary embodiments 1-1 to 1-6 excepting that a silane gas purification unit 50 is provided. FIG. 11 schematically shows a specific structure of a silane purification unit in an exhaust gas treatment system according to the exemplary embodiments 1-22 to 1-27. The pressure of the mixed gas discharged by a vacuum pump 106 of the silane gas treatment unit 20 is boosted up to 0.6 MPaG by a compressor 82b so as to be accumulated in a pressurized tank 83b. Then the flow rate of the mixed gas is controlled at a constant value by a mass flow controller 84b. Thereby, the mixed gas is introduced into an A1 adsorption tower 131 a of the silane gas purification unit 50 (with H-substituted mordenite-type zeolite filled, as adsorbent, with a volume of 5.0 L) and then the mixed gas is introduced into a B1 adsorption tower 131d (with activated alumina filled, as adsorbent, with a volume of 4.3 L). In the exemplary embodiments 1-22 and 1-25, the constant value is 2.0 NL/min. In the exemplary embodiments 1-23 and 1-26, the constant value is 2.5 NL/min. In the exemplary embodiments 1-24 and 1-27, the constant value is 0.5 NL/min. The pressure of the A1 adsorption tower 131 a is controlled at 0.5 MPaG by a back pressure valve 137a, and the pressure of the B1 adsorption tower 131d is controlled at 0.4 MPaG by a back pressure valve 137b. The flow rate and the composition of a gas that has passed through without being desorbed are measured by a flowmeter 138b and the gas analysis unit 85b. Before the start of operation, each of A1 to A3 adsorption towers (131 a to 131c) is heated to 200°C and the pretreatment is carried out for four hours while hydrogen is delivered at a rate of 10 NL/min. Then it is cooled down to a room temperature and is then controlled at a predetermined adsorption temperature (e.g., 30°C). Before the start of operation, each of B1 to B3 adsorption towers (131d to 131f) undergoes the pretreatment for four hours at 30°C while hydrogen is delivered at a rate of 10 NL/min. After this, the temperature of each of the B1 to B3 adsorption towers (131d to 131f) is kept at 30°C. After the operation for one hour, the A1 adsorption tower 131a and the B1 adsorption tower 131d close adsorption switching valves 132a plus 133a and 132d plus 133d, respectively, and open adsorption switching valves 132b plus 133b and 132e plus 133e, respectively. Thereby, the operation is switched to the A2 adsorption tower 131 b and the B2 adsorption tower 131 d so as to continue the operation. Simultaneously, desorption switching valves 134a and 134d are opened and the pressure is reduced to -0.09 MPaG by a vacuum pump 136 over a period of one hour while hydrogen is delivered at a rate of 10 NL/min. As a result, components adsorbed to the A1 adsorption tower 131a and the B1 adsorption tower 131d are removed. The flow rate of the desorbed gas is measured by a flowmeter 138a and then the desorbed gas is detoxified or abated by a combustion abatement apparatus 86 and then released to atmosphere. The operating conditions and results are gathered in Table 1 and Table 2.

### (Comparative examples 1-1 to 1-21)

The exhaust gas treatment system is operated under the same conditions as those of the exemplary embodiments 1-1 to 1-15 excepting that N₂ is used as the purge gas. The operating conditions and results are gathered in Table 3 and Table 4.

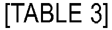

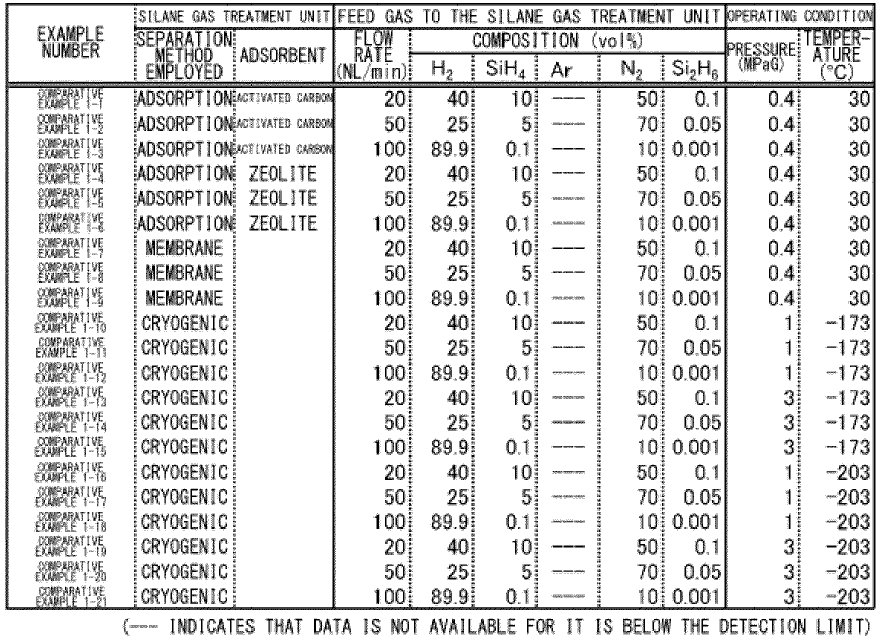

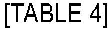

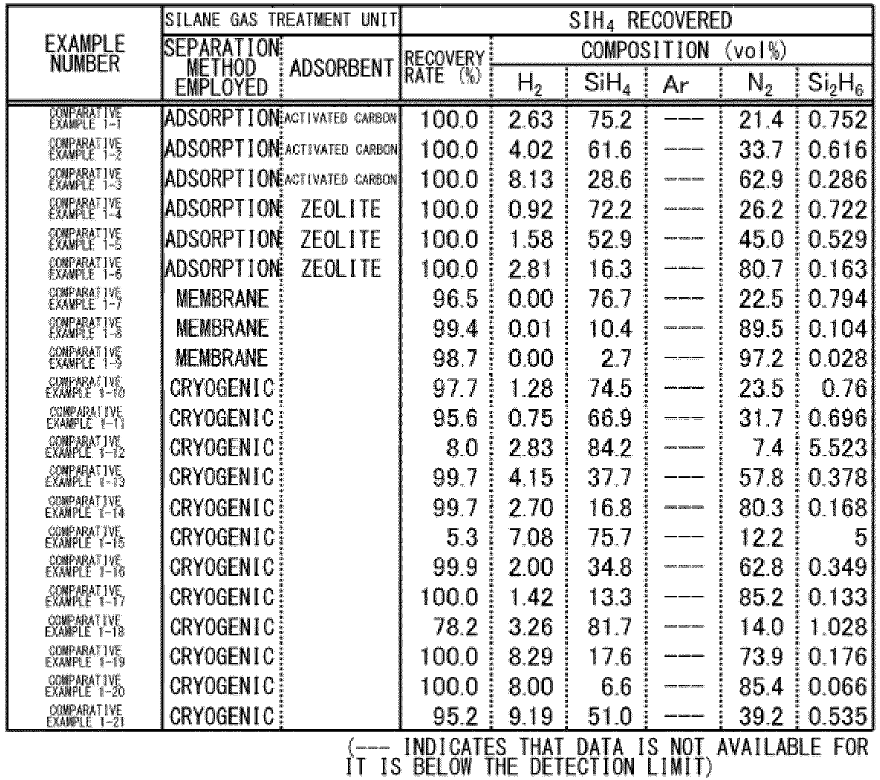

Using SiH₄ recovered in the exemplary embodiments 1-1, 1-4, 1-22 and 1-25 and the comparative examples 1-1 and 1-4, a-Si solar cells are made according to a routine method so as to conduct a characteristic evaluation of them. The results are gathered in Table 5.

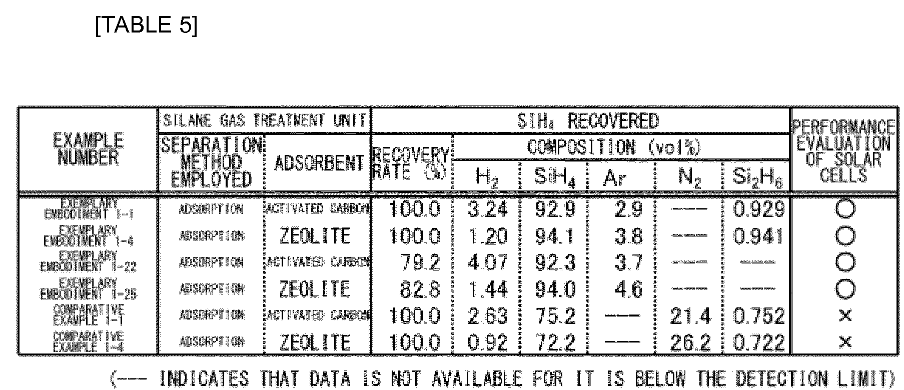

From the above results, it is evident that use of argon as the purge gas prevents a dopant component from being mixed into monosilane recovered and therefore the adverse effect of the dopant component on the performance of the solar cells can be reduced. Also, use of adsorption separation as the silane gas treatment unit attains a higher monosilane recovery rate than when other separation methods are used at an equal or higher purity level. Furthermore, the hydrogen/argon mixed gas separated by the silane gas treatment unit is processed by the membrane separation apparatus, so that high-purity argon can be recovered with a higher recovery rate.

### (Second Embodiment)

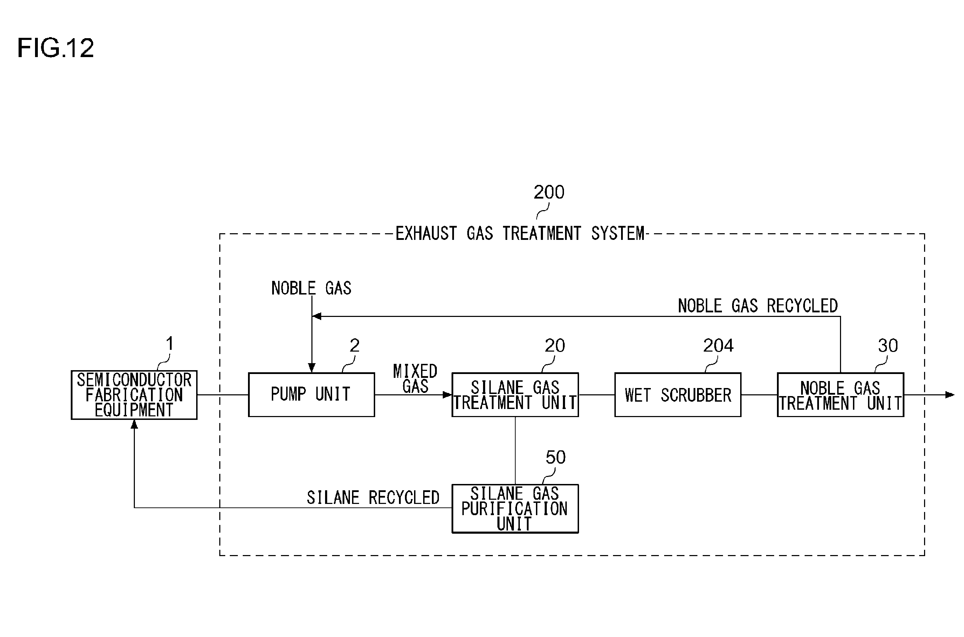

FIG. 12 is a system diagram showing an exemplary overview of an exhaust gas treatment system according to a second embodiment. As shown in FIG. 12, an exhaust gas treatment system 200 according to the second embodiment treats a mixed gas, which contains at least monosilane, hydrogen and argon, discharged from a semiconductor fabrication equipment 1 via a pump unit 2. And the exhaust gas treatment system 200 includes a silane gas treatment unit 20, which separates and recovers monosilane so as to be reused, a wet scrubber 204, which removes impurities mainly composed of hydrides in the mixed gas, mainly containing a high proportion of argon and hydrogen, discharged from the silane gas treatment unit 20, a noble gas treatment unit 30, which separates and collects (recovers) argon from the mixed gas, where the hydrides have been removed, discharged from the wet scrubber 204 and which reuses the thus recovered argon, and a silane purification unit 50, which purifies monosilane from the mixed gas, mainly containing a high proportion of monosilane, discharged from the silane gas treatment unit 20.

The silane gas treatment unit 20 allows the mixed gas to pass therethrough and separates the mixed gas into a monosilane-rich gas containing a high proportion of monosilane contained in the mixed gas and a hydrogen/noble gas-rich gas containing a high proportion of hydrogen and purge gas. A method for separating the mixed gas into a monosilane-rich gas and a hydrogen/noble gas-rich gas is not limited to any particular methods as long as the mixed gas can be separated into a gas composed primarily of monosilane and a mixed gas composed primarily of hydrogen and purge gas. For example, such a method may be an adsorption separation method using adsorbents.

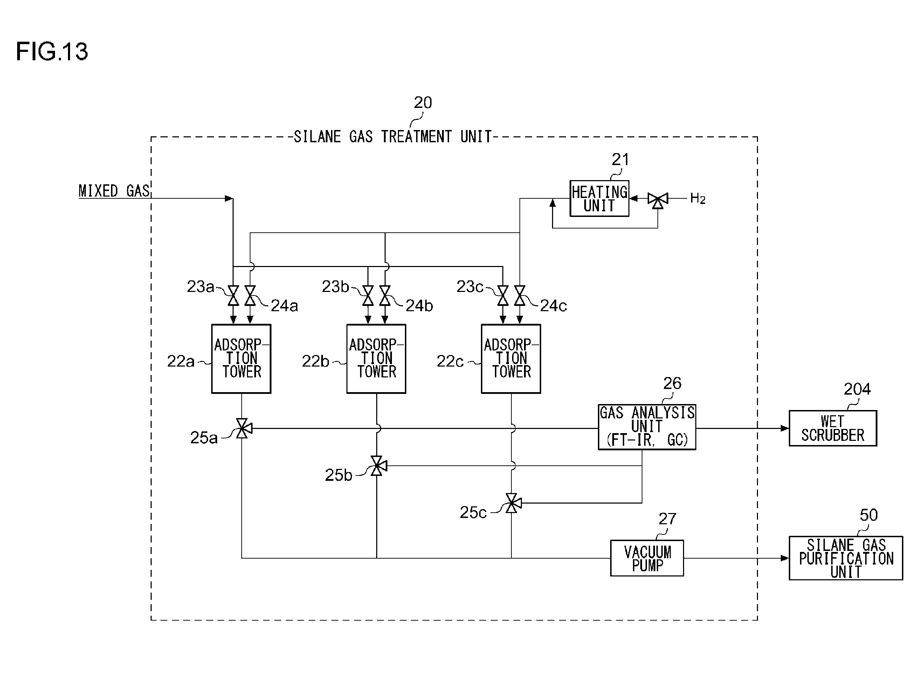

FIG. 13 schematically shows a specific structure of the silane gas treatment unit 20 when the silane gas treatment unit 20 carries out a adsorption separation process.

In the present embodiment, the adsorption-desorption switching three-way valves 25a to 25c are controlled such that exhaust passages of the adsorption towers 22a to 22c communicate with the wet scrubber 204. The gas analysis unit 26 conducts composition analysis of the mixed gas discharged from the absorbents by the use of a Fourier transform infrared spectrometer (FT-IR) and an on-line gas chromatography (GC). And when monosilane of a predetermined concentration is detected thereby, the adsorption-desorption switching three-way valves 25a to 25c shut off the passages, between the adsorption towers 22a to 22c and the wet scrubber, by the adsorption-desorption switching three-way valves 25a to 25c.

Also, in the present embodiment, the exhaust passages of the adsorption towers 22a to 22c are connected to the silane gas purification unit 50 and, furthermore, the adsorption-desorption switching three-way valves 25a to 25c are controlled such that exhaust passages of the adsorption towers 22a to 22c communicate with and circulate in the semiconductor fabrication equipment 1.

As described above, for the TSA process the silane gas treatment unit 20 controls the timings with which the mixed gas is introduced and the adsorption towers are heated, whereas for the PSA process the silane gas treatment unit 20 controls the timings with which the mixed gas is introduced and the adsorption towers are depressurized. Thereby, the monosilane-rich gas can be separated and then the thus separated monosilane gas can be sent to the semiconductor fabrication equipment 1 at a high concentration so as to be circulated thereinto. Also, the adsorption towers into which the mixed gas or carrier gas is introduced are switched sequentially by using the adsorption-desorption switching valves 23a to 23c and 24a to 24c. This enables the adsorption and desorption of monsilane in the mixed gas to be continuously carried out without any interruption. In other words, when the adsorption switching valve 23a is opened while the other valves are closed and when the adsorption-desorption switching three-way valve 25a is switched to a wet scrubber 204 side, the mixed gas flows into the adsorption tower 22a only and monosilane in the mixed gas is mainly adsorbed. Thus a hydrogen/noble gas-rich gas with a reduced monosilane concentration can be obtained at the wet scrubber 204. The adsorption is carried out for a predetermined length of time. Then the adsorption switching valve 23b is opened while the other valves are closed, and the adsorption-desorption switching three-way valve 25b is switched to the wet scrubber 204 side. This delivers the mixed gas to the adsorption tower 22b where monosilane in the mixed gas is mainly adsorbed, so that a hydrogen/noble gas-rich gas whose monosilan concentration has been mainly reduced can be continuously obtained at the wet scrubber 204 side. In parallel with the aforementioned processing, the adsorption-desorption switching three-way valve 25a is switched to a silane gas purification unit 50 side so that the gas can be fed to the semiconductor fabrication equipment 1, and then monosilane mainly adsorbed onto the adsorption tower 22a is desorbed through the above-described PSA or TSA process. This allows a gas containing monosilane in a high concentration to be circulated on the semiconductor fabrication equipment 1 side. Repeating these operations alternately for each adsorption tower allows a predetermined gas to be uninterruptedly supplied to the wet scrubber 204 side and the silane gas purification 50 side.

The wet scrubber 204 is not limited to any particular one as long as impurities (mainly hydrides) in the hydrogen/noble gas-rich gas containing a high proportion of hydrogen and argon separated by the silane gas treatment unit 200 can be removed by having the impurities mainly composed of hydrides pass through water. The wet scrubber 204 may preferably be a water scrubber, provided with a rotary stirring structure, having a high contact efficiency, for instance. More preferably, the wet scrubber 204 may have a horizontal scrubber structure in order to relieve blockage caused by precipitates occurring in connection with the removal of the impurities.

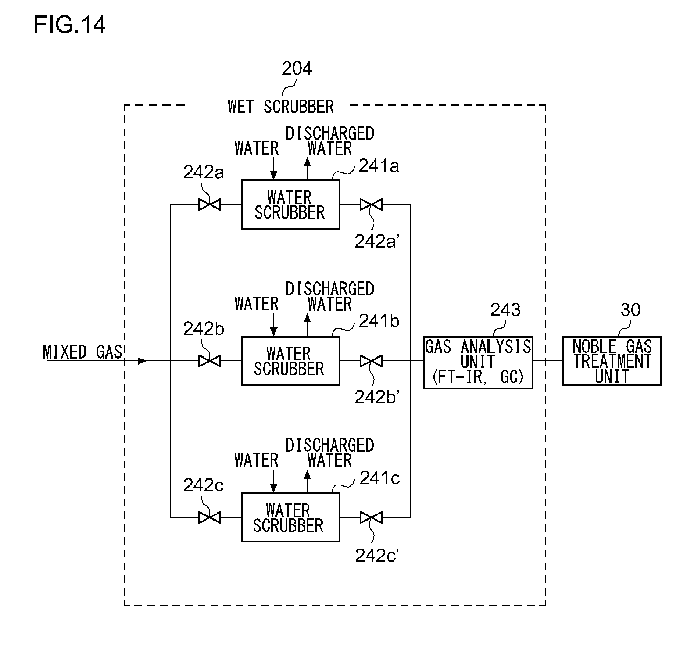

FIG. 14 schematically shows a specific structure of the wet scrubber 204. As shown in FIG. 14, the wet scrubber 204 includes water scrubbers 241 a to 241 c (namely, a plurality of water scrubbers 241) that are arranged in parallel to each other. Also, each water scrubber is provided with a mechanism (not shown) by which the temperature inside the water scrubber is adjusted. Further, the water scrubbers 241 a to 241 c can each be used independently if each of switching valves 242a to 242c, provided anterior to the water scrubbers 241 a to 241c, and each of switching valves 242a' to 242c' provided posterior thereto are switched. Further, each water scrubber is provided with a mechanism by which the water scrubber once used can be discharged and refilled. Furthermore, each water scrubber is provided with a cleaning mechanism (not shown), compatible with a given scaling, using a high pressure means or the like. Also, a gas analysis unit 243 may be provided posterior to the water scrubbers, in which case the processing status at the water scrubbers can be verified.

The noble gas treatment unit 30 is not limited to any particular one as long as it can separate wet hydrogen and dry argon, whose water concentration is 20 ppm or below, from a "mixed gas" composed mainly of hydrogen, argon and moisture content. Here, the "mixed gas" is composed mainly of hydrogen, argon and moisture content obtained when a hydrogen/noble gas-rich gas mainly composed of hydrogen and argon separated from the monosilane-rich gas by the silane gas treatment unit 20 is passed through the wet scrubber 204 in order to remove the impurities contained in the hydrogen/noble gas-rich gas. The noble gas treatment unit 30 may be a membrane separation means using a membrane separation module, for instance. Though the structure of a membrane separation apparatus used in this case may be similar to that of the membrane separation apparatus 32 according to the first embodiment, a membrane used for the membrane separation 32 may preferably be one that allows hydrogen and moisture to be selectively passed through and one for which the coefficient of moisture is larger than that of hydrogen.

The structure of the silane purification unit 50 is similar to that of the first embodiment.

A detailed description is given hereunder of the present embodiment based on exemplary embodiments or examples but the present embodiment is not limited to these exemplary embodiments only.

### (Exemplary embodiment 2-1)

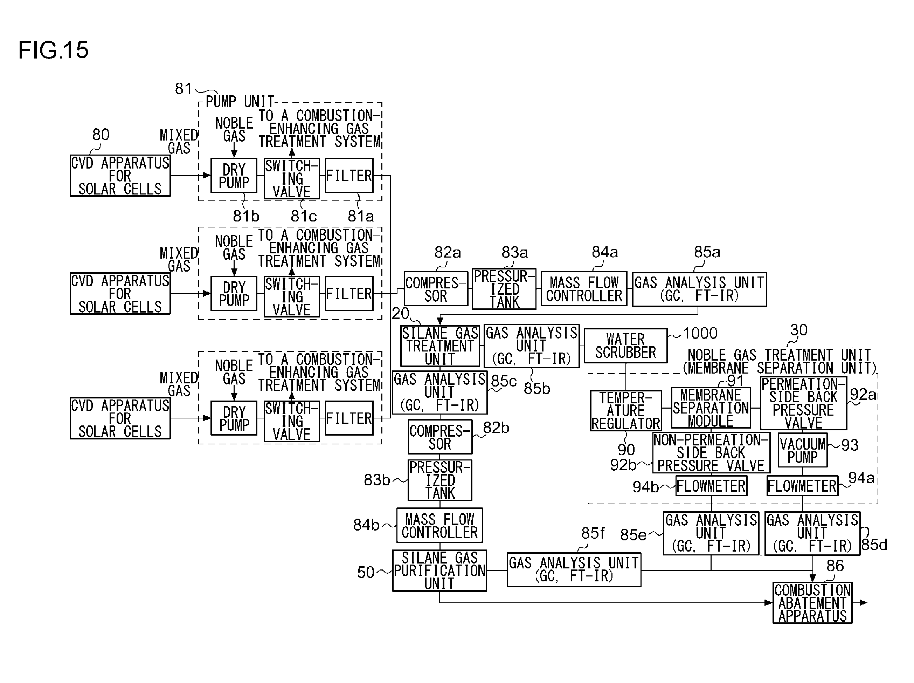

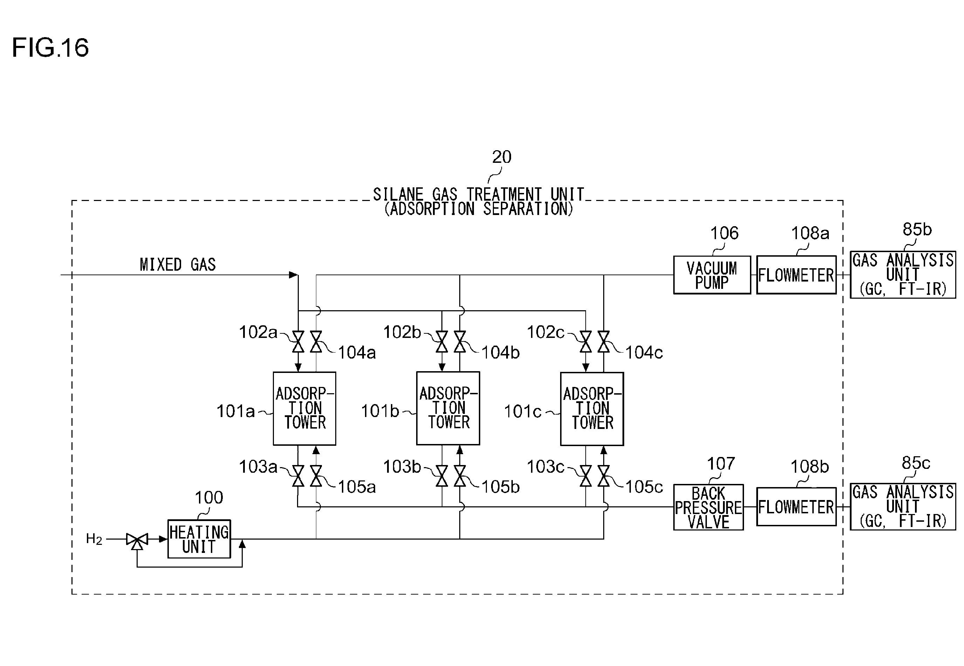

FIG. 15 and FIG. 16 are each a system diagram showing a structure of an exhaust gas treatment system according to exemplary embodiment 2-1. In the exemplary embodiment 2-1, the silane gas treatment unit 20 shown in FIG. 15 uses an adsorption separation method as depicted in FIG. 16. As shown in FIG. 15, the exhaust gas treatment system according to the above-described second embodiment is connected to three CVD apparatuses 80 for thin-film silicon solar cells. Here, the thin-film silicon solar cell CVD apparatus 80 is a semiconductor fabrication equipment 1. The exhaust gas treatment system suctions the mixed gas, discharged from a plurality of thin-film silicon solar cell CVD apparatuses 80, together with purge gases introduced into dry pumps 81 b, by the dry pumps 81 b corresponding respectively to the thin-film silicon solar cell CVD apparatuses 80. Then the exhaust gas treatment system delivers the mixed gas and the purge gases toward a compressor 82a. Note that a switching valve 81c is provided posterior to the dry pump 81 b. With this configuration, the operation mode is switched to the combustion-enhancing gas treatment system when exhaust gas comes out as a result of the chemical cleaning, thereby preventing such exhaust gas from being mixed into a treatment line of a silane-based gas. Also, in order that n-type membranes are produced by one of the three thin-film silicon solar cell CVD apparatus 80 and p-type type membranes are produced by another one thereof, PH₃ and B₂H₆ are introduced thereinto, respectively,

A compressor capable of being operated at the compression ratio of 4 is selected as the compressor 82a. While an outlet valve (not shown) of a pressurized tank 83a (capacity: 1 m³) is closed, argon is delivered to each dry pump 81 b as purge gas at the flow rate of 10 NL/min, so that the pressure of the pressurized tank 83a is boosted up to 0.5 MPaG. Then the outlet valve of the pressurized tank 83a is opened and the supply of gas to a mass flow controller 84a starts. Also, the respective thin-film silicon solar cell CVD apparatuses 80 start their operations such that the start of operation of each of the three thin-film silicon solar cell CVD apparatuses 80 lags each other by four minutes. The gas flow rate is controlled at 20 NL/min by the mass flow controller 84a and is supplied to an adsorption tower 101 a of the silane gas treatment unit 20 (with activated carbon filled, as adsorbent, with a volume of 60 L). The gas, whose flow rate has been controlled at a constant value by the mass flow controller 84a, undergoes gas composition analysis, and the pressure of the adsorption tower 101a is controlled at 0.3 MPaG by a back pressure valve 107. Before the start of operation, each of adsorption towers 101 a to 101c is heated to 200°C and the pretreatment is carried out for four hours while hydrogen is delivered at a rate of 10 NL/min. Then it is cooled down to a room temperature and is then controlled at a predetermined adsorption temperature (e.g., 30°C).

After the operation for one hour, the adsorption tower 101 a closes adsorption switching valves 102a and 103a and opens adsorption switching valves 102b and 103b. Thereby, the operation is switched to an adsorption tower 101 b so as to continue the operation. Simultaneously, a desorption switching valve 104a is opened and the pressure is reduced to -0.09 MPaG by a vacuum pump 106 over a period of one hour. As a result, components adsorbed to the adsorption tower 101 a are removed. After the operation for one hour, the adsorption tower 101 b closes the adsorption switching valves 102b and 103b and opens adsorption switching valves 102c and 103c. Thereby, the operation is switched to an adsorption tower 101c so as to continue the operation. Simultaneously, the desorption switching valve 104a is closed and opened and the pressure is reduced to -0.09 MPaG by the vacuum pump 106 over a period of one hour. This removes the components adsorbed to the adsorption tower 101 b. A cycle of three hours so far is now defined as one cycle. Now the adsorption tower in operation is returned from the adsorption tower 101 c to the adsorption tower 101 a and the adsorption tower for which the desorption is to be done is shifted from the adsorption tower 101 b to the adsorption tower 101c. Then experiments from a second cycle and onward are conducted. The flow rate and the composition of each gas separated by the silane gas treatment unit 20 are measured by flowmeters 108a and 108b and gas analysis units 85b and 85c. The operating conditions are gathered in Table 6, and the separated gas components after the respective gases have been passed through the silane gas treatment unit are gathered in the Table 7 and Table 8.

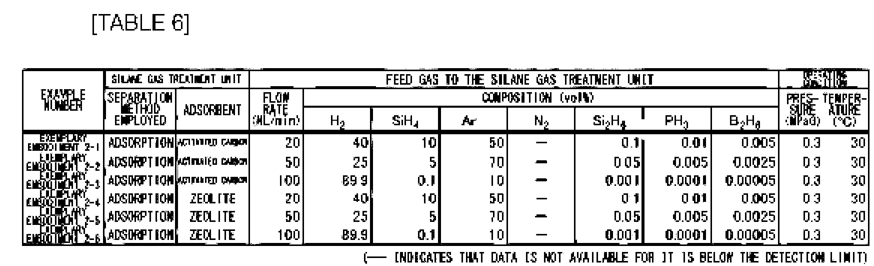

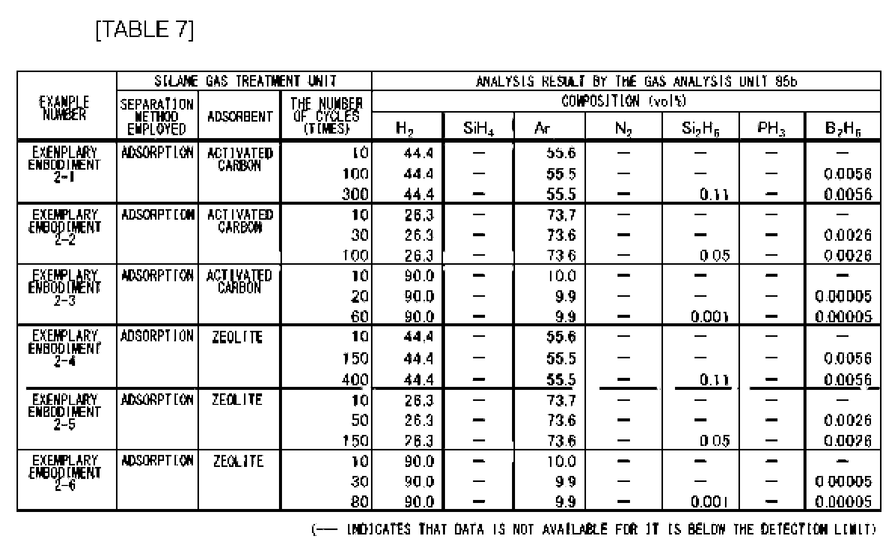

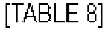

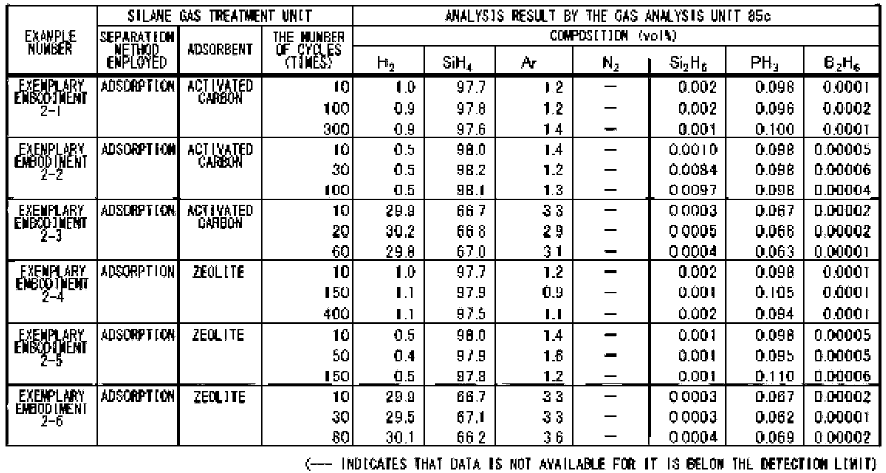

After a gas containing large amounts of hydrogen and argon, which are separated by the silane gas treatment unit 20 and then sent to the gas analysis unit 85b, has been passed through a water scrubber 1000, the gas is now sent to the noble gas treatment unit 30. The temperature of the gas is adjusted at 30°C by the temperature regulator 90 of the noble gas treatment unit 30 before the gas is introduced into a membrane separation module 91 (polyimide hollow fiber membrane with a volume of 0.6 L). A vacuum pump 93 is connected at a permeation side of the membrane separation module 91, and the permeation-side pressure of the membrane separation module 91 is adjusted to -0.1 MPaG at a permeation-side back pressure valve 92a. The non-permeation-side pressure of the membrane separation module 91 is controlled to 0.1 MPaG at a non-permeation-side back pressure valve 92b. The flow rate and the composition of a gas on the non-permeation side are measured by a flowmeter 94b and the GC (gas chromatogram) and FT-IR in a gas analysis unit 85e. The results analyzed by the gas analysis unit 85e are gathered in Table 9. Table 9 also shows the results of comparative examples 2-1 to 2-6 where the gas discharged from the gas analysis unit 85b is fed to the noble gas treatment unit 30 by bypassing the water scrubber 1000.

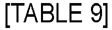

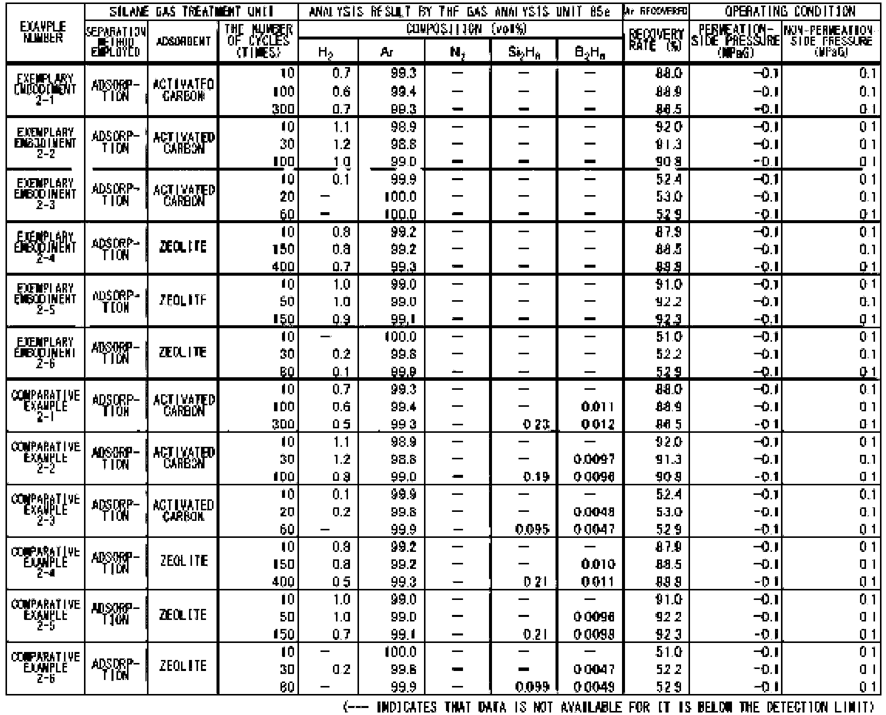

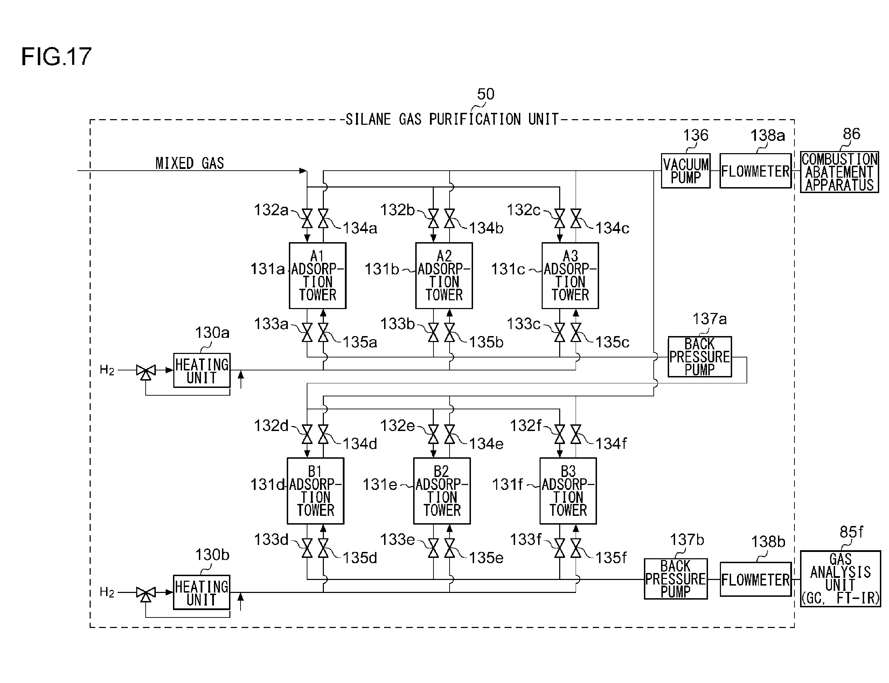

FIG. 17 schematically shows a specific structure of a silane gas purification unit in the exhaust gas treatment system according to exemplary embodiments. The pressure of the mixed gas discharged by a vacuum pump 106 of the silane gas treatment unit 20 is boosted up to 0.4 MPaG by a compressor 82b so as to be accumulated in a pressurized tank 83b. Then the flow rate of the mixed gas is controlled at 2.0 NL/min by a mass flow controller 84b. Thereby, the mixed gas is introduced into an A1 adsorption tower 131 a of the silane gas purification unit 50 (with H-substituted mordenite-type zeolite filled, as adsorbent, with a volume of 5.0 L) and then the mixed gas is introduced into a B1 adsorption tower 131d (with activated alumina filled, as adsorbent, with a volume of 20 L). The pressure of the A1 adsorption tower 131a is controlled at 0.4 MPaG by a back pressure valve 137a, and the pressure of the B1 adsorption tower 131d is controlled at 0.4 MPaG by a back pressure valve 137b. The flow rate and the composition of a gas that has passed through without being desorbed are measured by a flowmeter 138b and the gas analysis unit 85b. Before the start of operation, each of A1 to A3 adsorption towers (131 a to 131c) is heated to 200°C and the pretreatment is carried out for four hours while hydrogen is delivered at a rate of 10 NL/min. Then it is cooled down to a room temperature and is then controlled at a predetermined adsorption temperature (e.g., 30°C). Before the start of operation, each of B1 to B3 adsorption towers (131 d to 131f) undergoes the pretreatment for four hours at 30°C while hydrogen is delivered at a rate of 10 NL/min. After this, the temperature of each of the B1 to B3 adsorption towers (131d to 131f) is kept at 30°C. After the operation for one hour, the A1 adsorption tower 131 a closes adsorption switching valves 132a and 133a and opens adsorption switching valves 132b and 133b. Thereby, the operation is switched to the A2 adsorption tower 131 b so as to continue the operation. Simultaneously, desorption switching valves 134a and 135a are opened, the pressure is reduced to -0.09 MPaG by a vacuum pump 136, and the adsorbed material is desorbed for one hour while hydrogen is delivered at a rate of 10 NL/min. As a result, components adsorbed to the A1 adsorption tower 131 a are removed. Further, after the operation for one hour, the A2 adsorption tower 131 b closes adsorption switching valves 132b and 133b and opens adsorption switching valves 132c and 133c. Thereby, the operation is switched to the A3 adsorption tower 131 c so as to continue the operation. Simultaneously, adsorption switching valves 134b and 135b are opened, the pressure is reduced to -0.09 MPaG by the vacuum pump 136, and the adsorbed material is desorbed for one hour while hydrogen is delivered at a rate of 10 NL/min. As a result, components adsorbed to the A2 adsorption tower 131 b are removed. Furthermore, after the operation for one hour, the A3 adsorption tower 131c closes the adsorption switching valves 132c and 133c and opens the adsorption switching valves 132a and 133a. Thereby, the operation is switched to the A1 adsorption tower 131a so as to start another cycle. Simultaneously, adsorption switching valves 134c and 135c are opened, and shifting to a desorption process for the A3 adsorption tower 131 c is prepared. A cycle of three hours so far is now defined as one cycle and the experiments for a plurality of cycles are conducted. After the flow rate of desorbed gas is measured by the flowmeter 138a, the desorbed gas is detoxified or abated by a combustion abatement apparatus 86 and then released to atmosphere. The constituent concentrations detected by the gas analysis unit 85f are gathered in Table 10.

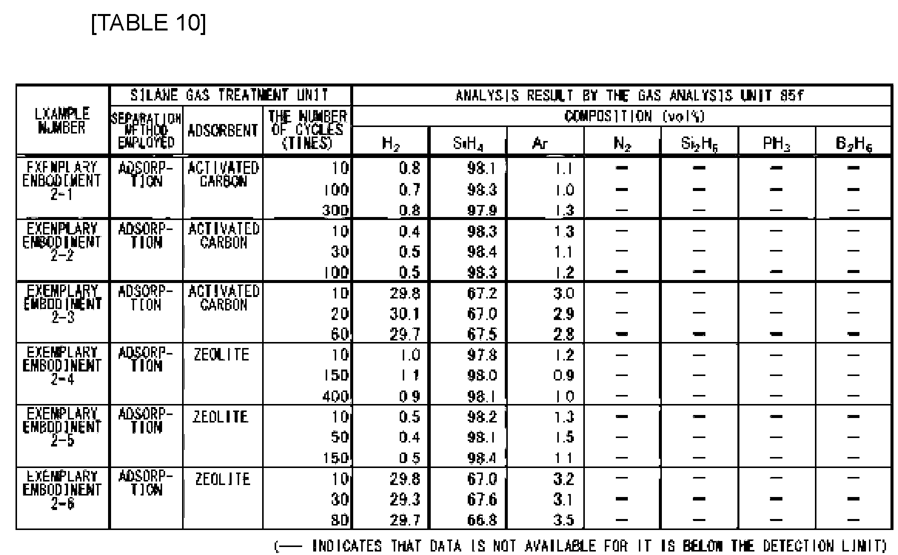

### (Exemplary embodiments 2-2 and 2-3)

The exhaust gas treatment system is operated under the same conditions as those of the exemplary embodiment 2-1 excepting the flow rates of the mass flow controllers 84a and 84b and the gas composition. The experiments are conducted under conditions where the flow rate of the mass flow controller 84b is 2.5 NL/min in the exemplary embodiment 202 and 0.5 NL/min in the exemplary embodiment 2-3.

### (Exemplary embodiments 2-4 to 2-6)

The exhaust gas treatment system is operated under the same conditions as those of the exemplary embodiments 2-1 to 2-3 excepting that zeolite 13X (80 L) is used.

### (Comparative examples 2-1 to 2-6)

The exhaust gas treatment system is operated under the same conditions as those of the exemplary embodiments 2-1 to 2-6 excepting that the gas having passed through the gas analysis unit 85b in the exemplary embodiments 2-1 to 2-6 is fed to the noble gas treatment unit 30 by bypassing the water scrubber 1000 (no such a bypass line is depicted in FIG. 8).

### (Comparative examples 2-7 to 2-12)

The exhaust gas treatment system is operated under the same conditions as those of the exemplary embodiments 2-1 to 2-6 excepting that N₂ is used as the purge gas. Analysis results of the gas analysis unit 85f under such conditions are gathered in Table 11.

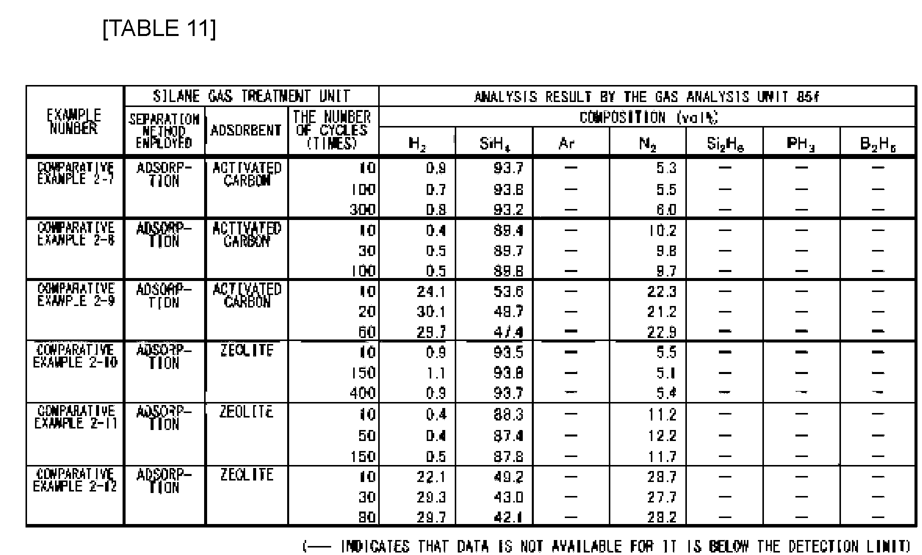

Using SiH₄ recovered in the exemplary embodiments 2-1 to 2-6 and the comparative examples 2-7 to 2-12, a-Si solar cells are made according to a routine method so as to conduct a characteristic evaluation of them. The results are gathered in Table 12.

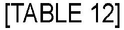

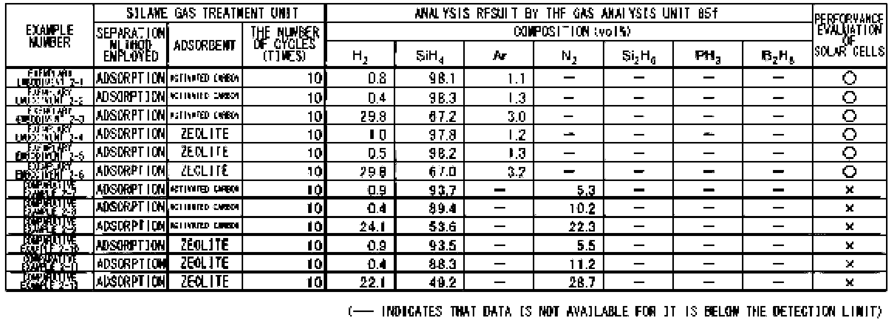

From the above results, it is evident that use of argon as the purge gas prevents a dopant component from being mixed into monosilane recovered and therefore the adverse effect of the dopant component on the performance of the solar cells can be reduced. Also, the hydrogen/noble gas-rich gas separated by the silane gas treatment unit is made to pass through the water scrubber. Thus high-purity argon gas where the hydrides such as diborane and disilane have been removed can be recovered and recycled.

### (Third Embodiment)

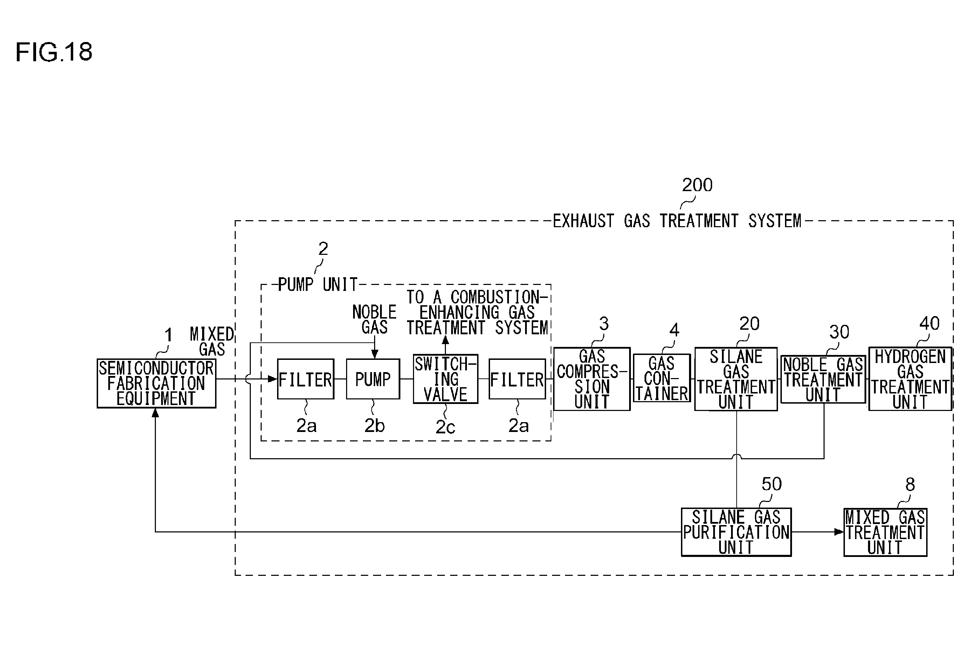

FIG. 18 is a system diagram showing an exemplary overview of an exhaust gas treatment system 200 according to a third embodiment. As shown in FIG. 18, the exhaust gas treatment system 200 according to the second embodiment includes a gas compression unit 3 for compressing a mixed gas, containing at least monosilane and argon, discharged from a semiconductor fabrication equipment 1 via a pump unit 2, a gas container 4 for accumulating the compressed mixed gas, a flow rate control unit (not shown) for controlling the mixed gas accumulated at the gas container 4 so that the mixed gas can be supplied, at a constant flow rate, to passages and components provided at a stage subsequent to the flow rate control unit, a silane gas treatment unit 20 for separating and recovering monosilane to be recycled, a noble gas treatment unit 30 for separating and recovering argon from the mixed gas so as to be recycled, and a silane gas purification unit 50 for raising the purity of a gas containing a high proportion of monosilane separated by the monosilane gas treatment unit 20.

The pump unit 2 suctions the mixed gas discharged from the semiconductor fabrication equipment 1, and sends out the mixed gas to the gas compression unit 3 provided at a stage subsequent to the pump unit 2.

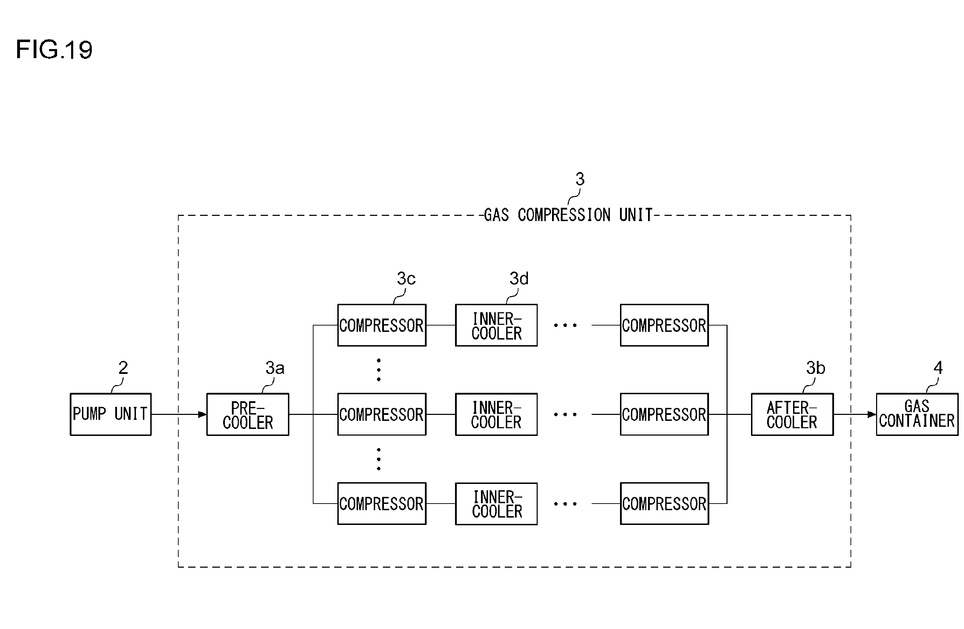

FIG. 19 schematically shows a specific structure of the gas compressing unit 3. The gas compression unit 3 can boost the pressure of the mixed gas discharged from the pump unit 2 up to 100 MPaG, preferably up to 15. 0 MPaG, or more preferably up to 5.0 MPaG. A compressor used for the gas compression unit 3 is not particular limited and may be a diaphragm compressor, a centrifugal compressor, an axial flow compressor, a reciprocating compressor, a twin-screw compressor, a single-screw compressor, a scroll compressor, a rotary compressor or the like. Among these compressors, a diaphragm compressor is highly preferred.

The structure of a compressor used for the gas compression unit 3 is not particularly limited. In order to stably operate the compressor even when the flow rate of the mixed gas fed to the compressor varies, the gas compression unit 3 is preferably configured such that both a compressor and an inverter are provided or the gas compression unit 3 is preferably configured by the use of a spill-back method where the mixed gas once compressed by the compressor is returned to a suction side of compressor.

The operating condition of the compressor used for the gas compression unit 3 is preferably operated such that the temperature of the compress gas to be fed to subsequent stages is 70 to 250°C or preferably 100 to 200°C. That is, when, for example, the mixed gas discharged from the pump unit 2 is compressed from an ordinary pressure, the compressor is preferably operated at a compression ratio of 10 or below or more preferably a compression ratio of 6 or below.

In order to achieve a desired pressure, the gas compression unit 3 may be configured such that a plurality of compressors are placed in series to each other. In such a case, for the purpose of enhancing the compression efficiency, it is preferable that an after-cooler 3b (or an inner-cooler 3d) is each provided subsequent to each of a plurality of compressors. And it is preferable that the temperature of the mixed gas is cooled down to -50°C to 50°C or more preferably to 0°C to 30°C each time and then the thus cooled mixed gas is fed to a next compressor.

The gas container 4 collects the mixed gas discharged from a plurality of semiconductor fabrication equipment 1 through the gas compression units in a tank or the like having a sufficient capacity. Thereby, the gas container 4 can average variations in the flow rate and the pressure of the mixed gas discharged from the respective semiconductor fabrication equipment 1 and can constantly deliver the mixed gas having a constant flow rate and a constant pressure to the silane gas treatment unit 20 provided at a stage subsequent to the gas container 4. The gas container 4 may be provided with a structure by which to deliver the gas to a subsequent stage at a constant flow rate. Also, a function of removing fine particles contained in the mixed gas may be added by devising the structure of the exhaust gas treatment system.

Though not particularly limited, the size of the tank used for the gas container 4 may preferably be set to at least a value corresponding a maximal flow rate of gas supplied to the semiconductor fabrication equipment 1.

Though not particularly limited, the pressure inside the tank used for the gas container 4 may be accumulated at a maximum of 10 MPaG. It may preferably be accumulated up to 5.0 MPaG or more preferably be accumulated up to 1 MPaG.

At the start-up of the system, it is preferable that while the outlet valve of the gas container 4 is being closed, the purge gas in a pump or the mixed gas be supplied to the gas container 4 from the gas compression unit 3 so as to be accumulated in the gas container 4. This can maintain a pressure enough to mitigate adverse changes in the supply flow rate of gas supplied to the respective subsequent separation apparatuses, in the event that the exhaust gas flow rate of the semiconductor fabrication equipment varies greatly. At the same time, the amount of gas that can be held in the gas container 4 can be increased and therefore the volume of the gas container 4 can be reduced. Further, accumulation of sufficient pressure allows the separation efficiency at each of the separation apparatuses, which is operationally advantageous.

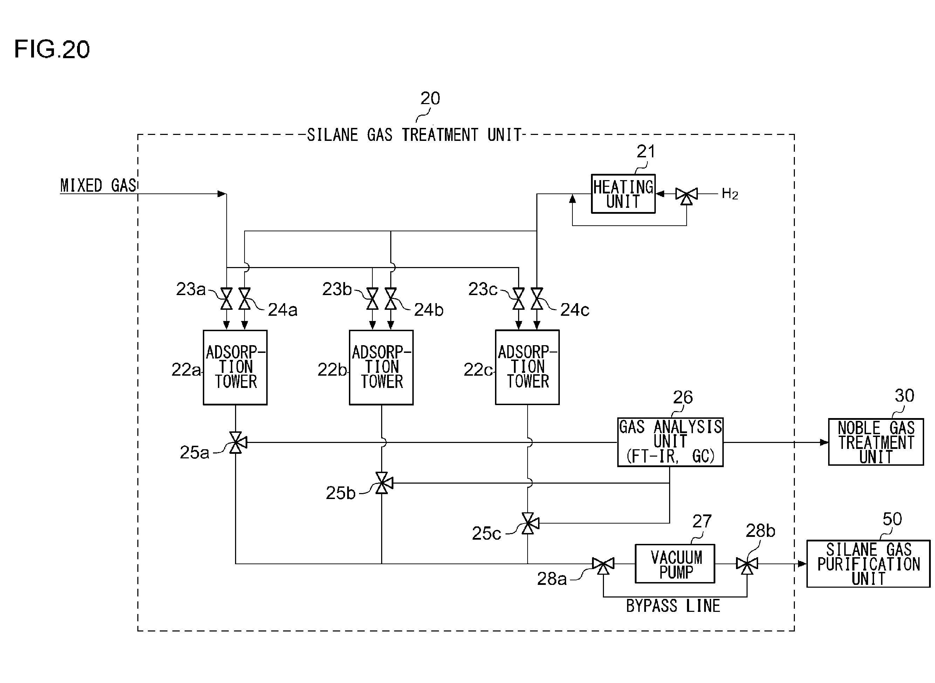

FIG. 20 schematically shows a specific structure of the silane gas treatment unit 20. The silane gas treatment unit 20 according to the present embodiment is provided with a bypass line that eliminates the involvement of the vacuum pump 27, in order that boosting the pressure to a sufficient level by the gas compression unit 3 can achieve the operation of a monosilane recycling process without provision of any further boosting processes subsequent to the gas compression unit 3. Thus the silane gas treatment unit 20 according to the present embodiment is also provided with three-way valves 28a and 28b. In the present embodiment, the three-way valves 25a to 25c are controlled such that the exhaust passages of the adsorption towers 22a to 22c communicate with the silane gas purification unit 50.

For the TSA process the silane gas treatment unit 20 controls the timings with which the mixed gas is introduced and the adsorbents are heated, whereas for the PSA process the silane gas treatment unit 20 controls the timings with which the mixed gas is introduced and the adsorbents are depressurized is depressurized. Thereby, the monosilane gas alone can be separated from the mixed gas and then the thus separated monosilane gas can be sent to the silane gas purification unit 50 at a high concentration so as to be circulated into the semiconductor fabrication equipment 1. Also, the adsorbents into which the mixed gas or carrier gas is introduced are switched sequentially by using the valves 23a to 23c and 24a to 24c. This enables the adsorption and desorption of monsilane in the mixed gas to be continuously carried out without any interruption. In other words, when the valve 23a is opened while the other valves are closed and when the three-way valve 25a is switched to a noble gas treatment unit 30 side, the mixed gas flows into the adsorption tower 22a only and monosilane in the mixed gas is adsorbed. Thus a gas with a reduced monosilane concentration can be obtained at the noble gas treatment unit 30. The adsorption is carried out for a predetermined length of time. Then the valve 23b is opened while the other valves are closed, and the three-way valve 25b is switched to the noble gas treatment unit 30 side. This delivers the mixed gas to the adsorption tower 22b where monosilane in the mixed gas is adsorbed, so that a gas with a reduced monosilane concentration can be continuously obtained at the noble gas treatment unit 30 side. In parallel with the aforementioned processing, the three-way valve 25a is switched to a semiconductor fabrication equipment 1 side and then monosilane adsorbed onto the adsorption tower 22a is desorbed through the above-described PSA or TSA process. This allows a gas containing monosilane in a high concentration to be circulated on the semiconductor fabrication equipment 1 side. Repeating these operations alternately for each adsorbent allows a predetermined gas to be uninterruptedly supplied to the noble gas treatment unit 30 side and the silane gas purification unit 50 side.

The structure of the noble gas treatment unit 30 is similar to that of the first embodiment.

The noble gas treatment unit 30 is not limited to the membrane separation means and the adsorption-separation means alone as long as the mixed gas can be separated into monosilane and other components excluding monosilane. For example, the noble gas treatment unit 30 as used herein may be an adsorption-separation means using adsorbents or a cryogenic separation means where the mixed gas is separated through distillation or partial condensation utilizing the difference in temperature when the mixed gas is cooled to a low temperature so as to be liquefied and condensed.

Note that the structure of the silane purification unit 50 is similar to that of the first embodiment.

In the exhaust gas treatment system according to the present embodiment, other various supplemental facilities as shown in FIG. 4 may be additionally provided.

A detailed description is given hereunder of the present embodiment based on exemplary embodiments or examples but the present embodiment is not limited to these exemplary embodiments only.

### (Exemplary embodiment 3-1)

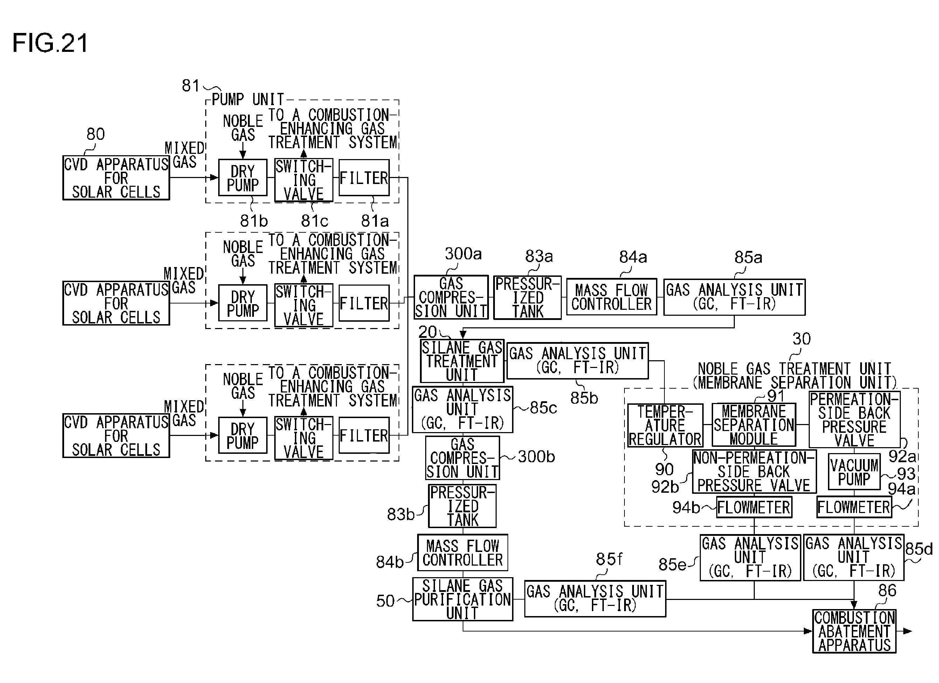

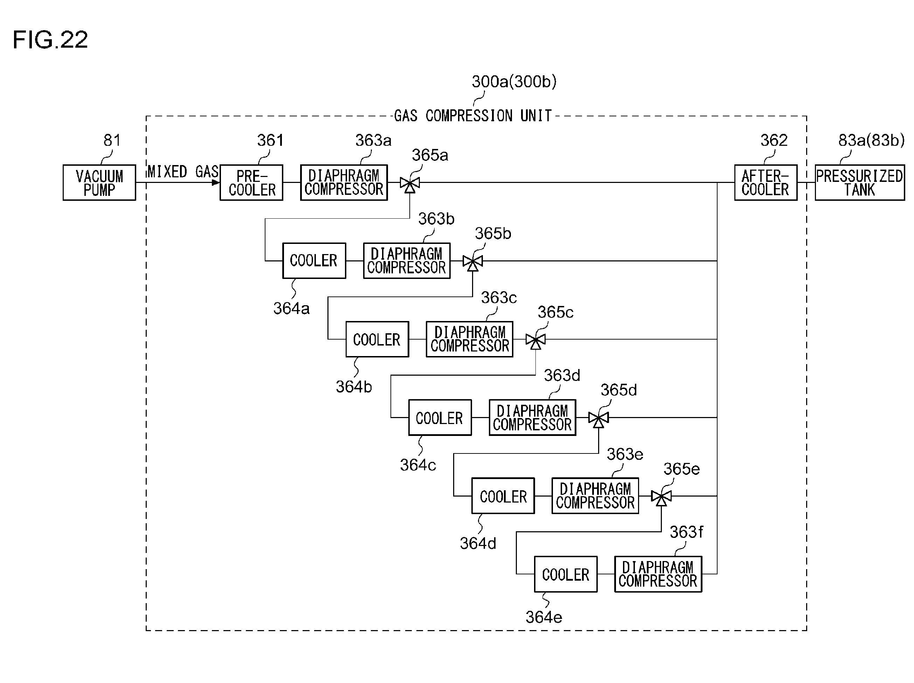

FIG. 21 is a system diagram showing a structure of an exhaust gas treatment system according to exemplary embodiment 3-1. As shown in FIG. 21, the exhaust gas treatment system according to the above-described third embodiment is connected to three CVD apparatuses 80 for thin-film silicon solar cells. Here, the thin-film silicon solar cell CVD apparatus 80 is a semiconductor fabrication equipment 1. The exhaust gas treatment system suctions the mixed gas, discharged from a plurality of thin-film silicon solar cell CVD apparatuses 80, together with purge gases introduced into dry pumps 81 b, by the dry pumps 81 b corresponding respectively to the thin-film silicon solar cell CVD apparatuses 80. Then the exhaust gas treatment system delivers the mixed gas and the purge gases toward a compression unit 300a via a filter 81 a. Note that a switching valve 81 c is provided after the dry pump 81 b. With this configuration, the operation mode is switched to the combustion-enhancing gas treatment system when exhaust gas comes out as a result of the chemical cleaning, thereby preventing such exhaust gas from being mixed into a treatment line of a silane-based gas. In order that n-type membranes are produced by one of the three thin-film silicon solar cell CVD apparatus 80 and p-type type membranes are produced by another one thereof, PH₃ and B₂H₆ are introduced thereinto, respectively. FIG. 22 shows a structure of the gas compression unit 300a. The gas compression unit 300a, which includes therein six diaphragm compressors and seven heat-exchange type coolers, is configured such that the first to sixth diaphragm compressors can be arranged in series with each other and operated in variable manners by switching on the three-way valves. In the exemplary embodiment 3-1, the temperature of the mixed gas delivered from the vacuum pump is adjusted at 30°C by a pre-cooler 361 provided within the gas compression unit 300a. A diaphragm compressor 363a provided subsequent to the pre-cooler 361 is run by adjusting the exhaust gas temperature at 100°C. A three-way valve 365a is controlled such that the diaphragm compressor 363a communicates with a cooler 364a, and the mixed gas is now fed to a diaphragm compressor 363b. The diaphragm compressor 363b is operated similarly to the diaphragm compressor 363a. A three-way valve 365b is controlled such that the diaphragm compressor 363b communicates with an after-cooler 362. And the temperature of the gas having been compressed in two stages is adjusted at 30°C by the after-cooler 362 and is accumulated in the pressurized tank 83a (capacity: 1 m³). When the pressure of gas is to be accumulated, the purge gas is delivered to each dry pump 81 b at the flow rate of 10 NL/min while the outlet valve (not shown) of the pressurized tank 83a is closed. Then the outlet valve of the pressurized tank 83a is opened and the supply of gas to a mass flow controller 84a starts. Also, the respective thin-film silicon solar cell CVD apparatuses 80 start their operations such that the start of operation of each of the three thin-film silicon solar cell CVD apparatuses 80 lags each other by four minutes. The gas flow rate of the mixed gas sent to the mass flow controller 84a is controlled at 20 NL/min and then sent to a subsequent gas analysis unit 85a where the composition of the gas is analyzed. The operating conditions of the gas compression unit 300a and the flow rates and compositions of the gas analyzed by the gas analysis unit 85a are gathered in Table 13. The gas analysis unit 85a measures the composition of the gas using GC (gas chromatogram) and FT-IR.

**[TABLE 13]**

| EXAMPLE NUMBER | OPERATING CONDITION OF THE GAS COMPRESSION UNIT 60a | | | NALYSIS RESULT BY THE GAS ANALYSIS UNIT 85a | | | | | | |
|---|---|---|---|---|---|---|---|---|---|---|
| | THE NUMBER OF COMPRESSION SEPS [SEPS] | SECONDARY GAS TEMPERATURE [°C] | SECONDARY GAS PRESSURE [MPaG] | GAS FLOW RATE [NL/min] | COMPOSITION | | | | | |
| | | | | | H₂ [ vol.% ] | SiH₄ [ vol.% ] | Ar [ vol.% ] | Si₂H₆ [ vol.ppm ] | PH₃ [ vol.ppm ] | B₂H₆ [ vol.ppm ] |
| EXEMPLARY EMBODIMENT 3-1 | 2 | 100 | 0.30 | 20 | 40.0 | 9.91 | 49.9 | 913 | 100 | <2 |
| EXEMPLARY EMBODIMENT 3-2 | 1 | 200 | 0.30 | 20 | 40.3 | 9.38 | 50.3 | < 0.5 | 101 | <2 |
| EXEMPLARY EMBODIMENT 3-3 | 2 | 100 | 0.30 | 50 | 25.0 | 4.95 | 70.0 | 456 | 50 | <2 |
| EXEMPLARY EMBODIMENT 3-4 | 1 | 200 | 0.30 | 50 | 25.1 | 4.67 | 70.2 | < 0.5 | 50 | <2 |
| EXEMPLARY EMBODIMENT 3-5 | 2 | 100 | 0.30 | 100 | 89.9 | 0.10 | 10.0 | 9 | 1 | <2 |
| EXEMPLARY EMBODIMENT 3-6 | 1 | 200 | 0.30 | 100 | 89.9 | 0.09 | 10.0 | <0.5 | 1 | <2 |

### (Exemplary embodiment 3-2)

The exhaust gas treatment system is operated under the same conditions as those of the exemplary embodiment 3-1 excepting that a secondary gas temperature, when the mixed gas is compressed by the diaphragm compressor 363a, is adjusted at 200°C and excepting that the temperature of the compressed mixed gas is adjusted at 40°C by the pre-cooler 361 and the after-cooler 362 and the compressor is operated in a single stage. The operating conditions of the gas compression unit 300a and the flow rates and compositions of the gas analyzed by the gas analysis unit 85a are gathered in Table 13.

### (Exemplary embodiments 3-3 to 3-6)

The exhaust gas treatment system is operated under the same conditions as those of the exemplary embodiments 3-1 and 3-2 excepting the flow rate of the mass flow controller 84a and the gas composition. The operating conditions of the gas compression unit 300a and the flow rates and compositions of the gas analyzed by the gas analysis unit 85a are gathered in Table 13.

### (Comparative example 3-1)

The exhaust gas treatment system is operated under the same conditions as those of the exemplary embodiments 3-1 and 3-2 excepting that the secondary gas temperature, when the mixed gas is compressed by the diaphragm compressors 363a to 363e, is adjusted at 60°C and excepting that the temperature of the compressed mixed gas is adjusted at 30°C by the pre-cooler 361, the coolers 364a to 364d, and the after-cooler 362, and compression is performed in five stages. The operating conditions of the gas compression unit 300a and the flow rates and compositions of the gas analyzed by the gas analysis unit 85a are gathered in Table 14.

### (Comparative example 3-2)

The exhaust gas treatment system is operated under the same conditions as those of the exemplary embodiments 3-1 and 3-2 excepting that the secondary gas temperature, when the mixed gas is compressed by the diaphragm compressor 363a, is adjusted at 300°C. The operating conditions of the gas compression unit 300a and the flow rates and compositions of the gas analyzed by the gas analysis unit 85a are gathered in Table 14.

### (Comparative examples 3-3 to 3-6)

The exhaust gas treatment system is operated under the same conditions as those of the exemplary embodiments 3-1 and 3-2 and the comparative examples 3-1 and 3-2 excepting the flow rate of the mass flow controller 84a and the gas composition. The operating conditions of the gas compression unit 300a and the flow rates and compositions of the gas analyzed by the gas analysis unit 85a are gathered in Table 14.

**[TABLE 14]**

| EXAMPLE NUMBER | OPERATING CONDITION OF THE GAS COMPRESSION UNIT 60a | | | NALYSIS RESULT BY THE GAS ANALYSIS UNIT 85a | | | | | | |
|---|---|---|---|---|---|---|---|---|---|---|
| | THE NUMBER OF COMPRESSION STEPS [STEPS] | SECONDARY GAS TEMPERATURE [°C] | SECONDARY GAS PRESSURE [MPaG] | GAS FLOW RATE [NL/min] | COMPOSITION | | | | | |
| | | | | | H₂ [Vol.%] | SiH₄ [Vol.% ] | Ar [vol.% ] | Si₂ H₆ [vol.ppm ] | PH₃ [vol.ppm ] | B₂ H₆ [vol.ppm ] |
| COMPARATIVE EXAMPLE 3-1 | 5 | 60 | 0.31 | 20 | 40.0 | 9.92 | 49.9 | 949 | 100 | 29 |
| COMPARATIVE EXAMPLE 3-2 | 1 | 300 | 0.32 | 20 | 44.5 | 0.08 | 55.5 | < 0.5 | 111 | <2 |
| COMPARATIVE EXAMPLE 3-3 | 5 | 60 | 0.31 | 50 | 25.0 | 4.96 | 70.0 | 474 | 50 | 14 |
| COMPARATIVE EXAMPLE 3-4 | 1 | 300 | 0.32 | 50 | 26.3 | 0.04 | 73.6 | < 0.5 | 53 | <2 |
| COMPARATIVE EXAMPLE 3-5 | 5 | 60 | 0.31 | 100 | 89.9 | 0.10 | 10.0 | 9 | 1 | < 2 |
| COMPARATIVE EXAMPLE 3-6 | 1 | 300 | 0.32 | 100 | 90.0 | 7.4 ppm | 10.0 | < 0.5 | 1 | < 2 |

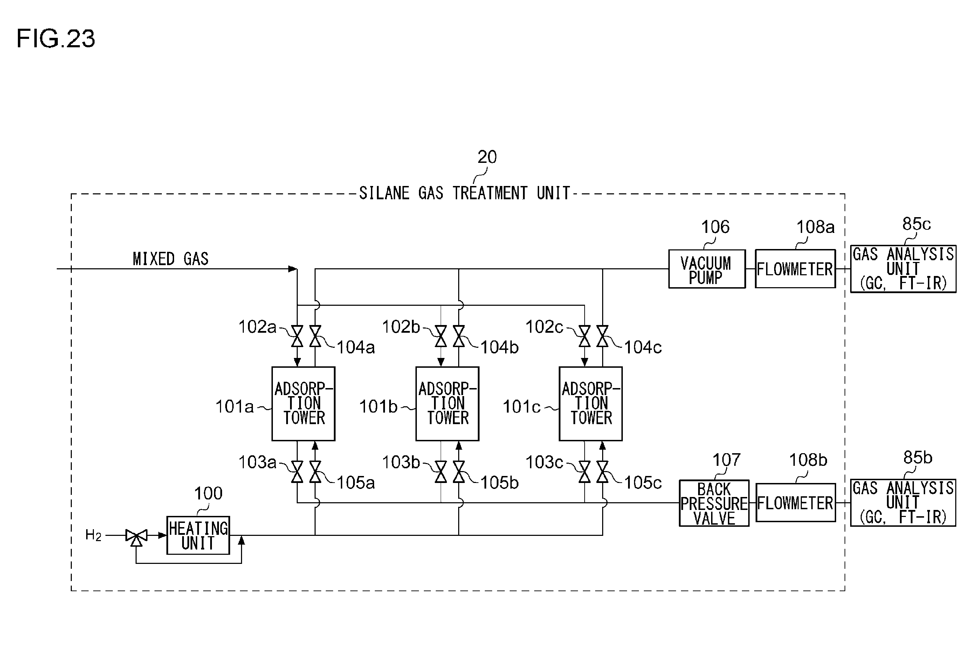

In order to recycle monosilane gas, various kinds of mixed gases in the exemplary embodiments 3-1 to 3-6 and the comparative examples 3-1 to 3-6 analyzed by the gas analysis unit 85a are supplied to the adsorption tower 101a (with activated carbon filled as adsorbent) of the silane gas treatment unit 20 employing an adsorption separation method as shown in FIG. 23. The pressure of the adsorption tower 101a is controlled at 0.3 MPaG by the back pressure valve 107. Before the start of operation, each of the adsorption towers 101 a to 101 c is heated to 200°C and the pretreatment is carried out for four hours while hydrogen is delivered at a rate of 10 NL/min. Then it is cooled down to a room temperature and is then controlled at a predetermined adsorption temperature (e.g., 30°C).

After the operation for one hour, the adsorption tower 101a closes the adsorption switching valves 102a and 103a and opens the adsorption switching valves 102b and 103b. Thereby, the operation is switched to the adsorption tower 101 b so as to continue the operation. Simultaneously, the desorption switching valve 104a is opened and the pressure is reduced to -0.09 MPaG by the vacuum pump 106 over a period of one hour. As a result, components adsorbed to the adsorption tower 101 a are removed. After the operation for one hour, the adsorption tower 101b closes the adsorption switching valves 102b and 103b and opens the adsorption switching valves 102c and 103c. Thereby, the operation is switched to the adsorption tower 101 c so as to continue the operation. Simultaneously, the desorption switching valve 104a is closed and the same valve 104 is opened, and the pressure is reduced to -0.09 MPaG by the vacuum pump 106 over a period of one hour. A cycle of three hours so far is now defined as one cycle. Now the adsorption tower in operation is returned from the adsorption tower 101 c to the adsorption tower 101 a and the adsorption tower for which the desorption is to be done is shifted from the adsorption tower 101 b to the adsorption tower 101 c. Then experiments from a second cycle and onward are conducted. The mixed gas containing large amounts of hydrogen and argon, which are separated by the silane gas treatment unit 20 and then sent to the gas analysis unit 85b, is sent to the noble gas treatment unit 30. The temperature of the gas is adjusted at 30°C by the temperature regulator 90 of the noble gas treatment unit 30 before the gas is introduced into the membrane separation module 91 (polyimide hollow fiber membrane with a volume of 0.6 L). Note that, in the exemplary embodiments 3-5 and 3-6 and the comparative examples 3-5 and 3-6, the experiments are conducted using the membrane separation module of 1.5 L in volume. The vacuum pump 93 is connected at a permeation side of the membrane separation module 91, and the permeation-side pressure of the membrane separation module 91 is adjusted to -0.1 MPaG at a permeation-side back pressure valve 92a. The non-permeation-side pressure of the membrane separation module 91 is controlled to 0.1 MPaG at a non-permeation-side back pressure valve 92b. The flow rate and the composition of a gas on the non-permeation side are measured by the flowmeter 94b and the GC (gas chromatogram) and FT-IR in the gas analysis unit 85e. The results analyzed by the gas analysis unit 85e are gathered in Table 15.

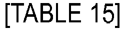

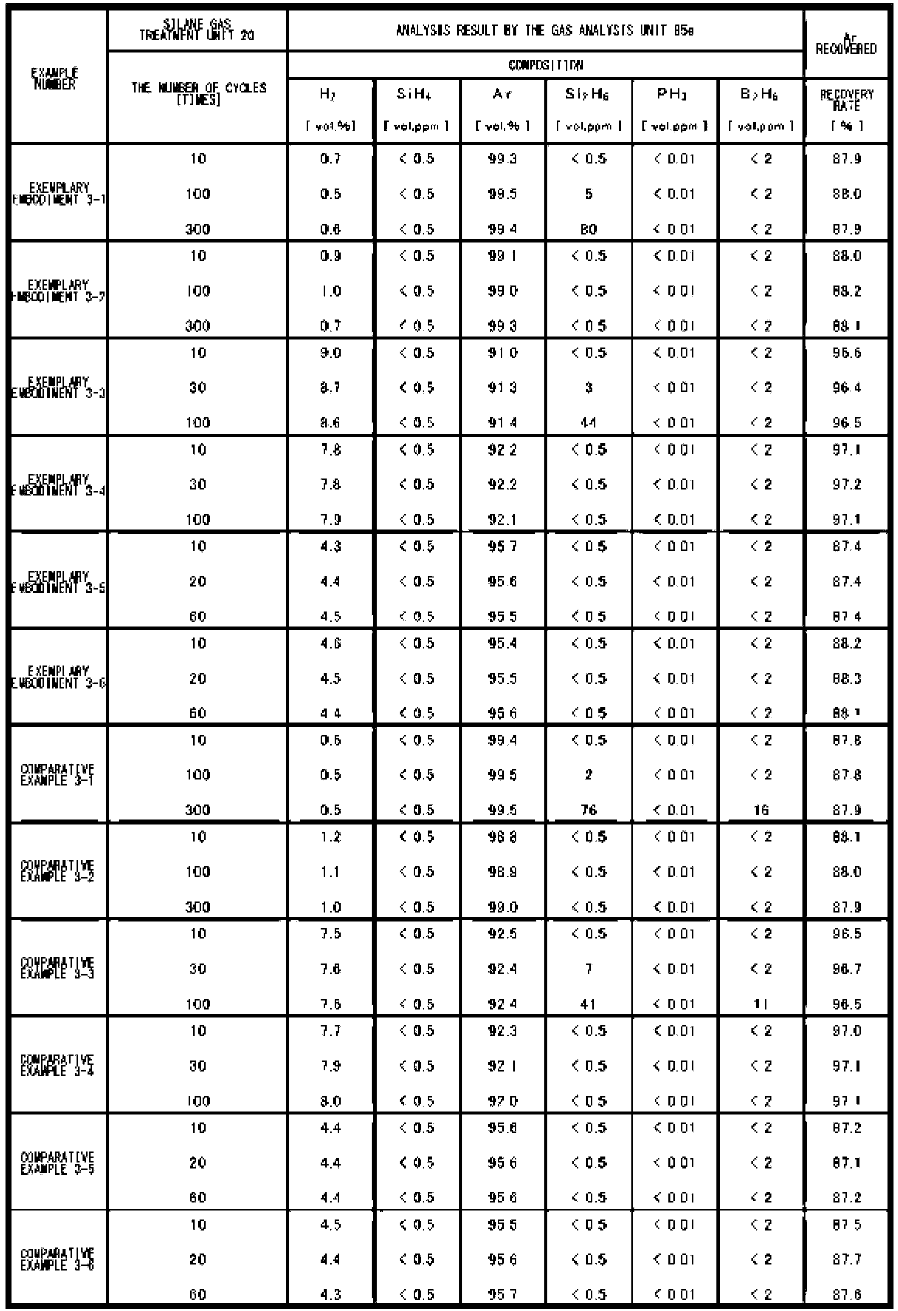

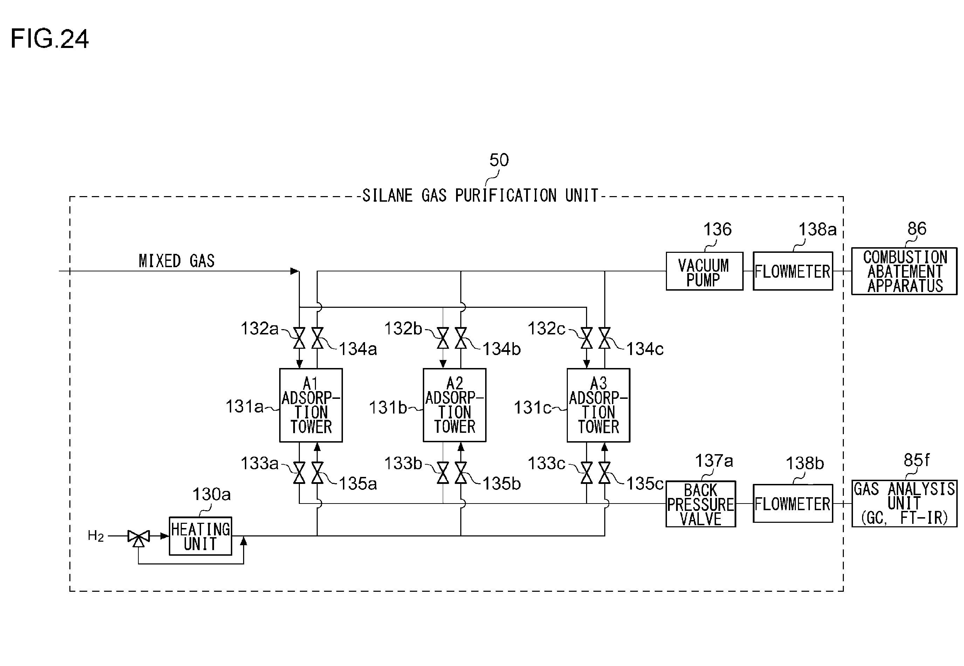

The pressure of the mixed gas discharged by the vacuum pump 106 of the silane gas treatment unit 20 is boosted by a compression unit 300b through an operation similar to that of the compression unit 300a. Then the temperature of the mixed gas is adjusted at 30°C by the after-cooler 362 so as to be accumulated in the pressurized tank 83b (capacity: 1 m³). The flow rate of the mixed gas accumulated by the pressurized tank 83b is controlled at a constant of 2.0 NL/min by the mass flow controller 84b and is supplied to the silane gas purification unit 50. In the exemplary embodiments 3-1 and 3-2, the constant value is 2.0 NL/min. In the exemplary embodiments 3-3 and 3-4, the constant value is 2.5 NL/min. In the exemplary embodiments 3-5 and 3-6, the constant value is 0.5 NL/min. FIG. 24 schematically shows a specific structure of the silane gas purification unit 50. The mixed gas is introduced into the A1 adsorption tower 131a of the silane gas purification unit 50 (with H-substituted mordenite-type zeolite filled, as adsorbent, with a volume of 5.0 L). The pressure of the A1 adsorption tower 131 a is controlled at 0.3 MPaG by the back pressure valve 137a. The flow rate and the composition of a gas that has passed through without being desorbed are measured by the flowmeter 138b and the gas analysis unit 85f. Before the start of operation, each of the A1 to A3 adsorption towers (131 a to 131 c) is heated to 200°C and the pretreatment is carried out for four hours while hydrogen is delivered at a rate of 10 NL/min. Then it is cooled down to a room temperature and is then controlled at a predetermined adsorption temperature (e.g., 30°C). After the operation for one hour, the A1 adsorption tower 131 a closes the adsorption switching valves 132a and 133a and opens the adsorption switching valves 132b and 133b. Thereby, the operation is switched to the A2 adsorption tower 131 b so as to continue the operation. Simultaneously, the desorption switching valves 134a and 135a are opened, the pressure is reduced to -0.09 MPaG by the vacuum pump 136, and the adsorbed material is desorbed for one hour while hydrogen is delivered at a rate of 10 NL/min. As a result, components adsorbed to the A1 adsorption tower 131 a are removed. Further, after the operation for one hour, the A2 adsorption tower 131 b closes the adsorption switching valves 132b and 133b and opens the adsorption switching valves 132c and 133c. Thereby, the operation is switched to the A3 adsorption tower 131c so as to continue the operation. Simultaneously, the adsorption switching valves 134b and 135b are opened, the pressure is reduced to -0.09 MPaG by the vacuum pump 136, and the adsorbed material is desorbed for one hour while hydrogen is delivered at a rate of 10 NL/min. As a result, components adsorbed to the A2 adsorption tower 131b are removed. Furthermore, after the operation for one hour, the A3 adsorption tower 131c closes the adsorption switching valves 132c and 133c and opens the adsorption switching valves 132a and 133a. Thereby, the operation is switched to the A-1 adsorption tower 131a so as to start another cycle. Simultaneously, the adsorption switching valves 134c and 135c are opened, and shifting to a desorption process for the A3 adsorption tower 131 c is prepared. A cycle of three hours so far is now defined as one cycle and the experiments for a plurality of cycles are conducted. After the flow rate of desorbed gas is measured by the flowmeter 138a, the desorbed gas is detoxified or abated by the combustion abatement apparatus 86 and then released to atmosphere. The constituent concentrations detected by the gas analysis unit 85f are gathered in Table 16.

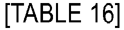

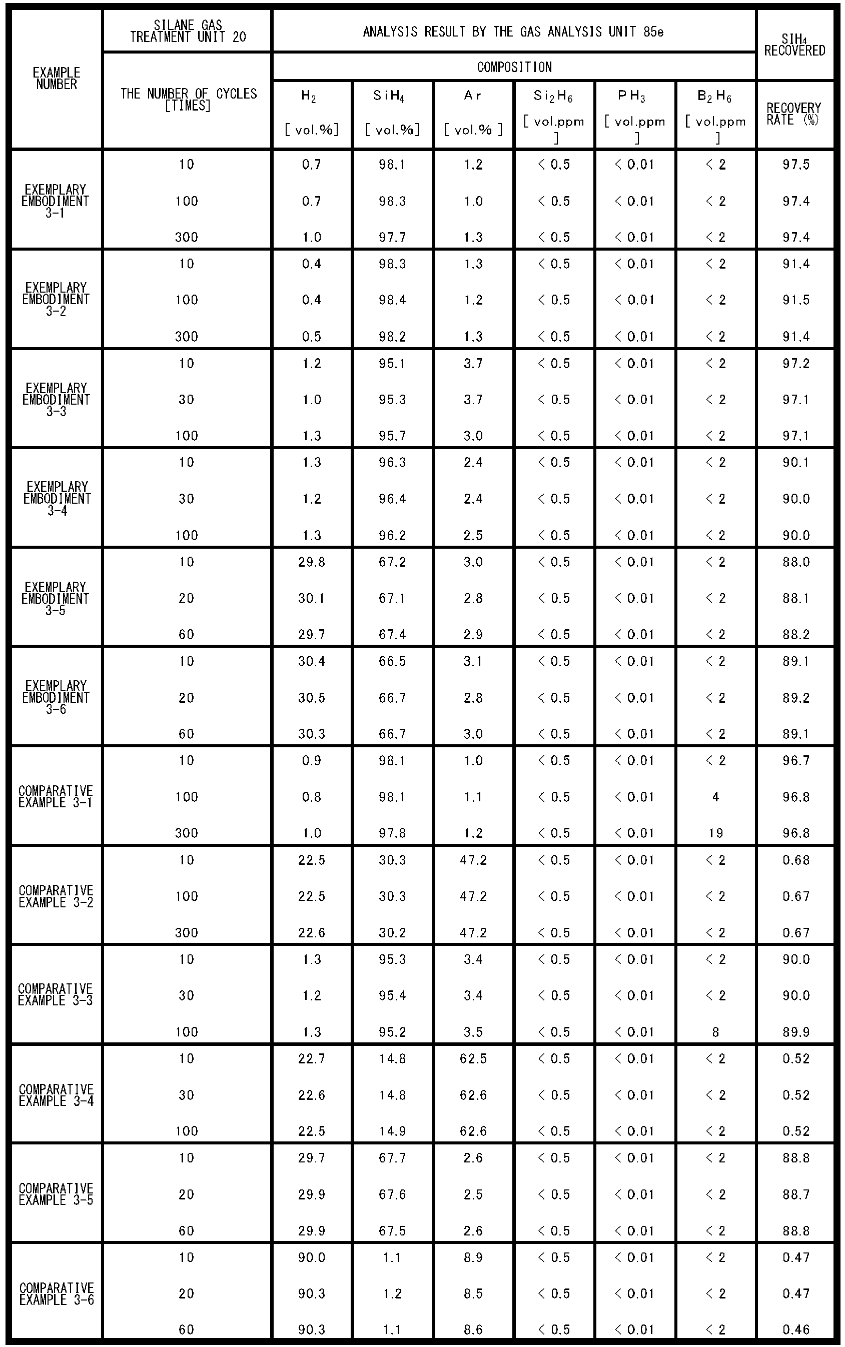

From the above results, it is evident that since the compressors inside the gas compression unit are operated by controlling the temperature of secondary outburst gas in a range of 100 to 200°C, a hydrogenated impurity gas (e.g., diborane and disilane) excluding monosilane can be efficiently decomposed and therefore monosilane can be recovered with a high recovery rate. Also, the hydrogen/argon mixed gas, which has been separated by the monosilane treatment unit, is made to pass through the noble gas treatment unit, so that high-purity argon can be recovered with a high recovery rate.

### (Fourth Embodiment)

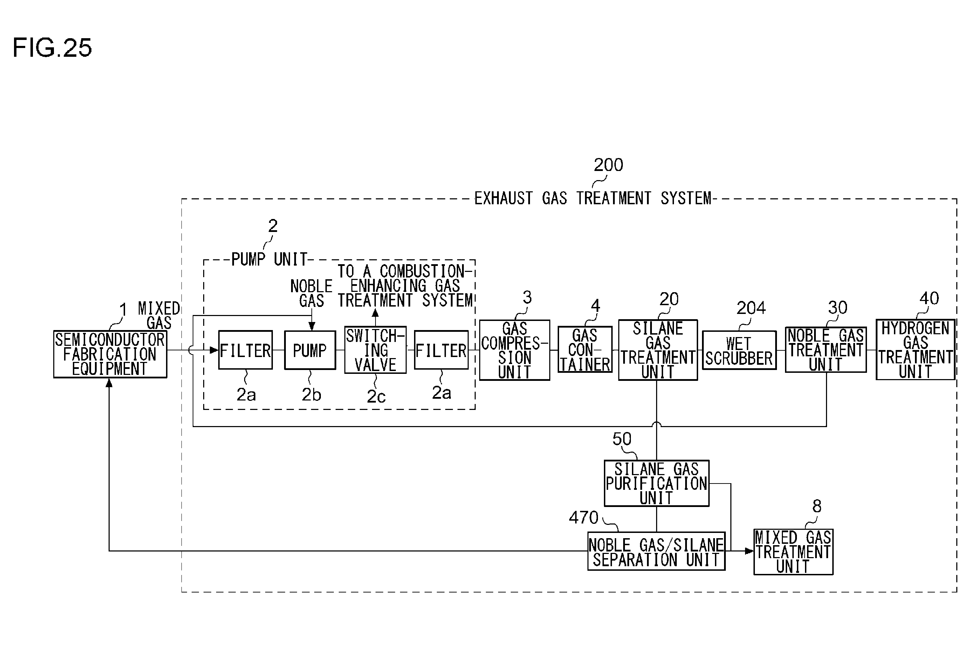

FIG. 25 is a system diagram showing an exemplary overview of an exhaust gas treatment system according to a fourth embodiment. As shown in FIG. 25, the exhaust gas treatment system 200 according to the fourth embodiment includes a gas compression unit 3 for compressing a mixed gas, containing at least monosilane, hydrogen and argon, discharged from a semiconductor fabrication equipment 1 via a pump unit 2, a gas container 4 for accumulating the compressed mixed gas, a silane gas treatment unit 20 for separating monosilane in the mixed gas delivered from the gas container 4 to the subsequent stages at a constant flow rate, a wet scrubber 204 for removing hydrides (e.g., SiH₄, PH₃, B₂H₆, SiH₆) in the mixed gas mainly containing a high proportion of hydrogen and argon separated by the silane gas treatment unit 20, a noble gas treatment unit 30 for separating and recovering argon from the mixed gas containing a high proportion of argon discharged from the wet scrubber 204 so as to be recycled, a silane gas purification unit 50 for removing hydrides, excluding monosilane, in the mixed gas containing a high proportion of monosilane separated by the silane gas treatment unit 20, and a noble gas/silane separation unit 470 for separating and removing a gas, mainly composed of argon, excluding monosilane, in the mixed gas containing a high proportion of monosilane that has been passed through the silane purification unit 50.

Note that the structures of the gas compression unit 3, the gas container 4, the silane gas treatment unit 20, the wet scrubber 204, and the noble gas treatment unit 30 are similar to those of the first to third embodiments.

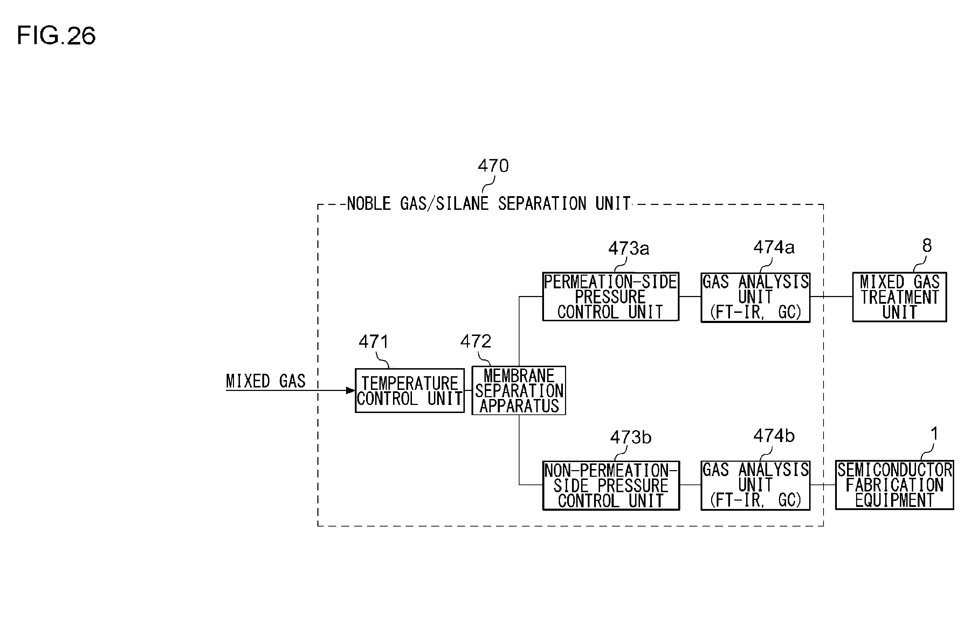

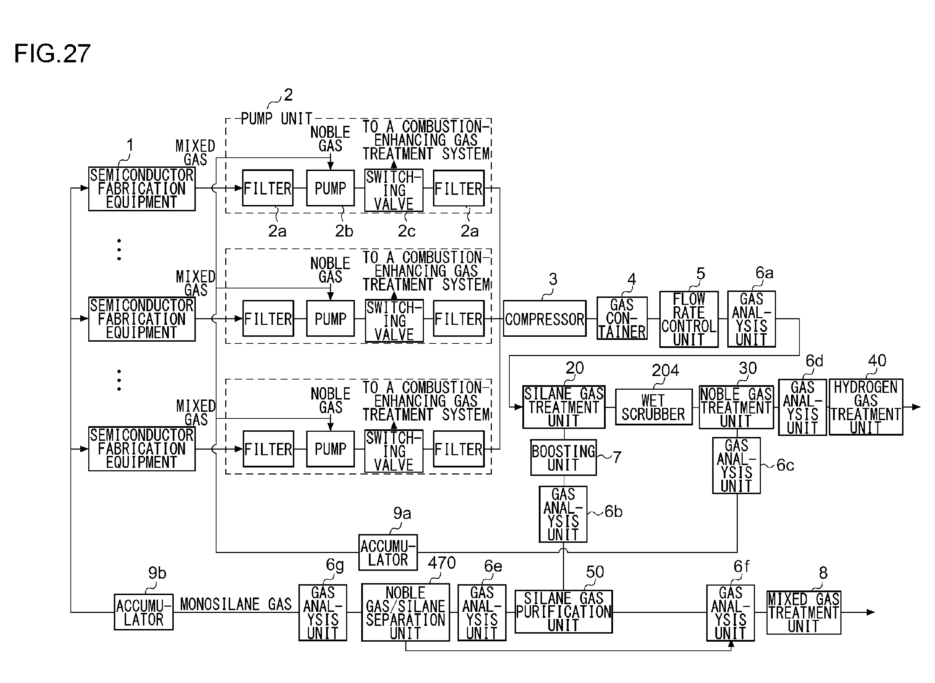

FIG. 26 schematically shows a specific structure of the noble gas/silane separation unit 470. As shown in FIG. 27, the noble gas/silane separation unit 470 includes a membrane separation apparatus 472, a permeation-side pressure control unit 473a and/or a non-permeation-side pressure control unit 473b. The membrane separation apparatus 472 is not limited to any particular one as long as it is a membrane through which gas other than monosilane is selectively permeated but it may be one of various semipermeable membranes, for instance. The semipermeable membrane includes, for example, a dense layer through which hydrogen is selectively permeated and a porous base material that supports a dense layer. The shape of the semipermeable membrane may be of a flat membrane, a spiral membrane, and a hollow fiber membrane, for instance. Among these shapes, the hollow fiber membrane is more preferable.

The material used for the dense layer may be polyimide, polysiloxane, polysilazane, acrylonitrile, polyester, cellulose polymer, polysulfone, polyalkylene glycol, polyethylene, polybutadiene, polystyrene, polyvinylhalide, polyvinylidene halide, polycarbonate, and block copolymers having repeating units of any of the preceding components, for instance.

The material used for the base material may be an inorganic material such as glass, ceramic, and sintered metal and a porous organic material, for instance. The porous organic material as used herein may be polyether, polyacrylonitrile, polyether, poly (arylene oxide), polyether ketone, polysulfide, polyethylene, polypropylene, polybutene, polyvinyl, and the like.

The flow rate, the pressure, and the temperature of the mixed gas supplied to the membrane separation apparatus 472 are not particularly limited. Also, the concentration of argon gas in the mixed gas, the non-permeation-side pressure and the permeation-side pressure of the membrane separation apparatus 472 are not particularly limited. For example, the flow rate may be 5 NL/min to 500 NL/min relative to the capacity of 1 L of the membrane separation apparatus 472, and may preferably be 10 NL/min to 100 NL/min. The pressure may preferably be -90 kPaG to 1.0 MPaG. The temperature may preferably be about -20°C to 100°C. The non-permeation-side pressure of the membrane separation apparatus 472 may preferably be -90 kPaG to 1.0 MPaG. The permeation-side pressure may preferably be -100 kPaG to 0.9 MPaG.

When the membrane separation unit is operated at a temperature, other than a room temperature, which serves as the temperature of the mixed gas supplied to the membrane separation apparatus 472, a temperature control unit 471 as shown in FIG.26 needs to be installed.

The temperature control unit 471 is not particularly limited as long as it has a function of cooling or heating the mixed gas and it may be an electric heater, various heat exchangers, or the like, for instance. The mixed gas that has been cooled or heated by the temperature control unit 471 is supplied to the membrane separation apparatus 472.

A gas mainly composed of moisture vapor and noble gas, excluding monosilane, separated by the membrane separation apparatus 472 is sent to the mixed gas treatment unit 8, whereas high-concentration monosilane is sent to the semiconductor fabrication equipment 1. In so doing, the mixed gas other than monosilane may be analyzed by a gas analysis unit 416a, so that the analysis result can be made use of in the setting of operating conditions. Also, the high-concentration monosilane may be analyzed by a gas analysis 416b, so that whether or not the high-concentration monosilane is to be recycled into the semiconductor fabrication equipment 1 can be determined.

The noble gas/silane separation unit 470 is not limited to the membrane separation means and the adsorption-separation means alone as long as the mixed gas can be separated into monosilane and other components excluding monosilane. For example, the noble gas/monosilane separation unit 470 as used herein may be an adsorption-separation means using adsorbents or a cryogenic separation means where the mixed gas is separated through distillation or partial condensation utilizing the difference in temperature when the mixed gas is cooled to a low temperature so as to be liquefied and condensed.

In the exhaust gas treatment system according to the present embodiment, other various supplemental facilities as shown in FIG. 27 may be additionally provided.

The exhaust gas treatment system as illustrated in FIG. 27 is a system capable of processing the exhaust gas from a plurality of semiconductor fabrication equipment.

A flow rate control unit 5 controls the flow rate and the pressure of the mixed gas gathered in the gas container 4 so that the flow rate and the pressure thereof are constant. Though not particularly limited, a method for controlling the flow rate and the pressure thereof may preferably be one that is not affected by a change in the pressure of the mixed gas supplied to the flow rate control unit 5. Such a method may be one using a mass flow controller, for instance. Also, as for the pressure, a necessary pressure can be ensured by selecting an operating condition of the gas compression unit 3.

A boosting unit 7 is used to introduce a gas composed mainly of monosilane separated by the silane gas treatment unit 20 into the silane gas purification unit 50 described later and is used to boost the pressure up to a certain pressure level in order to circulate monosilane in the semiconductor fabrication equipment 1. The boosting unit 7 as used herein is not particularly limited insofar as it attains the aforementioned purpose and may preferably be one having the same features and requisites as that of the above-described gas compression unit 3.

The mixed gas treatment unit 8 is an apparatus for detoxifying or abating monosilane, phosphine, diborane, disilane and the like, which are toxic gases. Also, the mixed gas treatment 8 is provided with a structure in which such toxic gases are diluted with noble gas to a predetermined concentration level and are then introduced into an detoxification unit or abatement unit where such gasses as monosilane, phosphine, diborane and disilane are detoxified or abated to an allowable concentration level or below and then released outside.

Gas analysis units 6a to 6g may be provided to measure the component of gas communicated to the silane gas treatment unit 20 from the flow rate control unit 5 as well as the component concentration of high-concentration monosilane gas and high-concentration argon separated by and discharged from the silane gas purification unit 50 and the noble gas treatment unit 30. A method for the measurement employed by the gas analysis units 6a to 6g is not particularly limited as long as at least the concentration of monosilane and the concentration of argon in the mixed gas can be measured. For example, such a method may be one using an FT-IR with a gas circulation type sample cell, an on-line type gas chromatograph, or the like.

If the concentration of argon and the concentration of monosilane measured by the gas analysis units 6g and 6c are less than predetermined concentration levels, a mechanism may be provided supplementarily where argon and monosilane are sent to the monosilane detoxification unit (not shown) and a noble gas exhaust unit (not shown), without being circulated in the semiconductor fabrication equipment 1 and the bump unit 2, respectively, so that they can be treated safely and appropriately.

The accumulators 9a and 9b have argon and monsilane, recovered by the noble gas treatment unit 30 and the silane gas purification unit 50, circulated in the pump unit 2 and the semiconductor fabrication equipment 1 at constant pressure. The accumulators 9a and 9b as used herein are not particularly limited insofar as they attain the aforementioned purpose. And the pressure to be accumulated in the accumulators 9a and 9b must be lower than the pressure of gas supplied to the accumulators 9a and 9b and higher than the pressure with which the differential pressure of a flow rate control apparatus of the semiconductor fabrication equipment 1 can be obtained. If no such a range of pressures can be obtained, a boosting apparatus (not shown) will be preferably provided at a stage prior to the accumulators in order to raise the supply pressure to the accumulators 9a and 9b. The boosting apparatus as used herein may preferably be one further having the same features and requisites as those of the above-described gas compression unit 3. The pressure to be accumulated in the accumulators 9a and 9b is not limited to a particular value insofar as it serves the aforementioned purpose and may preferably be 0.05 MPaG to 10 MPaG or more preferably 0.1 MPaG to 0.5 MPaG.

A detailed description is given hereunder of the present embodiment based on exemplary embodiments or examples but the present embodiment is not limited to these exemplary embodiments only.

### (Exemplary embodiment 4-1)

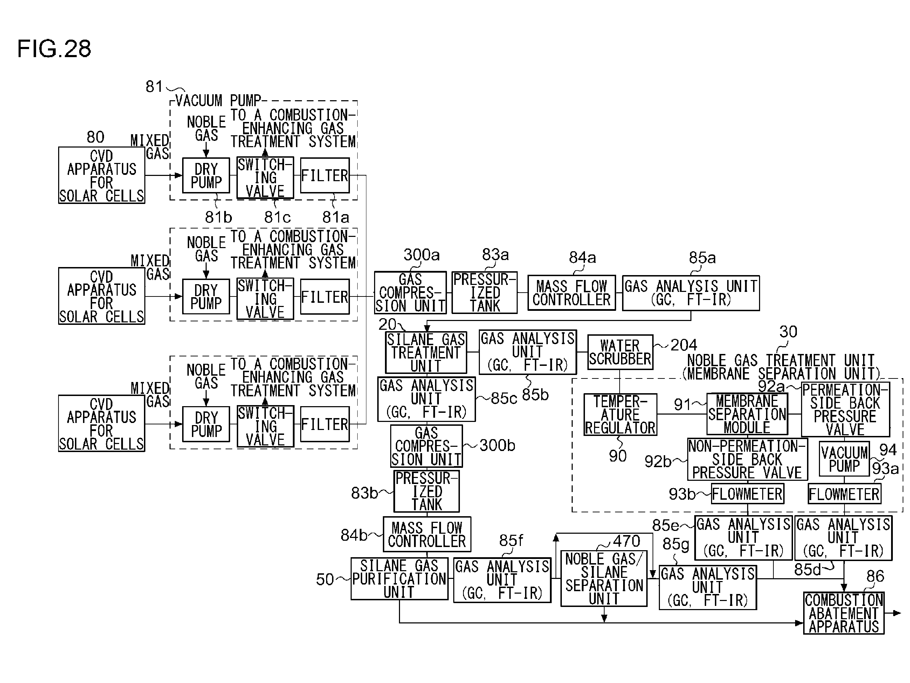

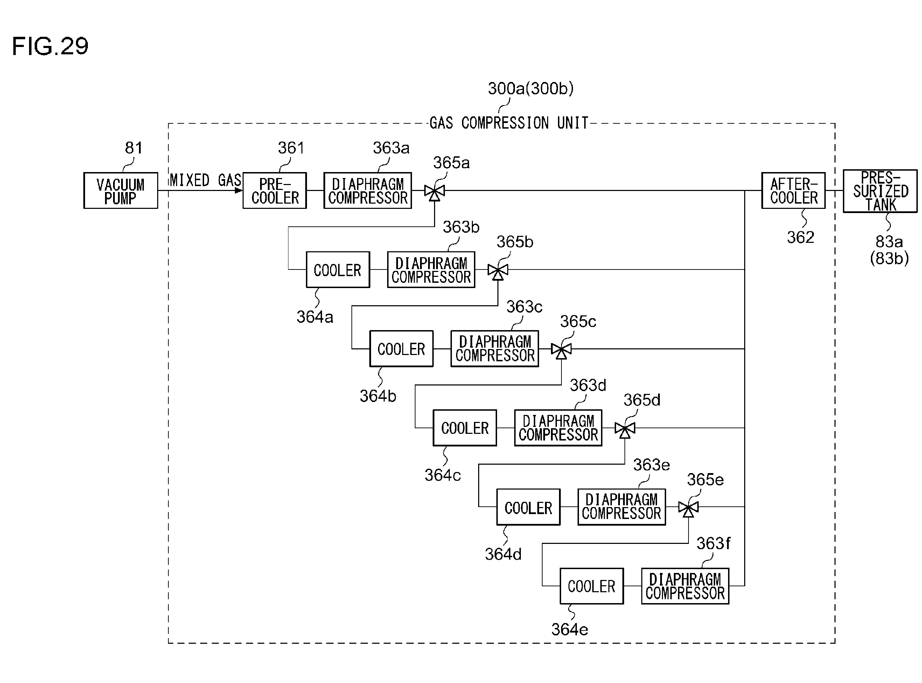

FIG. 28 is a system diagram showing a structure of an exhaust gas treatment system according to exemplary embodiment 4-1. As shown in FIG. 28, the exhaust gas treatment system according to the above-described fourth embodiment is connected to three CVD apparatuses 80 for thin-film silicon solar cells. Here, the thin-film silicon solar cell CVD apparatus 80 is a semiconductor fabrication equipment 1. The exhaust gas treatment system suctions the mixed gas, discharged from a plurality of thin-film silicon solar cell CVD apparatuses 80, together with purge gases introduced into dry pumps 81 b, by the dry pumps 81 b corresponding respectively to the thin-film silicon solar cell CVD apparatuses 80. Then the exhaust gas treatment system delivers the mixed gas and the purge gases toward a gas compression 300a unit via a filter 81a. Note that a switching valve 81c is provided after the dry pump 81b. With this configuration, the operation mode is switched to the combustion-enhancing gas treatment system when exhaust gas comes out as a result of the chemical cleaning, thereby preventing such exhaust gas from being mixed into a treatment line of a silane-based gas. In order that n-type membranes are produced by one of the three thin-film silicon solar cell CVD apparatus 80 and p-type type membranes are produced by another one thereof, PH₃ and B₂H₆ are introduced thereinto, respectively. FIG. 29 shows a structure of the gas compression unit 300a. The gas compression unit 300a, which includes therein six diaphragm compressors and seven heat-exchange type coolers, is configured such that the first to sixth diaphragm compressors can be arranged in series with each other and operated in variable manners by switching on the three-way valves. In the exemplary embodiment 4-1, the temperature of the mixed gas delivered from the vacuum pump is adjusted at 30°C by a pre-cooler 361 provided within the gas compression unit 300a. A diaphragm compressor 363a provided subsequent to the pre-cooler 361 is run by adjusting the exhaust gas temperature at 100°C. A three-way valve 365a is controlled such that the diaphragm compressor 363a communicates with a cooler 364a, and the mixed gas is now fed to a diaphragm compressor 363b. The diaphragm compressor 363b is operated similarly to the diaphragm compressor 363a. A three-way valve 365b is controlled such that the diaphragm compressor 363b communicates with an after-cooler 362. And the temperature of the gas having been compressed in two stages is adjusted at 30°C by the after-cooler 362 and is accumulated in the pressurized tank 83a (capacity: 1 m³). When the pressure of gas is to be accumulated, the purge gas is delivered to each dry pump 81b at the flow rate of 10 NL/min while the outlet valve (not shown) of the pressurized tank 83a is closed. Then the outlet valve of the pressurized tank 83a is opened and the supply of gas to a mass flow controller 84a starts. Also, the respective thin-film silicon solar cell CVD apparatuses 80 start their operations such that the start of operation of each of the three thin-film silicon solar cell CVD apparatuses 80 lags each other by four minutes. The gas flow rate of the mixed gas sent to the mass flow controller 84a is controlled at 20 NL/min and then sent to a subsequent gas analysis unit 85a where the composition of the gas is analyzed. The operating conditions of the gas compression unit 300a and the flow rates and compositions of the gas analyzed by the gas analysis unit 85a are gathered in Table 17. The gas analysis unit 85a measures the composition of the gas using GC (gas chromatogram) and FT-IR.

**[TABLE 17]**

| EXAMPLE NUMBER | OPERATING CONDITION OF THE GAS COMPRESSION UNIT 60a | | | ANALYSIS RESULT BY THE GAS ANALYSIS UNIT 85a | | | | | | |
|---|---|---|---|---|---|---|---|---|---|---|
| | THE NUMBER OF COMPRESSION STEPS [STEPS] | SECONDARY GAS TEMPERATURE [°C] | SECONDARY GAS PRESSURE [MPaG] | GAS FLOW RATE [NL/min] | COMPOSITION | | | | | |
| | | | | | H₂ [vol.% ] | SiH₄ [vol.% ] | Ar [vol.% ] | Si₂H₆ [vol.ppm] | PH₃ [vol.ppm] | B₂H₆ [vol.ppm] |
| EXEMPLARY EMBODIMENT 4-1 | 2 | 100 | 0.30 | 20 | 40.0 | 9.91 | 49.9 | 913 | 100 | < 2 |
| EXEMPLARY EMBODIMENT 4-2 | 4 | 70 | 0.31 | 20 | 40.0 | 9.92 | 49.9 | 941 | 100 | 22 |
| EXEMPLARY EMBODIMENT 4-3 | 2 | 100 | 0.30 | 50 | 25.0 | 4.95 | 70.0 | 456 | 50 | < 2 |
| EXEMPLARY EMBODIMENT 4-4 | 4 | 70 | 0.31 | 50 | 25.0 | 4.96 | 70.0 | 470 | 50 | 9 |
| EXEMPLARY EMBODIMENT 4-5 | 2 | 100 | 0.30 | 100 | 89.9 | 0.10 | 10.0 | 9 | 1 | < 2 |
| EXEMPLARY EMBODIMENT 4-6 | 4 | 70 | 0.31 | 100 | 89.9 | 0.10 | 10.0 | 9 | 1 | < 2 |

### (Exemplary embodiment 4-2)

The exhaust gas treatment system is operated under the same conditions as those of the exemplary embodiment 4-1 excepting that the secondary gas temperature, when the mixed gas is compressed by the diaphragm compressor 363a, is adjusted at 70°C and excepting that the temperature of the compressed mixed gas is adjusted at 35°C by the pre-cooler 361 and coolers 364 and the compressor is operated in four stages. The operating conditions of the gas compression unit 300a and the flow rates and compositions of the gas analyzed by the gas analysis unit 85a are gathered in Table 17.

### (Exemplary embodiments 4-3- 4-6)

The exhaust gas treatment system is operated under the same conditions as those of the exemplary embodiments 4-1 and 4-2 excepting the flow rate of the mass flow controller 84a and the gas composition. The operating conditions of the gas compression unit 300a and the flow rates and compositions of the gas analyzed by the gas analysis unit 85a are gathered in Table 13.

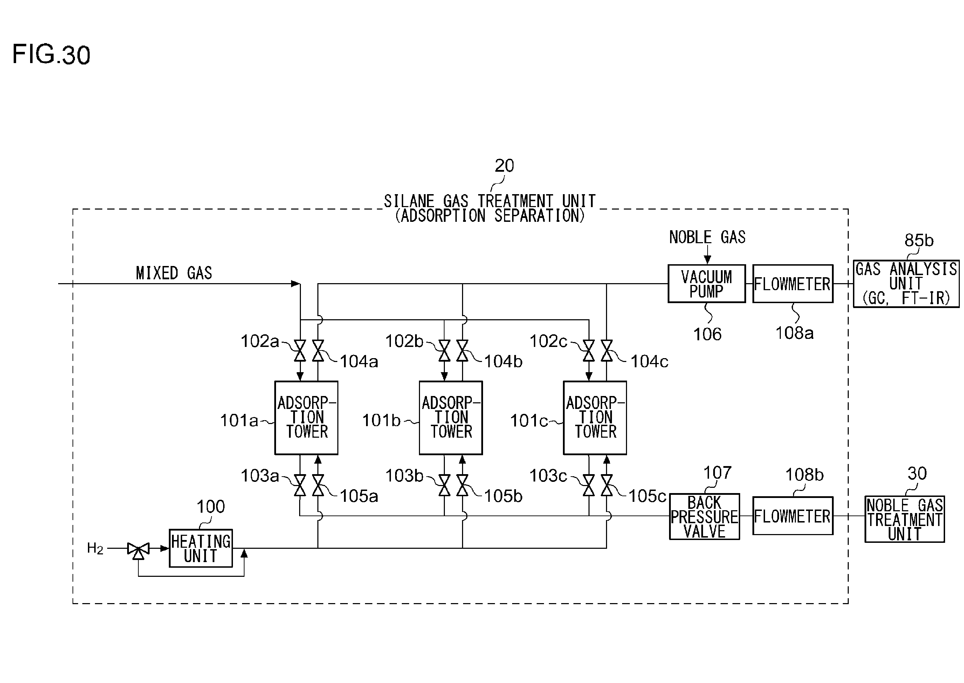

In order to recycle monosilane gas, various kinds of mixed gases in the exemplary embodiments 4-1 to 4-6 analyzed by the gas analysis unit 85a are supplied to the adsorption tower 101 a (with activated carbon filled as adsorbent) of the silane gas treatment unit 20 employing an adsorption separation method as shown in FIG. 30. The pressure of the adsorption tower 101 a is controlled at 0.3 MPaG by the back pressure valve 107. Before the start of operation, each of the adsorption towers 101 a to 101c is heated to 200°C and the pretreatment is carried out for four hours while hydrogen is delivered at a rate of 10 NL/min. Then it is cooled down to a room temperature and is then controlled at a predetermined adsorption temperature (e.g., 30°C).

After the operation for one hour, the adsorption tower 101 a closes the adsorption switching valves 102a and 103a and opens the adsorption switching valves 102b and 103b. Thereby, the operation is switched to the adsorption tower 101 b so as to continue the operation. Simultaneously, the desorption switching valve 104a is opened and the pressure is reduced to -0.09 MPaG by the vacuum pump 106 over a period of one hour. As a result, components adsorbed to the adsorption tower 101 a are desorbed. After the operation for one hour, the adsorption tower 101 b closes the adsorption switching valves 102b and 103b and opens the adsorption switching valves 102c and 103c. Thereby, the operation is switched to the adsorption tower 101c so as to continue the operation. Simultaneously, the desorption switching valve 104a is closed and the same valve 104 is opened and the pressure is reduced to -0.09 MPaG by the vacuum pump 106 over a period of one hour. A cycle of three hours so far is now defined as one cycle. Now the adsorption tower in operation is returned from the adsorption tower 101c to the adsorption tower 101 a and the adsorption tower for which the desorption is to be done is shifted from the adsorption tower 101 b to the adsorption tower 101 c. Then experiments from a second cycle and onward are conducted. The mixed gas containing large amounts of hydrogen and argon, which are separated by the silane gas treatment unit 20 and then sent to the gas analysis unit 85b, passes through the water scrubber so as to remove the hydrides in the mixed gas. And the mixed gas where the hydrides have been removed by the water scrubber is now sent to the noble gas treatment unit 30. The temperature of the gas is adjusted at 30°C by the temperature regulator 90 of the noble gas treatment unit 30 before the gas is introduced into the membrane separation module 91 (polyimide hollow fiber membrane with a volume of 0.6 L). A vacuum pump 94 is connected at a permeation side of the membrane separation module 91, and the permeation-side pressure of the membrane separation module 91 is adjusted to -0.1 MPaG at a permeation-side back pressure valve 92a. The non-permeation-side pressure of the membrane separation module 91 is controlled to 0.1 MPaG at a non-permeation-side back pressure valve 92b. The flow rate and the composition of a gas on the non-permeation side are measured by a flowmeter 93b and GC (gas chromatogram) and FT-IR in the gas analysis unit 85e. The results analyzed by the gas analysis unit 85e are gathered in Table 18.

**[TABLE 18]**

| EXAMPLE NUMBER | SILANE TREATMENT GAS UNIT 20 | ANALYSIS RESULT BY THE GAS ANALYSIS UNIT 85e | | | | | | Ar RECOVERED |
|---|---|---|---|---|---|---|---|---|
| | THE NUMBER OF CYCLES [TIMES] CYCLES [TIMES] | COMPOSITION | | | | | | |
| | | H₂ [vol.%] | SiH₄ vol.ppm] | Ar [vol.%] | Si₂H₆) [vol.ppm] | PH₃ [vol.ppm ] | B₂H₆ [vol.ppm ] | RECOVERY RATE [%] |
| EXEMPLARY EMBODIMENT 4-1 | 10 | 0.7 | < 0.5 | 99.3 | < 0.5 | < 0.01 | < 2 | 87.9 |
| | 100 | 0.5 | < 0.5 | 99.5 | < 0.5 | < 0.01 | < 2 | 88.0 |
| | 300 | 0.6 | < 0.5 | 99.4 | < 0.5 | < 0.01 | < 2 | 87.9 |
| EXEMPLARY EMBODIMENT | 10 | 0.9 | < 0.5 | 99.1 | < 0.5 | < 0.01 | < 2 | 88.3 |
| | 100 | 1.0 | < 0.5 | 99.0 | < 0.5 | < 0,01 | < 2 | 88.4 |
| | 300 | 0.7 | < 0.5 | 99.3 | < 0.5 | < 0.01 | < 2 | 88.5 |
| EXEMPLARY EMBODIMENT 4-3 | 10 | 9.0 | < 0.5 | 91.0 | < 0.5 | < 0.01 | < 2 | 96.6 |
| | 30 | 8.7 | < 0.5 | 91.3 | < 0.5 | < 0.01 | < 2 | 96.4 |
| | 100 | 8.6 | < 0.5 | 91.4 | < 0.5 | < 0.01 | < 2 | 96.5 |
| EXEMPLARY EMBODIMENT 4-4 | 10 | 7.8 | < 0.5 | 92.2 | <0.5 | < 0.01 | < 2 | 97.6 |
| | 30 | 7.8 | < 0.5 | 92.2 | < 0.5 | < 0.01 | < 2 | 97.8 |
| | 100 | 7.9 | < 0.5 | 92.1 | < 0.5 | <0.01 | < 2 | 97.6 |
| EXEMPLARY EMBODIMENT 4-5 | 10 | 4.3 | < 0.5 | 95.7 | < 0.5 | < 0.01 | < 2 | 87.4 |
| | 20 | 4.4 | < 0.5 | 95.6 | < 0.5 | < 0.01 | < 2 | 87.4 |
| | 60 | 4.5 | < 0.5 | 95.5 | < 0.5 | < 0.01 | < 2 | 87.4 |
| EXPEMPLARY EMBODIMENT 4-6 | 10 | 4.6 | < 0.5 | 95.4 | < 0.5 | < 0.01 | < 2 | 88.3 |
| | 20 | 4.5 | < 0.5 | 95.5 | < 0.5 | < 0.01 | < 2 | 88.6 |
| | 60 | 4.4 | < 0.5 | 95.6 | < 0.5 | < 0.01 | < 2 | 88.5 |

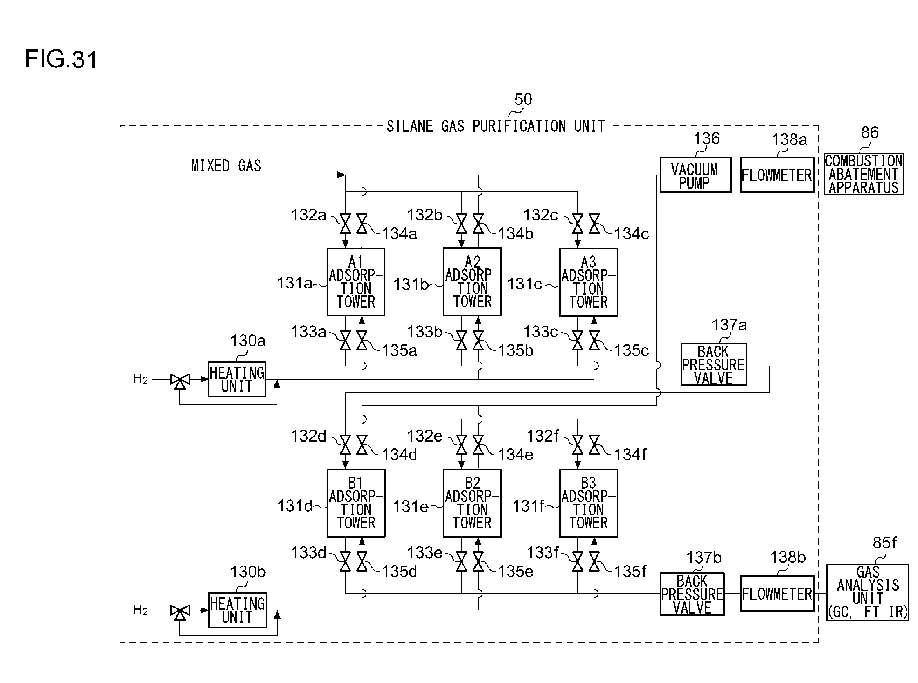

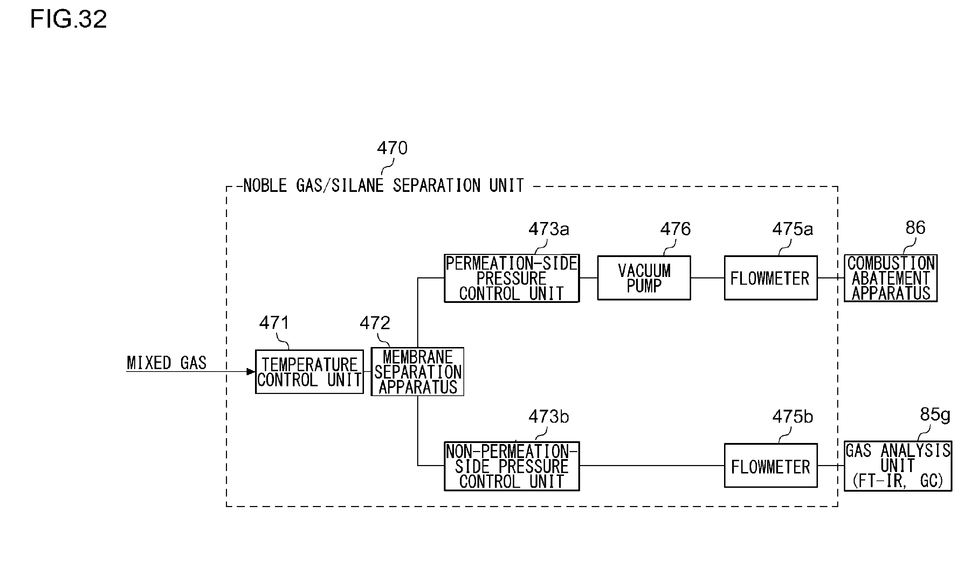

FIG. 31 schematically shows a specific structure of the gas purification unit 50 in the exhaust gas treatment system according to an exemplary embodiment. The pressure of the mixed gas discharged by the vacuum pump 106 of the silane gas treatment unit 20 (argon being supplied at 10 NL/min as the purge gas) is boosted to 0.6 MPaG by a compression unit 300b and the thus boosted mixed gas is accumulated in the pressurized tank 83b. Then the flow rate of the mixed gas accumulated in the pressurized tank 83b is controlled at a constant value by the mass flow controller 84b and is supplied to the silane gas purification unit 50. Thereby, the mixed gas is introduced into an A1 adsorption tower 131 a of the silane gas purification unit 50 (with H-substituted mordenite-type zeolite filled, as adsorbent, with a volume of 5.0 L) and then the mixed gas is introduced into a B1 adsorption tower 131d (with activated alumina filled, as adsorbent, with a volume of 4.3 L). In the exemplary embodiments 4-1 and 4-2, the constant value is 2.0 NL/min. In the exemplary embodiments 4-3 and 4-4, the constant value is 2.5 NL/min. In the exemplary embodiments 4-5 and 4-6, the constant value is 0.5 NL/min. The pressure of the A1 adsorption tower 131a is controlled at 0.5 MPaG by the back pressure valve 137a, and the pressure of the B1 adsorption tower 131d is controlled at 0.4 MPaG by a back pressure valve 137b. The flow rate and the composition of a gas that has passed through without being desorbed are measured by the flowmeter 138b and the gas analysis unit 85f. Before the start of operation, each of the A1 to A3 adsorption towers (131 a to 131 c) is heated to 200°C and the pretreatment is carried out for four hours while hydrogen is delivered at a rate of 10 NL/min. Then it is cooled down to a room temperature and is then controlled at a predetermined adsorption temperature (e.g., 50°C). Before the start of operation, each of B1 to B3 adsorption towers (131 d to 131f) undergoes the pretreatment for four hours at 30°C while hydrogen is delivered at a rate of 10 NL/min. After this, the temperature of each of the B1 to B3 adsorption towers (131d to 131f) is kept at 30°C. After the operation for one hour, the A1 adsorption tower 131 a closes the adsorption switching valves 132a and 133a and opens the adsorption switching valves 132b and 133b. Thereby, the operation is switched to the A2 adsorption tower 131b so as to continue the operation. Simultaneously, the desorption switching valves 134a and 135a are opened, the pressure is reduced to -0.09 MPaG by the vacuum pump 136, and the adsorbed material is desorbed for one hour while hydrogen is delivered at a rate of 10 NL/min. As a result, components adsorbed to the A1 adsorption tower 131a are removed. Further, after the operation for one hour, the A2 adsorption tower 131 b closes the adsorption switching valves 132b and 133b and opens the adsorption switching valves 132c and 133c. Thereby, the operation is switched to the A3 adsorption tower 131c so as to continue the operation. Simultaneously, the adsorption switching valves 134b and 135b are opened, the pressure is reduced to -0.09 MPaG by the vacuum pump 136, and the adsorbed material is desorbed for one hour while hydrogen is delivered at a rate of 10 NL/min. As a result, components adsorbed to the A2 adsorption tower 131b are removed. Furthermore, after the operation for one hour, the A3 adsorption tower 131 c closes the adsorption switching valves 132c and 133c and opens the adsorption switching valves 132a and 133a. Thereby, the operation is switched to the A-1 adsorption tower 131 a so as to start another cycle. Simultaneously, the adsorption switching valves 134c and 135c are opened, and shifting to a desorption process for the A3 adsorption tower 131c is prepared. A cycle of three hours so far is now defined as one cycle and the experiments for a plurality of cycles are conducted. After the flow rate of desorbed gas is measured by the flowmeter 138a, the desorbed gas is detoxified or abated by the combustion abatement apparatus 86 and then released to atmosphere. The mixed gas detected by the gas analysis unit 85f is sent to a noble gas/silane separation unit 470 shown in FIG. 32. The gas temperature is now adjusted at 30°C by a temperature control unit 471 before the gas is introduced into a membrane separation apparatus 472 (polyimide hollow fiber membrane with a volume of 5.1 L). A vacuum pump 476 is connected at a permeation side of the membrane separation apparatus 472, and the permeation-side pressure of the membrane separation apparatus 472 is adjusted to -0.1 MPaG at a permeation-side back pressure valve 473a. The non-permeation-side pressure of the membrane separation apparatus 472 is adjusted to -0.2 MPaG at a non-permeation-side back pressure valve 473b. The flow rate and the composition of the gas on the non-permeation side are measured by a flowmeter 475b and GC (gas chromatogram) and FT-IR in a gas analysis unit 85c are measured by a flowmeter 108a and a gas analysis unit 85g. The operating conditions and results analyzed by the gas analysis unit 85g are gathered in Table 19.

**[TABLE 19]**

| EXEMPLE NUMBER | SILANE GAS 20 TREATMENT UNIT | ANALYSIS RESULT BY THE GAS ANALYSIS UNIT 85g | | | | | | SiH₄ RECOVERED |
|---|---|---|---|---|---|---|---|---|
| | THE NUMBER OF CYCLES [TIMES] | COMPOSITION | | | | | | |
| | | H₂ | SiH₄ | Ar | Si₂H₆ | PH₃ | B₂H₆ | RECOVERY RATE |
| | | [Vol-ppm] | [vol.%] | [vol.ppm] | [vol.ppm | [vol.ppm] | [vol.ppm ] | [%] |
| EXEMPLARY EMBODIMENT 3-1 | 10 | 358 | 99.9 | 493 | < 0.5 | < 0.01 | < 2 | 73.4 |
| | 100 | 371 | 99.9 | 482 | < 0.5 | < 0.01 | < 2 | 73.3 |
| | 300 | 383 | 99.9 | 492 | < 0.5 | < 0.01 | < 2 | 73.3 |
| EXEMPLARY EMBODIMENT 3-2 | 10 | 289 | 99.9 | 448 | < 0.5 | < 0.01 | < 2 | 4 |
| | 100 | 276 | 99.9 | 449 | < 0.5 | < 0.01 | < 2 | 72.4 |
| | 300 | 277 | 99.9 | 433 | < 0.5 | < 0.01 | < 2 | 72.5 |
| EXEMPLARY EMBODIMENT 3-3 | 10 | 211 | 99.7 | 3092 | < 0.5 | < 0.01 | < 2 | 78.0 |
| | 30 | 209 | 99.7 | 3033 | < 0.5 | < 0,01 | < 2 | 77.9 |
| | 100 | 210 | 99.7 | 3049 | < 0.5 | < 0.01 | < 2 | 77.9 |
| EXEMPLARY EMBODIMENT | 10 | 198 | 99.8 | 1772 | < 0.5 | < 0.01 | < 2 | 70.8 |
| | 30 | 188 | 99.8 | 1745 | < 0.5 | < 0.01 | < 2 | 70.8 |
| | 100 | 190 | 99.8 | 1787 | < 0.5 | < 0.01 | < 2 | 70,8 |
| EXEMPLARY EMBODIMENT 3-5 | 10 | 411 | 99.5 | 5021 | < 0.5 | < 0.01 | < 2 | 82.0 |
| | 20 | 428 | 99.5 | 4984 | < 0.5 | < 0.01 | < 2 | 81,9 |
| | 60 | 418 | 99.5 | 4974 | < 0.5 | < 0.01 | < 2 | 82.0 |
| EXEMPLARY EMBODIMENT 3-6 | 10 | 545 | 99.3 | 6827 | < 0.5 | < 0.01 | < 2 | 79.0 |
| | 20 | 544 | 99.3 | 6814 | < 0.5 | < 0.01 | < 2 | 79.0 |
| | 60 | 553 | 99.3 | 6822 | < 0.5 | < 0.01 | < 2 | 79.1 |

(Comparative example 4-1 to 4-6) The exhaust gas treatment system id operative under the same condition as those of the exemplary embodiments 4-1 to 4-6 excepting that the mixed gas is fed to the analysis unit 85g by bypassing the noble gas/silane separation unit 470. The results concerning the flow rates and compositions of the mixed gas measured by the GC (gas chromatogram) and FT-IR in the gas analysis unit 85g are gathered in Table 20.

**[TABLE 20]**

| EXAMPLE NUMBER | SILANE GAS TREATEMENT UNIT 20 | ANALYSIS RESULT BY THE GAS ANALYSIS UNIT 85g ' | | | | | | SIH₄ RECOVERED |
|---|---|---|---|---|---|---|---|---|
| | THE NUMBER OF CYCLES [TIMES] | COMPOSITION | | | | | | |
| | | H₂ | SiH₄ | Ar | Si₂H₆ | PH₃ | B₂H₆ | RECOVERY RATE |
| | | [ vol.%] | [ vol.% ] | [ vol.% ] | [ vol.ppm ] | [ vol.ppm ] | [ vol.ppm ] | [ % ] |
| COMPARATIVE EXAMPLE 3-1 | 10 | 0.12 | 16.3 | 83.6 | < 0.5 | < 0.01 | < 2 | 97.5 |
| | 100 | 0.11 | 16.2 | 83.7 | < 0.5 | < 0.01 | < 2 | 97.4 |
| | 300 | 0.12 | 16.1 | 83.8 | < 0.5 | < 0.01 | < 2 | 97.4 |
| COMPARATIVE EXAMPLE 3-2 | 10 | 0.13 | 16.1 | 83.8 | < 0.5 | < 0.01 | < 2 | 96.5 |
| | 100 | 0.12 | 16.1 | 83.8 | < 0.5 | < 0.01 | < 2 | 96.4 |
| | 300 | 0.12 | 16.0 | 83.9 | < 0.5 | < 0.01 | < 2 | 96.4 |
| COMPARATIVE EXAMPLE 3-3 | 10 | 0.24 | 19.4 | 80.4 | < 0.5 | < 0.01 | < 2 | 97.2 |
| | 30 | 0.33 | | 80.0 | < 0.5 | < 0.01 | < 2 | 97.1 |
| | 100 | 0.28 | 19.6 | 80.1 | < 0.5 | < 0.01 | < 2 | 97.1 |
| COMPARATIVE EXAMPLE 3-4 | 10 | 0.24 | 18.2 | 81.6 | < 0.5 | < 0.01 | < 2 | 90.1 |
| | 30 | 0.28 | 18.2 | 81.5 | < 0.5 | < 0.01 | < 2 | 90.0 |
| | 100 | 0.19 | 18.1 | 81.7 | < 0.5 | < 0.01 | < 2 | 90.0 |
| COMPARATIVE EXAMPLE 3-5 | 10 | 0.38 | 0.87 | 98.7 | < 0.5 | < 0.01 | < 2 | 88.0 |
| | 20 | 0.41 | 0.88 | 98.7 | < 0.5 | < 0.01 | < 2 | 88.1 |
| | 60 | 0.42 | 0.93 | 98.6 | < 0.5 | < 0.01 | < 2 | 88.2 |
| COMPARATIVE EXAMPLE 3-6 | 10 | 0.38 | 0.88 | 98.7 | < 0.5 | < 0.01 | < 2 | 89.1 |
| | 20 | 0.33 | 0.82 | 98.8 | < 0.5 | < 0.01 | < 2 | 89.2 |
| | 60 | 0.42 | 0.89 | 98.7 | < 0.5 | < 0.01 | < 2 | 89.1 |

Using the mixed gas containing SiH4 recovered in the exemplary embodiments 4-1 to 4-6 and the comparative examples 4-1 to 4-6, a-Si solar cells are made according to a routine method so as to conduct a characteristic evaluation of them. The results show that although no change is found in the characteristics of the solar cells fabricated according to the exemplary embodiments 4-1 to 4-6, the characteristics thereof fabricated according to the comparative examples 4-1 to 4-6 are significantly degraded.

From the above results, it is evident that use of argon as the purge gas and installation of the noble gas/silane separation unit at a final stage of the monosilane recycling process prevent high-concentration argon from being mixed into monosilane recovered and therefore the adverse effect of the high-concentration argon on the performance of the solar cells can be reduced. Also, the mixed gas, containing a high proportion of hydrogen and argon separated by the silane separation unit, is made to pass through the water scrubber, so that the hydrogenated impurities can be removed. Also, the mixed gas that has passed through the water scrubber is further subjected to the separation treatment at the membrane separation apparatus, so that high-purity argon can be recovered with a higher recovery rate.

The present invention is not limited to the above-described embodiments only. It is understood that various modifications such as changes in design may be made based on the knowledge of those skilled in the art, and the embodiments added with such modifications are also within the scope of the present invention.

### [DESCRIPTION OF THE REFERENCE NUMERALS]

1 Semiconductor fabrication equipment
2 Pump unit
2a Filter
2b Pump
2C Switching valve
3 Compressor
3a Pre-cooler
3b After-cooler
3c Compressor
3d Inner-cooler
4 Gas container
5 Flow rate control unit
6a to 6f Gas analysis units
7 Boosting unit
8 Mixed gas processing unit
9a to 9b Accumulators
20 Silane gas treatment unit
21 Heating unit
22a to 22c Adsorption towers
23a to 23c Adsorption switching valves
24a to 24c Carrier gas introduction switching valves
25a to 25c Adsorption-desorption switching three-way valves
26 Gas analysis unit
27 Vacuum pump
28a, 28b Three-way valves
30 Noble gas treatment unit
31 Temperature control unit
32 Membrane separation apparatus
33a Permeation-side pressure control unit
33b Non-permeation-side pressure control unit
34a, 34b Gas analysis units
40 Hydrogen gas treatment unit
50 Silane gas purification unit
60 First purification unit
61 Heating unit
62a to 62c Adsorption towers
63a to 63c Adsorption switching valves
64a to 64c Carrier gas introduction switching valves
65a to 65c Adsorption-desorption switching three-way valves
66 Vacuum pump
70 Second purification unit
71 Heating unit
72a to 72c Adsorption towers
73a to 73c Adsorption switching valves
74a to 74c Adsorption-desorption switching three-way valves
76 Vacuum pump
80 Thin-film silicon solar cell CVD apparatus
81c Switching valve
82a, 82b Compressors
83a, 83b Pressurized tanks
84a, 84b Mass flow controllers
85a to 85d Gas analysis units (GC, FT-IR)
86 Combustion abatement apparatus
90 Temperature regulator
91 Membrane separation module
92a Permeation-side back pressure valve
92b Non-permeation-side back pressure valve
93 Vacuum pump
94a, 94b Flowmeters
100 Heating unit
101 a to 101 c Adsorption towers
102a to 102c Adsorption switching valves (inlets)
103a to 103c Adsorption switching valves (outlets)
104a to 104c Desorption switching valves
105a to 105c Carrier gas introduction switching valves
106 Vacuum pump
107 Back pressure valve
108a, 108b Flowmeters
110 Temperature control unit
111 Membrane separation module
112a Permeation-side back pressure valve
112b Non-permeation-side back pressure valve
113 Vacuum valve
114a, 114b Flowmeters
120 Heat exchanger
121 Cryogenic separation apparatus
122a Gas-side back pressure valve
122b Liquid-side back pressure valve
123a, 123b Flowmeters
130a, 130b Heating units
131 a to 131c A1 to A3 adsorption towers
131d to 131f B1 to B3 adsorption towers
132a to 132f Adsorption switching valves (inlets)
133a to 135f Adsorption switching valves (outlets)
134a to 134f Desorption switching valves
135a to 135f Carrier gas introduction switching valves
136 vacuum pump
137a, 137b Back pressure valves
138a, 138b Flowmeters
200 Exhaust gas treatment system
204 Wet scrubber
241 a to 241 c Water scrubbers
242a to 242c Switching valves (inlets)
242a' to 242c' Switching valves (outlets)
243 Gas analysis unit
300a, 300b Gas compression units
361 Pre-cooler
362 After-cooler
363a to 363f Diaphragm compressors
364a to 364e Coolers
365a to 364e Three-way valves
470 Noble gas/silane separation unit
471 Temperature control unit
472 Membrane separation apparatus
473a Permeation-side pressure control unit
473b Non-permeation-side pressure control unit
474a, 474b Gas analysis units
475a, 475b Flowmeters
476 Vacuum pump
1000 Water scrubber

### [INDUSTRIAL APPLICABILITY]

The present invention is applicable to a system that separates and recovers monosilane from a mixed gas, which contains monosilane, discharged from a semiconductor fabrication equipment so as to recycle it.

## Claims

1. An exhaust gas treatment system for recovering monosilane from a mixed gas containing at least hydrogen and monosilane discharged from a semiconductor fabrication equipment, the system comprising:
a pump unit configured to release the mixed gas discharged from the semiconductor fabrication equipment; and
a silane gas treatment unit configured to separate and recover monosilane from the mixed gas so as to be recycled in the semiconductor fabrication equipment,
wherein argon is used as a purge gas introduced into the pump unit.

2. An exhaust gas treatment system according to claim 1, further comprising a noble gas treatment unit configured to recover argon, introduced as the purge gas of the pump unit, from a hydrogen-rich gas removed from monosilane by the silane gas treatment unit.

3. An exhaust gas treatment system according to claim 2, wherein argon recovered by the noble gas treatment unit is reused as the purge gas of the pump unit.

4. An exhaust gas treatment system according to claim 2 or claim 3, wherein membrane separation is used as the noble gas treatment unit.

5. An exhaust gas treatment system according to any one of claim 1 to claim 4, wherein the silane gas treatment unit is an adsorption separation unit that contains zeolite or activated carbon as adsorbent.

6. An exhaust gas treatment system according to any one of claim 1 to claim 5, wherein only the mixed gas discharged from the semiconductor fabrication equipment that does not use dopant gas as the mixed gas discharged from the semiconductor fabrication equipment is introduced into the silane gas treatment unit.

7. An exhaust gas treatment system according to any one of claim 1 to claim 6, further comprising a wet scrubber configured to remove impurity of hydrogen/noble gas-rich gas where monosilane has been removed by silane gas treatment unit,
wherein the noble gas treatment unit recovers argon from the mixed gas that is obtained when the mixed gas is passed through the wet scrubber.

8. An exhaust gas treatment system according to claim 7, wherein argon recovered by the noble gas treatment unit is reused as the purge gas of the pump unit

9. An exhaust gas treatment system according to any one of claim 1 to claim 8, further comprising a silane gas purification unit configured to remove impurity, which excludes monosilane, from a monosilane-rich gas separated by the silane gas treatment unit and configured to purify the monosilane-rich gas and recover monosilane.

10. An exhaust gas treatment system according to any one of claim 1 to claim 9, further comprising:
a gas compression unit configured to raise the pressure of the mixed gas discharged from the pump unit and configured to feed the pressure-raised mixed gas to a subsequent stage; and
a gas container configured to accumulate and store the mixed gas compressed by the gas compression unit,
wherein the silane gas treatment unit separates and recovers monosilane from the mixed gas fed from the gas container so as to be recycled in the semiconductor fabrication equipment, and
wherein a compression ratio at the gas compression unit is controlled in a manner such that the temperature of the mixed gas after compression is in a rage of 70°C to 250°C.

11. An exhaust gas treatment system according to any one of claim 1 to claim 10, further comprising:
a gas compression unit configured to raise the pressure of the mixed gas discharged from the pump unit and configured to feed the pressure-raised mixed gas to a subsequent stage;
a gas container configured to accumulate and store the mixed gas compressed by the gas compression unit;
a silane gas purification unit configured to remove impurity excluding monosilane, in the mixed gas, separated by the silane gas treatment unit; and
a noble gas/silane separation unit configured to separate a noble gas component in the mixed gas that has passed through the silane gas purification unit,
wherein the silane gas treatment unit mainly separates and monosilane from the mixed gas fed from the gas container, and
wherein argon is used as a purge gas introduced into the pump unit.

12. An exhaust gas treatment system according to claim 11, wherein a pump unit is provided in the silane gas treatment unit.

13. An exhaust gas treatment system according to claim 11 or claim 12, wherein membrane separation is used as the noble gas/silane separation unit.
